(19) Europäisches Patentamt
European Patent Office
Office européen des brevets

(11) EP 3 001 571 A1

(12) EUROPEAN PATENT APPLICATION

(43) Date of publication:
**30.03.2016 Bulletin 2016/13**

(21) Application number: **14186535.2**

(22) Date of filing: **26.09.2014**

(51) Int Cl.:
*H03M 13/03* (2006.01) *H03M 13/11* (2006.01)
*H03M 13/27* (2006.01) *H03M 13/29* (2006.01)
*H03M 13/00* (2006.01) *H04L 1/00* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ALCATEL LUCENT**
**92100 Boulogne-Billancourt (FR)**

(72) Inventor: **Schmalen, Laurent**
**70435 Stuttgart (DE)**

(74) Representative: **Wetzel, Emmanuelle**
**Alcatel Lucent**
**Intellectual Property & Corporate Standards**
**Lorenzstrasse 10**
**70435 Stuttgart (DE)**

Remarks:
Amended claims in accordance with Rule 137(2) EPC.

(54) **LDPC coding and decoding for channels with phase slip**

(57) Low-complexity coding schemes are disclosed that are resilient against sporadic phase slip events and based on a new phase-slip transparent construction of LDPC codes based on a quasi-cyclic code construction, called block symmetric codes and an outer differential coding. Code constructions for multiple modulation formats are presented.

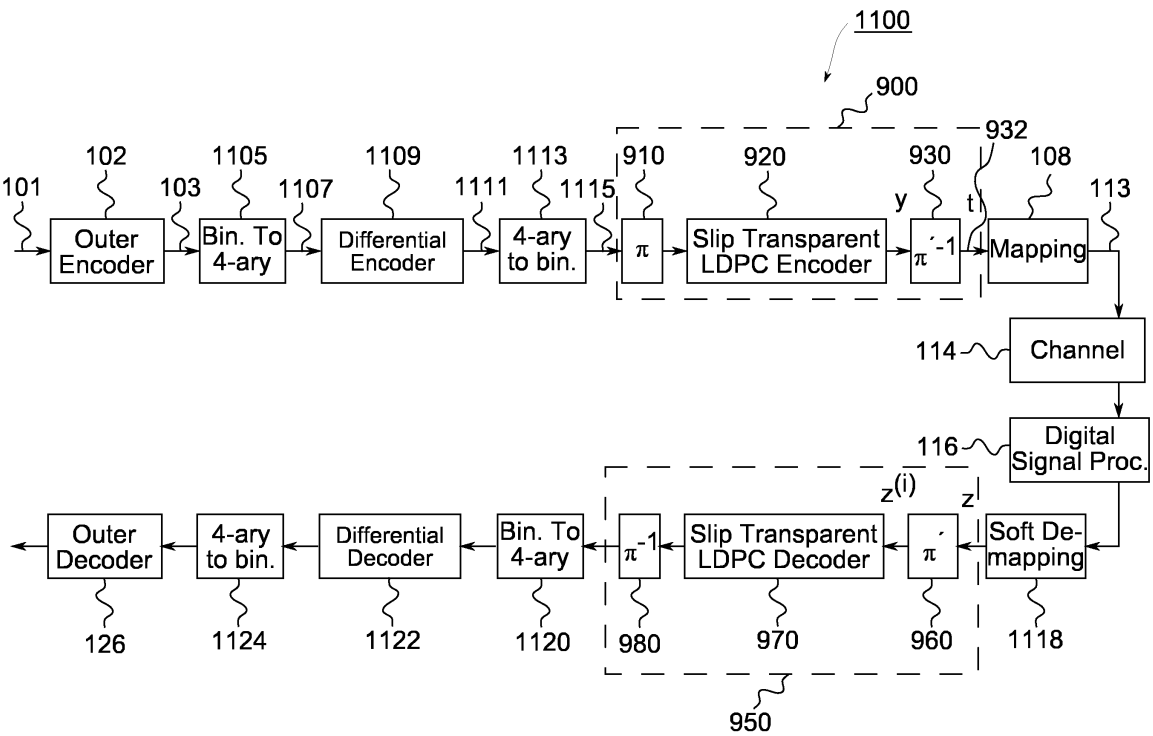


Fig. 11

EP 3 001 571 A1

## Description

Embodiments of the present disclosure generally relate to communication systems and, more particularly, to communication systems employing Low-Density Parity-Check (LDPC) Codes

## Background

This section introduces aspects that may be helpful in facilitating a better understanding of embodiments. Accordingly, the statements of this section are to be read in this light and are not to be understood as admissions about what is in the prior art or what is not in the prior art.

A Low-Density Parity-Check (LDPC) code is a linear error correcting code for transmitting a message over a noisy transmission channel, and may be constructed using a sparse bipartite graph whose vertices can be divided into two disjoint independent sets *U and V* such that every edge connects a vertex in *U* to one in *V.* An example of a bipartite graph used for LPDC codes is the so-called Tanner graph. In coding theory, Tanner graphs may also be used to construct longer codes from smaller ones. Both LPDC encoders and LPDC decoders may employ these graphs extensively.

An important application of LDPC codes is in optical or wireless communication systems. As the LDPC codes used in optical communications are mainly high-rate LDPC codes with rates higher than 0.8 (overhead smaller than 25%), these LDPC codes are usually based on parity check matrices of size $M$ (rows) $\times$ $N$ (columns), with $M \ll N$. It is well-recognized that LDPC codes perform remarkably well assuming that a carrier phase is perfectly synchronized and coherent detection is performed. It should be noted however that due to practical issues like complexity, acquisition time, sensitivity to tracking errors, and phase ambiguity, coherent detection may become expensive or infeasible in some cases. For example, in optical communications a signal received after carrier recovery may be affected by phase slips, with a probability depending on a (possibly non-linear) phase noise introduced by an optical transmission link, such as a fiber, for example. If the phase slip is not recovered correctly, error propagation may occur at the receiver and data following the phase slip may not be properly corrected by a decoder.

When transmitting a signal over a transmission channel, the signal's phase may be degraded by a phase offset that may be estimated at the receiver. The phase of a modulated signal may then be corrected by this estimated phase offset. The estimated phase offset may be erroneous to a degree, such that the correction of the received signal causes a rotation of the constellation diagram by a whole numbered multiple of the separation angle from the receiver's perspective. Such a rotation of the constellation diagram occurs from the time instant of one data symbol to a next time instant of a next successive data symbol and is called a phase slip. A typical value for a probability of a phase slip is, for example, $10^{-4}$.

In such scenarios a technique of differential encoding becomes relevant. Differential encoding admits simple non-coherent differential detection which solves phase ambiguity and requires only frequency synchronization (often more readily available than phase synchronization). Viewed from the coding perspective, performing differential encoding is essentially concatenating the original code with an accumulator, or, a recursive convolutional code.

When regarding iterative decoding of a Forward Error Correction (FEC) code, such as LDPC, and a differential code, the random phase slips on a transmission channel can be taken into account by an appropriately chosen clipping function (S-Function) which may be inserted in an iterative loop between the differential decoder and FEC decoder. The advantage of this solution is that a standard differential decoder with soft-output decoding can be utilized. Such a decoder may be commonly based on the trellis representation using the MAP/BCJR (MAP = Maximum A Posteriori; BCJR = Bahl, Cocke, Jelinek and Raviv) algorithm. A drawback of this solution is however that the Very-Large-Scale Integration (VLSI) implementation is complicated due to the presence of two different decoding domains. Thereby VLSI commonly denotes a process of creating integrated circuits by combining thousands of transistors into a single chip.

If the probability of occurrence of phase slips is rare, which can be ensured by optimized phase estimators and transmission lines, it is desirable to improve existing solutions to achieve the same coding gains with lower implementation complexity.

## Summary

Some simplifications may be made in the following summary, which is intended to highlight and introduce some aspects of the various example embodiments, but such simplifications are not intended to limit the scope embodiments. Detailed descriptions of preferred example embodiments adequate to allow those of ordinary skill in the art to make and use the inventive concepts will follow in later sections.

Embodiments propose low-complexity coding schemes that are resilient against sporadic phase slip events and based on a new phase-slip transparent construction of LDPC codes, called block symmetric codes. Embodiments propose code constructions for multiple modulation formats.

According to a first aspect of the present disclosure, it is provided an encoder device. The encoder includes an interleaver module having an input for a binary signal and an output for an interleaved signal. Thereby a pair of bits of the binary signal corresponds or may be mapped to a quaternary symbol. In some embodiments, the quaternary symbol may be symbol of a differentially encoded quaternary symbol stream. The interleaver module is configured to interleave an input block of k consecutive bits of the binary signal according to a first interleaver rule. The first interleaver rule re-arranges the $K$ consecutive bits of the input block to an interleaved signal block of $K$ consecutive interleaved bits. The interleaved signal block comprises at least a first sub-block of S consecutive bits corresponding odd bit positions in the input block and at least one adjacent second sub-block of S consecutive bits corresponding to even bit positions in the input block. The encoder further includes an LDPC encoder module having an input for the interleaved signal block and an output for an LDPC encoded signal block. The LDPC encoder module is configured to provide the LDPC encoded signal block based on a combination of the interleaved signal block with a parity check matrix of an LDPC code of rate $K/N$. The parity check matrix comprises $M$ rows of $N$ binary-valued sub-matrices of size $SxS$. Thereby, a first sub-matrix corresponding to an odd sub-matrix position in a row of sub-matrices equals an adjacent second sub-matrix corresponding to an even sub-matrix position in the row of sub-matrices. According to embodiments, the LDPC encoder module is configured to encode the interleaved input signal block systematically, i.e., the input signal block is included verbatim in the LDPC encoded output signal block. Hence, the LDPC code is a systematic LDPC code. The encoder also includes a de-interleaver module having an input for the LDPC encoded signal block and an output for a de-interleaved signal. The de-interleaver module is configured to de-interleave the LDPC encoded signal block of N consecutive bits in accordance with a second interleaver rule of a corresponding second interleaver. The second interleaver rule re-arranges N consecutive bits of an input signal block to an interleaved signal block of N consecutive interleaved bits. The interleaved signal block comprises at least a first sub-block of S consecutive bits corresponding to odd bit positions in the input signal block and at least a second sub-block of S consecutive bits corresponding to even bit positions in the input signal block.

In one or more embodiments, the encoder further includes a mapping module having an input for the de-interleaved signal and an output to a communications channel. The mapping module is configured to map a number of bits of the de-interleaved signal to a modulation symbol of an at least quaternary symbol alphabet or constellation diagram.

In one or more embodiments, the encoder further includes a first conversion module having an input for a binary signal and an output for a quaternary signal. The first conversion module is configured to convert a pair of bits of the binary signal to a quaternary symbol of the quaternary signal. In one embodiment, the encoder also includes a differential encoder module having an input for the quaternary signal and an output for a differentially encoded quaternary signal. The differential encoder module is configured to provide the differentially encoded quaternary signal based on the quaternary signal and a differential encoding rule. In one embodiment, the encoder further includes a second conversion module having an input for the differentially encoded quaternary signal and an output for a binary signal. The second conversion module is configured to convert a quaternary symbol of the differentially encoded quaternary signal to a pair of bits of the (quaternary-to-binary converted) binary signal. In one or more embodiments, the second conversion module's output is coupled to the interleaver module's input.

In some embodiments, the differential encoder module is configured to provide a sample $v_t$ of the differentially encoded quaternary signal at time index $t$ based on $v_t = (v_{t-1} + u_t)\%4$, wherein $u_t$ denotes a quaternary input signal at time index $t$ and wherein $(u\%v)$ returns the remainder of $u$ divided by $v$, i.e., $u = c \cdot v + (u\%v)$, with $c$ an integer number such that $0 \leq u - c \cdot v < v$.

In some embodiments, the first sub-matrix corresponding to the odd sub-matrix position in a row of sub-matrices and the equal adjacent second sub-matrix corresponding to an even sub-matrix position in the row of sub-matrices are both associated with the differentially encoded and quaternary-to-binary converted signal.

In some embodiments, the parity check matrix is based on an addition of an even number of parity check matrices corresponding to different quasi-cyclic LDPC codes, respectively. In one embodiment, a first parity check matrix of the even number of parity check matrices is constructed from a first $M' \times N'$ lifting matrix by replacing each entry of the first lifting matrix with either an all-zero matrix of size $SxS$ or a permutation matrix of size $S \times S$, depending on the entry of the first lifting matrix. A second parity check matrix of the even number of parity check matrices is constructed from a second $M' \times N'$ lifting matrix by replacing each entry of the second lifting matrix with either an all-zero matrix of size $SxS$ or a permutation matrix of size $S \times S$, depending on the entry of the second lifting matrix. An entry $A_{1,m,i}$ of the $m$-th row and the $i$-th column of the first lifting matrix corresponds to an entry $A_{2,m,i}$ of the $m$-th row and the $i$-th column of the second lifting matrix, if the entry $A_{1,m,i}$ is $x$, wherein $x$ denotes a predetermined value of the first lifting matrix leading to zero entries in the corresponding first and second parity check matrices. According to embodiments, $A_{1,m,i} \neq A_{2,m,i}$, if $A_{1,m,i} \neq x$, and $A_{2,m,i} \neq x$. Further, $A_{1,m,2i-1} = A_{1,m.2i}$ and $A_{2,m,2i-1} = A_{2,m.2i}$.

In some embodiments, the interleaver module is configured to re-arrange an $i$-th bit $x_i$ of the input block to obtain a bit $y_j$ of the interleaved signal block according to

$$y_{\lfloor \frac{i-1}{2S} \rfloor 2S + \frac{(i-1)\%(2S)}{2} + 1} = x_i \quad \text{if } i \text{ odd}$$

$$y_{\lfloor \frac{i-1}{2S} \rfloor 2S + \frac{(i-2)\%(2S)}{2} + S + 1} = x_i \quad \text{if } i \text{ even},$$

wherein $\lfloor u \rfloor$ denotes the largest integer smaller or equal than $u$ and ($u\%v$) returns the remainder of $u$ divided by $v$.

Similarly, the de-interleaver module may be configured to re-arrange an $i$-th bit $y_i$ of the input block to obtain a bit $x_i$ of the de-interleaved signal block according to

$$x_i = y_{\lfloor \frac{i-1}{2S} \rfloor 2S + \frac{(i-1)\%(2S)}{2} + 1} \quad \text{if } i \text{ odd}$$

$$x_i = y_{\lfloor \frac{i-1}{2S} \rfloor 2S + \frac{(i-2)\%(2S)}{2} + S + 1} \quad \text{if } i \text{ even}.$$

According to a second aspect of the present disclosure, it is provided a corresponding decoder device. The decoder includes an interleaver module having an input for a received signal and an output for an interleaved signal. A pair of samples of the received signal corresponds to a potential or hypothetical quaternary symbol. In some embodiments, the potential quaternary symbol may be symbol of a differentially encoded quaternary symbol stream. The interleaver module is configured to interleave an input block of N consecutive samples of the received signal according to a first interleaver rule. The first interleaver rule re-arranges the $N$ consecutive samples of the input block to an interleaved signal block of $N$ consecutive interleaved samples. The interleaved signal block comprises at least a first sub-block of S consecutive samples corresponding to odd sample positions in the input block and at least an adjacent second sub-block of S consecutive samples corresponding even sample positions in the input block. The decoder also includes an LDPC decoder module having an input for the interleaved signal block and an output for an LDPC decoded signal block. The LDPC decoder module is configured to provide the LDPC decoded signal block based on a combination of the interleaved signal block with a parity check matrix of a systematic LDPC code of rate $K/N$. The parity check matrix comprises $M'$ *rows* of $N'$ binary-valued sub-matrices of size $SxS$. A first sub-matrix corresponding to an odd sub-matrix position in a row of sub-matrices equals an adjacent second sub-matrix corresponding to an even sub-matrix position in the row of sub-matrices. The decoder further includes a de-interleaver module having an input for the LDPC decoded signal block and an output for a de-interleaved signal. The de-interleaver module is configured to de-interleave the LDPC decoded signal block *of* $K$ consecutive samples in accordance with a second interleaver rule of a corresponding second interleaver. The second interleaver rule re-arranges an input signal block *of* $K$ consecutive input samples to an interleaved signal block of $K$ consecutive interleaved samples. The interleaved signal block comprises at least a first sub-block of $S$ consecutive samples corresponding odd bit positions in the input signal block and at least a second sub-block of S consecutive samples corresponding even bit positions in the input signal block.

In some embodiments, the decoder further includes a de-mapping or demodulator module having an input for a received modulated signal and an output for a demodulated signal. The de-mapping module is configured to map a received modulated signal sample to a number of demodulated signal samples based on a mapping rule between a number of bits and a modulation symbol of an at least quaternary symbol alphabet. The de-mapping module's output may be coupled to the interleaver module's input.

In one embodiment, the decoder further includes a differential decoder module having an input for a quaternary signal and an output for a differentially decoded quaternary signal. The differential decoder module is configured to provide the differentially decoded quaternary signal based on the quaternary signal and a differential decoding rule. The differential decoder module's input is coupled to the de-interleaver module's output. The decoder may also include a conversion module having an input for the differentially decoded quaternary signal and an output for a binary signal. The conversion module is configured to convert a quaternary symbol of the differentially decoded quaternary signal to a pair of bits of the binary signal.

In some embodiments, the LDPC decoder module is configured to provide the LDPC decoded signal with soft-decisions. Then, the differential decoding rule of the differential decoder module may be a soft decision decoding rule.

In some embodiments, the differential decoder module comprises an output coupled to the LDPC decoder module to transfer extrinsic information back to the LDPC decoder module for a subsequent decoding iteration.

In one or more embodiments, the LDPC decoder module is configured to provide the LDPC decoded signal with binary hard-decisions. In such embodiments the decoder may additionally comprise a further conversion module having an input for a binary input signal and an output for a quaternary signal. The further conversion module is configured to convert a pair of bits of the binary input signal to a quaternary symbol of the quaternary signal. The further conversion module's input may be coupled to the de-interleaver module's output.

In one embodiment, the differential decoder module is configured to provide a differentially decoded quaternary signal $d_t$, at time index *t* based on $d_t = (y_t - y_{t-1})\%4$, wherein (*u*%*v*) returns the remainder of *u* divided by v.

According to a further aspect of the present disclosure, it is provided an encoding method. The encoding method includes interleaving an input block of k consecutive bits of a binary signal according to a first interleaver rule. Thereby, a pair of bits of the binary signal corresponds to a quaternary symbol. The first interleaver rule re-arranges the *K* consecutive bits of the input block to an interleaved signal block of *K* consecutive interleaved bits. The interleaved signal block comprises at least a first sub-block of S consecutive bits corresponding odd bit positions in the input block and at least an adjacent second sub-block of S consecutive bits corresponding even bit positions in the input block. The encoding method further includes providing an LDPC encoded signal block based on a combination of the interleaved signal block with a parity check matrix of a systematic LDPC code of rate *K*/*N*. The parity-check matrix comprises *M'* rows of *N'* binary-valued sub-matrices of size *SxS*. A first sub-matrix corresponding to an odd sub-matrix position in a row of sub-matrices equals an adjacent second sub-matrix corresponding to an even sub-matrix position in the row of sub-matrices. The encoding method also includes de-interleaving the LDPC encoded signal block of *N* consecutive bits in accordance with a second interleaver rule of a corresponding second interleaver. The second interleaver rule re-arranges *N* consecutive bits of an input signal block to an interleaved signal block of *N* consecutive interleaved bits. The interleaved signal block comprises at least a first sub-block of *S* consecutive bits corresponding odd bit positions in the input signal block and at least a second sub-block *of S* consecutive bits corresponding even bit positions in the input signal block.

According to yet further aspect of the present disclosure, it is provided a decoding method. The decoding method includes interleaving an input block of *N* consecutive samples of a received signal according to a first interleaver rule. The first interleaver rule re-arranges the *N* consecutive samples of the input block to an interleaved signal block of *N* consecutive interleaved samples. The interleaved signal block comprises at least a first sub-block of *S* consecutive samples corresponding odd sample positions in the input block and at least an adjacent second sub-block *of S* consecutive samples corresponding even sample positions in the input block. The decoding method also includes providing a block of a LDPC decoded signal based on a combination of the interleaved signal block with a parity check matrix defining a systematic LDPC code of rate *K*/*N*. The parity check matrix comprises *M' rows* of *N'* binary-valued sub-matrices of size *SxS.* At least a first sub-matrix corresponding to an odd sub-matrix position in a row of sub-matrices equals an adjacent second sub-matrix corresponding to an even sub-matrix position in the row of sub-matrices. The decoding method further includes de-interleaving the LDPC decoded signal block of *K* consecutive samples in accordance with a second interleaver rule of a corresponding second interleaver. The second interleaver rule re-arranging an input signal block *of K* consecutive input samples to an interleaved signal block *of K* consecutive interleaved samples comprising at least a first sub-block of *S* consecutive samples corresponding odd bit positions in the input signal block and at least a second sub-block of *S* consecutive samples corresponding even bit positions in the input signal block.

Some embodiments comprise digital circuitry installed within the encoder and/or decoders for performing the respective aforementioned methods. Such a digital control circuitry, e.g., a Digital Signal Processor (DSP), a Field-Programmable Gate Array (FPGA), an Application-Specific Integrated Circuit (ASIC), or a general purpose processor, needs to be programmed accordingly. Hence, yet further embodiments also provide a computer program having a program code for performing embodiments of the method, when the computer program is executed on a computer or a programmable hardware device.

Embodiments may improves the Signal-to-Noise Ratio (SNR) performance of optical transport systems while keeping the VLSI complexity low. Embodiments may facilitate VLSI implementation and may largely reduce implementation complexity by avoiding the use of non-binary codes. Potential performance improvements of 0.5 to 1 dB are possible.

## Brief description of the Figures

Some embodiments of apparatuses and/or methods will be described in the following by way of example only, and with reference to the accompanying figures, in which

| | |
|---|---|
| Fig. 1 | schematically illustrates a signal processing chain of an optical communication system; |
| Fig. 2a | illustrates an equivalent channel model with phase slips; |
| Fig. 2b | shows an example rectangular 8-QAM constellation with rotationally invariant mapping on each half-plane |

| | |
|---|---|
| | and two differentially encoded states S1 and S2; |
| Fig. 3 | illustrates a block diagram of a conventional row-layered decoder with check node decoding operation; |
| Fig. 4 | shows a detailed view of a row-layered decoder processing check node 5 of a code with $\mathcal{N}$ (5) = {1; 5; 9; 13; 21}; |
| Fig. 5 | illustrates a pipelined implementation of the iterative differential decoding using trellis-based differential decoding; |
| Fig. 6 | illustrates row-layered decoding and scattered memory access to the variable node aposteriori memory; |
| Fig. 7 | illustrates hardware architecture (row decoding) for decoding quasi-cyclic LDPC codes; |
| Fig. 8 | illustrates an embodiment with a quasi-symmetric LDPC code and interchanged roles of differential encoder and FEC decoder; |
| Figs. 9a, b | shows schematic block diagrams of encoder and decoder devices according to embodiments; |
| Fig. 10a | shows an example quaternary constellation diagram; |
| Fig. 10b | illustrates a bit sequence affected by a phase slip; |
| Fig. 11 | shows a schematic block diagram of a communication system comprising encoder and decoder devices according to embodiments; |
| Fig. 12 | illustrates an example implementation of an interleaver according to an embodiment; |
| Fig. 13 | illustrates a parity check matrix of an example LDPC code, constructed with S = 30; |
| Fig. 14a | shows a difference between an original transmitted codeword and a decoder output for a large SNR; |
| Fig. 14b | shows a result after proper de-interleaving followed by differential decoding of the decoder output of Fig. 14a; |
| Fig. 15a | shows a difference between an original transmitted codeword and a decoder output for a small SNR; |
| Fig. 15b | shows a result after proper de-interleaving followed by differential decoding of the decoder output of Fig. 15a; |
| Fig. 16 | illustrates a 16-QAM Modulation format suitable for differential coding with rotationally invariant mapping on two LSBs; |
| Fig. 17 | shows a schematic block diagram of a communication system for 8-QAM modulation and comprising encoder and decoder devices according to embodiments; |
| Fig. 18 | shows an embodiment of a proposed receiver for constellations with 90° phase ambiguity based on slip-transparent binary LDPC code and with iterative decoding and demapping; |
| Fig. 19 | shows an embodiment of a proposed receiver for constellations with 90° phase ambiguity based on slip-transparent binary LDPC code and with iterative decoding and differential decoding; and |
| Fig. 20 | shows an embodiment of a proposed receiver for constellations with 90° phase ambiguity based on slip-transparent binary LDPC code and with iterative decoding and differential decoding and iterative demodulation. |

## Description of Embodiments

Various example embodiments will now be described more fully with reference to the accompanying drawings in which some example embodiments are illustrated. Accordingly, while example embodiments are capable of various modifications and al-ternative forms, embodiments thereof are shown by way of example in the drawings and will herein be described in detail. It should be understood, however, that there is no intent to limit example embodiments to the particular forms disclosed, but on the contrary, example embodiments are to cover all modifications, equivalents, and alternatives falling within the scope of the claims. Like numbers refer to like elements throughout the description of the figures. It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of example embodiments. As used herein, the term "and/or" includes any and all combinations of one or more of the associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g.., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/ or "including," when used herein, specify the presence of stated features, integers, steps, operations, elements and/or components, but do not preclude the presence or addition of one or more other features, integers, steps, operations, elements, components and/ or group thereof.

It should also be noted that in some alternative implementations, the functions/ acts noted may occur out of the order noted in the figures. For example, figures shown in succession may in fact be executed substantially concurrently or may sometimes be executed in the reverse order, depending upon the functionality/acts involved.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

Portions of example embodiments and corresponding detailed description are presented in terms of software, or algorithms and symbolic representations of operation of data bits within a computer memory. These descriptions and representations are the ones by which those of ordinary skill in the art effectively convey the substance of their work to others of ordinary skill in the art. An algorithm, as the term is used here, and as it is used generally, is conceived to be a self-consistent sequence of steps leading to a desired result. The steps are those requiring physical manipulations of physical quantities. Usually, though not necessarily, these quantities take the form of optical, electrical, or magnetic signals capable of being stored, transferred, combined, compared, and otherwise manipulated. It has proven convenient at times, principally for reasons of common usage, to refer to these signals as bits, values, elements, symbols, characters, terms, numbers, or the like.

In the following description, illustrative embodiments will be described with reference to acts and symbolic representations of operations (e.g., in the form of flowcharts) that may be implemented as program modules or functional processes including routines, programs, objects, components, data structures, etc., that perform particular tasks or implement particular abstract data types and may be implemented using existing hardware at existing network elements or control nodes. Such existing hardware may include one or more Central Processing Units (CPUs), Digital Signal Processors (DSPs), Application-Specific Integrated Circuits, Field Programmable Gate Arrays (FPGAs), computers, or the like.

Unless specifically stated otherwise, or as is apparent from the discussion, terms such as "processing" or "computing" or "calculating" or "determining" or "displaying" or the like, refer to the action and processes of a computer system, or similar electronic computing device, that manipulates and transforms data represented as physical, electronic quantities within the computer system's registers and memories into other data similarly represented as physical quantities within the computer system memories or registers or other such information storage, transmission or display devices.

As disclosed herein, the term "storage medium", "storage unit" or "computer readable storage medium" may represent one or more devices for storing data, including Read Only Memory (ROM), Random Access Memory (RAM), magnetic RAM, core memory, magnetic disk storage mediums, optical storage mediums, flash memory devices and/ or other tangible machine readable mediums for storing information. The term "computer-readable medium" may include, but is not limited to, portable or fixed storage devices, optical storage devices, and various other mediums capable of storing, containing or carrying instruction(s) and/or data.

Furthermore, example embodiments may be implemented by hardware, software, firmware, middleware, microcode, hardware description languages, or any combination thereof. When implemented in software, firmware, middleware or microcode, the program code or code segments to perform the necessary tasks may be stored in a machine or computer readable medium such as a computer readable storage medium. When implemented in software, a processor or processors will perform the necessary tasks.

A code segment may represent a procedure, function, subprogram, program, routine, subroutine, module, software package, class, or any combination of instructions, data structures or program statements. A code segment may be coupled to another code segment or a hardware circuit by passing and /or receiving information, data, arguments, parameters or memory contents. Information, arguments, parameters, data, etc. may be passed, forwarded, or transmitted via any suitable means including memory sharing, message passing, token passing, network transmission, etc.

**Fig. 1** illustrates a communication system overview, which will be used subsequently to further detail and explain some embodiments.

Fig. 1 shows a signal processing chain of a communication system 100, e.g., an optical communication system, which can also be provided by embodiments. The signal processing exemplarily starts at the upper left corner of Fig. 1 with an outer encoder 102, which may, for example, correspond to a convolutional encoder, a Reed Solomon encoder, or a Turbo product encoder 102. The task of the outer encoder 102 is to add redundancy to an input information word 101, which may comprise digitized data. A signal output 103 of the outer encoder 102 may then be input into an interleaver 104, which interleaves the data. The interleaving can be adapted to an error characteristic, which is introduced in a transmission channel 114 later on such that burst errors can be resolved by subsequent de-interleaving 124 to enable enhanced error correction at an outer decoder 126. In the exemplary communication system 100 resulting interleaved data 105 may then be input into an LDPC encoder 106 to obtain (encoded) LPDC code words 107 before being assigned to transmission symbols 109 by a mapping entity 108. The transmission symbols 109 may then be differentially encoded by a differential encoder 110 to prevent or limit the effect of phase slips, which may occur due to undetectable phase noise events in the subsequent transmission channel 114. Strictly speaking, the phase slips do not occur in the transmission channel as such but are due to phase noise events that cause a phase offset correction algorithm to make a wrong decision. The phase noise correction algorithm is part of the digital signal processing chain that is not explicitly shown in Fig. 1 and that can be considered as being either part of the transmission channel 114 or as being part of the demodulation 116. Differentially encoded data symbols 111 may be derived, using a linear feedback shift register which comprises a delay element. The transfer function of the linear feedback shift register performing the differential encoding rule is given in the z-domain as $H(z) = 1/(1 - z^{-1})$. In the BPSK case, the differential encoder 110 can be represented as an accumulator computing $y_i = y_{i-1} \oplus x_i$, where "$\oplus$" denotes the modulo-2 addition or the exclusive OR (XOR) operation, respectively. The differentially encoded transmission symbols 111 are then modulated by modulator 112 and transmitted through the transmission channel 114. Note that the blocks 102 to 112 make up a transmitter of the communication system 100. This can be an optical transmitter.

The modulation 112 may comprise a conversion from base band, which can be complex, to a transmission band as well as a conversion from a digital/electrical to an optical signal. In the present example an optical conversion and thus an optical transmission channel 114 is assumed. In a transmission channel, e.g., an optical, a wireless, a wireline or a powerline transmission channel, phase slips can occur due to the inability of a receiver to handle large phase noise, i.e., the phase may jump or suddenly change by a certain angle. This angle may correspond to 180° or $\pi$ in a BPSK case; it may correspond predominantly to 90° or $\pi/2$ in the QPSK case, for example. Such a phase slip may result in erroneous symbols being detected subsequently. The differential coding 110 limits the effect of a phase slip to the symbol, which is detected subsequent to the phase slip, as the difference to the previous symbol only is affected by the phase slip. However, since the difference to the next symbol is not affected by the phase slip (assuming only a single phase slip to occur), the differential encoding limits the effect of a phase slip. As the phenomenon of phase slips is well known in the art further details will be omitted not to obscure the principles of embodiments.

**Fig. 2a** displays an example of a phase-slip channel model.

The channel input 113 is a complex modulation symbol $y[t] \in \mathcal{M} \subset \mathcal{C}$. A first noise contribution 115 is complex-valued Additive White Gaussian Noise (AWGN). In the field of coding and in the broad body of literature on Forward Error Correction (FEC), the term $E_S/N_0$ is frequently used to characterize AWGN channels. Therein, $E_S$ denotes the energy per modulation symbol. The complex noise $n[t] = n_I[t] + n_Q[t]$ is characterized by the two-sided noise power spectral density $N_0 = 2\sigma_n^2$ where $\sigma_n^2$ is the variance of the real-valued noise component $\sigma_n^2 = \mathrm{var}(n_I[t]) = \mathrm{var}(n_Q[t])$. $N_0$ refers to the complex Gaussian noise (in the complex I-Q plane of the modulation) but in the case of BPSK, we may only consider the real part. A received symbol $z[t]$ 117 in our model is obtained by $z[t] = (y[t] + n[t])\cdot p[t]$. Note that in optical communications, the Optical Signal-to-Noise Ratio (OSNR) is also frequently employed. The OSNR is the signal-to-noise ratio measured in a reference optical bandwidth, where frequently a bandwidth $B_{\mathrm{ref}}$ of 12.5 GHz is used corresponding to 0.1 nm wavelength. The OSNR relates to $E_S/N_0$ as

$$\mathrm{OSNR}\Big|_{\mathrm{dB}} = \frac{E_s}{N_0}\Big|_{\mathrm{dB}} + 10\log_{10}\frac{R_S}{B_{\mathrm{ref}}},$$

where $B_{\mathrm{ref}}$ is the previously introduced reference bandwidth and $R_S$ corresponds to the symbol rate of the transmission. Continuing with the description of the channel model in Fig. 2, we see that the noisy signal $\tilde{y}[t]$ additionally undergoes a potential phase rotation of a multiple of $2\pi/V$ yielding the channel output $z[t]$ 117, where $V$ *is* a rotational invariance of the constellation. We say that a constellation $M = \{M_0, M_1, \ldots, M_{Q-1}\}$ exhibits a $V$-fold rotational invariance, i.e., if we recover the original constellation $M$ after rotating each modulation symbol $M_i$ by an amount $(2\pi/k)\cdot k$, $\forall k \in \{1, \ldots, V\}$ in the complex plane. Formally, we say that a constellation exhibits a $V$-fold rotation invariance if

$$\{M_i \in \mathcal{M} : M_i \cdot e^{j\frac{2\pi}{V}k}\} = \mathcal{M} \qquad \mathit{for}\ k \in \{1, \ldots, V\}.$$

For example, QPSK and 16-QAM constellations exhibit a $V = 4$ fold rotational invariance, while the BPSK constellation exhibits a $V = 2$ fold rotational invariance.

The occurrence of a phase slip is determined by a random variable $s[t]$. We introduce the following probabilistic phase slip model assuming that $V$ is even (which is the case for most of the practically relevant constellations):

$$P(s[t] = \pm 1) = \xi$$
$$P(s[t] = \pm 2) = \xi^2$$
$$\vdots \qquad \vdots$$
$$P\left(s[t] = \pm \frac{V}{2}\right) = \xi^{V/2}$$

The probability that a phase slip occurs may thus be expressed as

$$P_{\text{slip}} = 2\sum_{i=1}^{V/2} \xi^i = \frac{2\xi\left(1 - \xi^{V/2}\right)}{1 - \xi}.$$

For a given phase slip probability, which can usually be obtained from measurements and which depends on the non-linear phase noise introduced by the optical transmission link 114, we obtain the value $\xi$ by solving the above equation for $\xi$. For practically important cases with $V = 2$, and $V = 4$, we get

$$\xi = \begin{cases} \frac{P_{\text{slip}}}{2} & \text{if } V = 2 \\ \frac{\sqrt{2P_{\text{slip}}+1}}{2} - \frac{1}{2} & \text{if } V = 4. \end{cases}$$

Experimental measurements suggest that the phase slip probability $P_{\text{slip}}$ depends on the equivalent bit error rate before the FEC. We may thus model $P_{\text{slip}}$ as

$$P_{\text{slip}} = \begin{cases} \min\left(1, \frac{\gamma}{2}\,\text{erfc}\left(\sqrt{\frac{E_s}{2N_0}}\right)\right), & \text{for QPSK} \\ \min\left(1, \frac{\gamma}{2}\,\text{erfc}\left(\sqrt{\frac{E_s}{6N_0}}\right)\right), & \text{for rect. 8-QAM} \end{cases}$$

where y is the factor between slip rate and pre-FEC bit error rate for the equivalent BPSK channel and by assuming for the 8-QAM case (with the constellation of **Fig.** 2b) that the signal-to-noise ratio is large enough such that the bit error rate is dominated by errors to neighboring symbols only.

At the receiver, the received differentially encoded data symbols, i.e., the differentially encoded the LPDC code words, may be demodulated 116, where the demodulation 116 may include optical/electrical conversion and conversion from the transmission band to the complex base band. Fig. 1 illustrates a processing path between the demodulation 116 and a subsequent de-interleaver 124 involving a differential decoder 118, an optional clipping function 120 and an LDPC decoder 122. Following the processing path, the base band symbols may be differentially decoded 118, which may result in soft information 119, i.e., information on estimated symbols or bits and reliability information thereon, which can, for example, be expressed in terms of likelihood values or log-likelihood values. This soft information 119 from the differential decoder 118 may also be denoted as extrinsic probability information. In the example shown in Fig. 1, a clipping function 120 may be applied to the output of the differential encoder. The clipping function 120 limits the likelihood values (extrinsic probability information) to enable a better decoding performance of the subsequent LDPC decoder 122. The performance of the LDPC decoder 122 can be improved by the limitation as an upper limit of the likelihood values can be assumed based on a known occurrence or probability of occurrence of a phase slip. For example, the probability of a phase slip for a given optical channel may be in a range around $10^{-3}$. Hence, all likelihood values can be limited to $\log((1-10^{-3})/10^{-3}) \approx 6.91$, as this is the highest certainty that can be achieved. In other words, a residual error rate of $10^{-3}$ is known and considered by using an according the clipping function 120. This is only a simplified view. The clipping function 120 can be a pure clipping function that saturates all values above a certain threshold to that value or it can be a smooth function given by an equation $f(x) = \log(((1-P_s)\cdot\exp(x) + P_s)/(P_s\cdot exp(x) + (1-P_s)))$, wherein $P_s$ denotes the probability of a phase slip.

The clipped output 121 of the clipping function 120 may then be input into the LDPC decoder 122, which will be explained in more detail below. The LDPC decoder 122 may then determine updated likelihood values 121', which may be fed back to the clipping function 120 and from there to the differential decoder 118 as priori probability information 119' for a next iteration of differential decoder 118, which is indicated by the arrows between the differential decoder 118, the clipping function 120, and the LDPC decoder 122. The circular shaped arrows indicate that a number of iterations may be carried out, wherein the likelihood values are updated by one of the decoders 118, 122 and clipped in between by the clipping function 120. The decoding iteration may be terminated by a parity check criterion. The output from the LDPC decoder 122 may then be de-interleaved by de-interleaver 124 before being provided to the outer decoder 126 for outer decoding in line with the above described outer encoding 102.

For a better understanding of embodiments of the present invention a short introduction to LDPC codes and some related decoding algorithms will be provided in the following.

An LDPC code may be defined by a sparse binary parity check matrix **H** of dimension $M \times N$, where $N$ is the LDPC code word length (in bits) of the LDPC code and $M$ denotes the number of parity bits. The rows of a parity check matrix are parity checks on the code words of a code. That is, they show how linear combinations of certain digits of each code word equal zero. Usually, the number of information bits *equals* $K = N-M$. The design rate of the code amounts to $r = (N-M)/N$. The overhead of the code is defined as $\mathrm{OH} = 1/r - 1 = M/(N-M)$. Sparse means that the number of 1s in **H** is small compared to the number of zero entries. Practical LDPC codes usually have a fraction of "Is" that is below 1% by several orders of magnitude.

We start by introducing some notation and terminology related to LDPC codes. Each column of the parity check matrix **H** corresponds to one bit of a Forward Error Correction (FEC) frame or LPDC code word. As LDPC codes can also be represented in a graphical structure called Tanner graph (which we will not introduce here), the columns of **H** and thus the FEC frame (LPDC code word) bits are sometimes also called variable nodes, referring to the graph-theoretic representation. Similarly, each row of **H** corresponds to a parity check equation and ideally defines a parity bit, if **H** has full rank. For example, the rank can be defined as the column rank. The column rank of a matrix **H** is the maximum number of linearly independent column vectors of **H.** Correspondingly, row rank **of H** is the maximum number of linearly independent row vectors **of H.** Owing to the Tanner graph representation, the rows of **H** are associated to so-called check nodes. Note that the row rank and the column rank of a matrix **H** are always equal, which is a well-known result in linear algebra.

In order to describe an exemplary LDPC decoder 122 we introduce some additional notation. First, we denote by **x** the vector of $K = N - M$ information bits. The single elements of **x** are denoted by $x_i$, i.e., $\mathbf{x} = (x_1, x_2, ..., x_i, ..., x_K)^T$. After encoding with an exemplary LDPC encoder 106, the LDPC code word 107 $\mathbf{y} = (y_1, y_2, ..., y_N)^T$ of length $N$ results. We denote by $y_i$ the single bits of the code word **y**. The LDPC code is said to be systematic if the information vector **x** is included in the code word, e.g., if $y = (x_1,..., x_K, p_1, ... p_M)^T$, with $\mathbf{p} = (p_1, ..., p_M)^T$ denoting the vector of $M$ parity bits. Furthermore, let the set $\mathcal{N}(m)$ denote the positions of the 1s in the $m$-th row of **H**, i.e., $\mathcal{N}(m) = \{i: H_{m,i} = 1\}$. A binary vector y is a code word of the LDPC code defined by **H**, if $\mathbf{Hy} = \mathbf{0}$, with the additions defined over the binary field (addition modulo-2, or XOR, respectively). The set of code words is thus defined to be the null space of **H.** This signifies that the product of each row of **H** and **y** must be zero, or $\sum_{j \in \mathcal{N}(m)} y_j = 0,$ for all $m$ with $1 \leq m \leq M$.

Let us illustrate the concept of LDPC codes by a "toy" example. This example defines a parity check matrix **H** of two concatenated (4, 5) single parity check codes, separated by a 4x5 block-interleaver. The exemplary parity check matrix **H** of dimension 9x25 is given by

$$\mathbf{H} = \begin{pmatrix}
1&1&1&1&&&&&&&&&&&&&1&&&&&&&& \\
&&&&1&1&1&1&&&&&&&&&&1&&&&&&& \\
&&&&&&&&1&1&1&1&&&&&&&1&&&&&& \\
&&&&&&&&&&&&1&1&1&1&&&&1&&&&& \\
1&&&&1&&&&1&&&&1&&&&&&&&1&&&& \\
&1&&&&1&&&&1&&&&1&&&&&&&&1&&& \\
&&1&&&&1&&&&1&&&&1&&&&&&&&1&& \\
&&&1&&&&1&&&&1&&&&1&&&&&&&&1& \\
&&&&&&&&&&&&&&&&1&1&1&1&&&&&1
\end{pmatrix}.$$

Note that for simplicity reasons only the 1s are illustrated in the parity check matrix **H** above. Thus, M= 9, $N$ =

25, and the code has an overhead of 56% (given by $M/(N - M)$) or a rate of $r$ = 0.64, equivalently. We have $\mathcal{N}(1) = \{1; 2; 3; 4; 17\}$, $\mathcal{N}(2) = \{5; 6; 7; 8; 18\}$, $\mathcal{N}(3) = \{9; 10; 11; 12; 19\}$, $\mathcal{N}(4) = \{13; 14; 15; 16; 20\}$, $\mathcal{N}(5) = \{1; 5; 9; 13; 21\}$, $\mathcal{N}(6) = \{2; 6; 10; 14; 22\}$, $\mathcal{N}(7) = \{3; 7; 11; 15; 23\}$, $\mathcal{N}(8) = \{4; 8; 12; 16; 24\}$, $\mathcal{N}(9) = \{17; 18; 19; 20; 25\}$. This means for instance that we have (using the first row of **H)** $y_1+y_2+y_3+y_4+y_{17}=0$, or, if the code is systematic, $x_1+x_2+x_3+x_4+p_1=0$, i.e., $p_1=x_1+x_2+x_3+x_4$, defines the first parity bit.

One of the most common decoding algorithms for LDPC codes is the so-called "sum-product" decoding algorithm and its simplified versions. These algorithms can be described either in a graph structure commonly denoted Tanner graph, or given directly in a form suitable for implementation. While the former is advantageous for describing and understanding the underlying operations, we only focus on the latter in this specification.

In the context of coherent detection, we can usually assume an equivalent Additive White Gaussian Noise (AWGN) channel model for the transmission channel 114. This assumption is justified by the central limit theorem which applies due to the extensive use of filtering in inner Digital Signal Processing (DSP) stages of the transmitter and/or receiver. If we denote by $y_i$ ($i$ = 1, ..., $N$) the single bits of an LDPC code word y as defined above, then the received values at the input of the LDPC decoder 122 after differential decoding 118 amount to $z_i = y_i + n_i$, with $n_i$ ($i$ = 1, ..., $N$) being Gaussian distributed noise samples of zero mean and variance $\sigma^2$. Usually, the received noisy samples are converted into the Log-Likelihood Ratio (LLR) domain, which leads to a numerically more stable decoder implementation. The LLR of a received sample $z_i$ may be defined as

$$L(z_i) = \log\left(\frac{p(z_i \mid y_i = 0)}{p(z_i \mid y_i = 1)}\right) \qquad (1)$$

with $p(z_i \mid y_i = k) = \exp\left(-(z_i - (1-2k))^2 / (2\sigma^2)\right) / \sqrt{2\pi\sigma^2}$ denoting the probability density function (pdf) of the received sample $z_i$ under AWGN assumption conditioned on the transmitted bit $y_i$ and with bipolar signaling ($y_i$=0 → +1, $y_i$=1 → -1). Conveniently, it turns out that $L(z_i) = z_i \cdot 2/\sigma^2 = z_i \cdot L_c$ under the AWGN assumption. Usually, the value $L_c = 2/\sigma^2$ is assumed to be constant and predetermined.

Turning now to **Fig. 3,** we describe a conventional row-layered LDPC decoding algorithm, as introduced in D. E. Hocevar, "A Reduced Complexity Decoder Architecture via Layered Decoding of LDPC Codes," in Proc. IEEE Workshop on Signal Processing Systems (SIPS), 2004. Here, the LDPC decoder continuously updates the received LLR values with the goal to compute LLRs that approximate the Maximum A Posteriori (MAP) values. The received vector of LLRs **z** 121 is therefore copied to a memory $\hat{\mathbf{z}}$ of size N, which is continuously updated. The decoding operation in the row-layered decoder 122 comprises three acts, where a) the first act prepares the input data, b) the second act performs the computation of new extrinsic data and c) the final act updates the LLR memory. The row-layered LDPC decoder 122 carries out the three steps sequentially for each row of the parity check matrix **H.** After all rows have been considered, a single decoding iteration has been carried out. The LDPC decoder usually carries out several iterations, where the number depends on the available resources.

In the following, we describe the aforementioned three acts for a single row $m$ of **H.** The first step a) comprises computing card($\mathcal{N}(m)$) = $d_c$ (card = cardinality) temporary values $t_{m,i}$, with

$$t_{m,i} = \hat{z}_i - e_{m,i}^{(l)} \qquad \text{for all } i \in \mathcal{N}(m) \qquad (2)$$

for all non-zero entries (indexed by $i$) of the $m$'th row of **H**. The superscript $^{(l)}$ denotes the iteration counter, i.e., the operations are carried out in the $l$-th iteration of the row-layered LDPC decoding procedure. The value $e_{m,i}$ is the (stored) extrinsic memory for row $m$ and variable $\hat{z}_i$. At the beginning of the decoding of a single LDPC frame (code word), all $e_{m,i}$ may be initialized by zero $\left(\text{i.e., } e_{m,i}^{(1)} = 0\right)$ and then continuously updated. Note that in total only $\sum_m$ card($\mathcal{N}(m)$) memory locations may be used for storing the $e_{m,i}$. If the code is check-regular, $\sum_m$ card($\mathcal{N}(m)$) = $Md_c$. In the second step, the extrinsic memory for the subsequent iteration ($l$+1) is updated using the $t_{m,i}$ according to

$$
\begin{aligned}
e_{m,i}^{(l+1)} &= 2\cdot\tanh^{-1}\left(\prod_{j\in\mathcal{N}(m)\setminus\{i\}}\tanh\left(\frac{t_{m,j}}{2}\right)\right) \qquad \text{for all } i\in\mathcal{N}(m) \\
&= \left[\prod_{j\in\mathcal{N}(m)\setminus\{i\}}\operatorname{sign}\left(t_{m,j}\right)\right]\cdot\phi\left(\sum_{j\in\mathcal{N}(m)\setminus\{i\}}\phi\left(\left|t_{m,j}\right|\right)\right), \quad \text{with } \phi(\tau)=-\log\left(\tanh\left(\frac{\tau}{2}\right)\right)=\log\left(\frac{e^{\tau}+1}{e^{\tau}-1}\right)
\end{aligned}
\tag{3}
$$

where the log-domain expression may be more suitable for practical implementations, as the multiplication is replaced by an addition and instead of two functions tanh(·)/tanh$^{-1}$(·), only a single function $\phi$(·) needs to be implemented (or approximated by a look-up table). The product (or the sum) of equation (3) may be carried out over all entries in $\mathcal{N}$ ($m$) except the one under consideration $i$. This is indicated by the notation $\mathcal{N}$ $(m)\setminus\{i\}$. For instance, in the above example, where $\mathcal{N}$ (5) = {1; 5; 9; 13; 21}, $e_{5,13}^{(l+1)}$ may be computed corresponding to

$$
\begin{aligned}
e_{5,13}^{(l+1)} &= 2\cdot\tanh^{-1}\left(\prod_{j\in\mathcal{N}(5)\setminus\{13\}}\tanh\left(\frac{t_{m,j}}{2}\right)\right) = 2\cdot\tanh^{-1}\left(\prod_{j\in\{1;5;9;21\}}\tanh\left(\frac{t_{m,j}}{2}\right)\right) \\
&= 2\cdot\tanh^{-1}\left(\tanh\left(\frac{t_{5,1}}{2}\right)\tanh\left(\frac{t_{5,5}}{2}\right)\tanh\left(\frac{t_{5,9}}{2}\right)\tanh\left(\frac{t_{5,21}}{2}\right)\right).
\end{aligned}
\tag{4}
$$

The derivation of equation (4) for the extrinsic update is beyond the scope of this specification. Usually, if high LDPC decoder throughputs shall be achieved, the computation of $e_{m,i}$ can be further simplified. An often employed simplification of the log-domain equation (3), which we will consider in the following, is the so-called min-sum approximation which leads to

$$
e_{m,i}^{(l+1)} = \left[\prod_{j\in\mathcal{N}(m)\setminus\{i\}}\operatorname{sign}(t_{k,j})\right]\min_{j\in\mathcal{N}(m)\setminus\{i\}}|t_{m,j}| \qquad \text{for all } i\in\mathcal{N}(m). \tag{5}
$$

As this second act b) computes the output of the parity check node $m$ of the check node in the graphical representation of LDPC codes, it is frequently denoted by check node operation.

Finally, in the last decoding act c), the LLR memory may be updated corresponding to

$$
\hat{z}_i = t_{m,i} + e_{m,i}^{(l+1)} \qquad \text{for all } i\in\mathcal{N}(m) \tag{6}
$$

and the LDPC decoder 122 may continue with decoding row $m$+1 or, if $m = M$, restarts at $m$ = 1 (next iteration).

Fig. 3 shows the simplified block diagram 300 of the check node decoding operation for computing $e_{m,i}^{(l+1)}$. As has been explained before, the check node operation 302 may be realized by equations (3) (log-domain) or (5) (min-sum domain).

The update act c) can be further simplified in actual implementations. Let $\mu_m^{[1]} = \min_{j\in\mathcal{N}(m)}|t_{m,j}|$ be the first minimum of the absolute value of all involved incoming messages $t_{m,j}$ at row $m$ and let $i_m^{[1]} = \arg\min_{j\in\mathcal{N}(m)}|t_{m,j}|$ be the position (i.e., the index) of this first minimum. Let furthermore $\mu_m^{[2]} = \min_{j\in\mathcal{N}(m)\setminus\{i_m^{[1]}\}}|t_{m,j}|$ be the second minimum (larger than the first minimum) of all incoming messages at row $m$. We further define $s_m = \prod_{j\in\mathcal{N}(m)}\operatorname{sign}(t_{m,j})$. The output message can then be computed corresponding to

$$e_{m,i}^{(l+1)} = s_m \cdot \operatorname{sign}(t_{m,i}) \cdot \begin{cases} \mu_m^{[1]} & \text{if } i \neq i_m^{[1]} \\ \mu_m^{[2]} & \text{if } i = i_m^{[1]} \end{cases} . \tag{7}$$

Thus, one burden for implementing the check node operation 302 for computing $e_{m,i}^{(l+1)}$ consists in finding the first and second minimum of the incoming messages together with the position of the first minimum. The memory requirements of this algorithm are N memory cells for storing the (continuously updated) a-posteriori values $\hat{z}_i$. Additionally, the storing requirements of the extrinsic memory $e_{m,i}$ 304 amount to the total number of 1s in the parity check matrix **H**, however, due to the simplified implementation using the minimum approximation, the extrinsic memory 304 does not need to store all $d_c$ different values per row, but only the $d_c$ different signs, both minima $\mu_m^{[1]}$ and $\mu_m^{[2]}$, and the location index of the first minimum $i_m^{[1]}$. The values $e_{m,i}$ can then be computed on the fly as required.

As the min-sum algorithm is only an approximation to the full belief-propagation expression of equation (3), numerous attempts have been made to improve the performance of the min-sum algorithm. Two notable improvements are the normalized min-sum algorithm and the offset min-sum algorithm, see J. Chen, A. Dholakia, E. Eleftheriou, M. P. C. Fossorier, and X.-Y. Hu, "Reduced-Complexity Decoding of LDPC Codes," IEEE Transactions on Communications, vol. 53, no. 8, pp. 1288-1299, Aug 2005. The update rule of the offset min-sum algorithm reads

$$e_{m,i}^{(l+1)} = s_m \cdot \operatorname{sign}(t_{m,i}) \cdot \begin{cases} \max(\mu_m^{[1]} - \beta, 0) & \text{if } i \neq i_m^{[1]} \\ \max(\mu_m^{[2]} - \beta, 0) & \text{if } i = i_m^{[1]} \end{cases} , \tag{8}$$

where the variable $\beta$ can either be constant and determined offline or be updated during decoding according to a predefined rule.

A simplified row-layered decoder block diagram 400, which can be derived from Fig. 3 in a straight forward way, is shown in **Fig. 4.** Thereby Fig. 4 exemplarily illustrates the check node operation for all entries in $\mathcal{N}$ (*m*), for example, $\mathcal{N}$ (5) = {1; 5; 9; 13; 21}.

In order to recover the performance loss due to differential encoding, the LDPC decoder 122 can iteratively invoke the soft-input soft-output differential detector 118 as, e.g., described in EP 2 538 596 A1 or EP 2 506 516 A1. If a row-layered LDPC decoder is used, this has some implications on the architecture. The differential detector 118 may be implemented using the BCJR algorithm operating on a trellis diagram, see L. R. Bahl, J. Cocke, F. Jelinek, and J. Raviv, "Optimal Decoding of Linear Codes for minimizing symbol error rate", IEEE Transactions on Information Theory, vol. IT-20(2), pp.284-287, March 1974. In the remainder of this specification we employ the terms "trellis", "trellis decoder", "differential detector" synonymously. We can describe the trellis by a function $y = f_T(\mathbf{s},\mathbf{a})$, with **s** denoting the vector of received modulation symbols from demodulator 116 and **a** denoting a-priori knowledge from the LDPC/FEC decoder 118, 122. The output of the trellis is so-called extrinsic information as defined in J. Hagenauer, E. Offer, L. Papke, "Iterative Decoding of Binary Block and Convolutional Codes", IEEE Trans. Inform. Theory, vol. 42, no. 2, March 1996.

Before first invoking the LDPC decoder 122, the differential detector 118 first needs to prepare the data and fill the LDPC decoder's a-posteriori memory $\hat{z}_i$, ($i \in \mathcal{N}$ (*m*)). This may initially be done by executing the trellis decoder 118 without a-priori knowledge: $\hat{z}_i = f_T(\mathbf{s},\mathbf{0})_i$ and by storing these initial values in a bypass memory 306, i.e., $b_i^{(1)} = \hat{z}_i = f_T(\mathbf{s},0)_i$, **see Fig. 5.** Then the LDPC decoder 122 may be executed and the LDPC decoder's a-posteriori memory $\hat{z}_i$ may be updated several times during the execution of the LDPC decoder 122. Note that in the initial (first) iteration $e_{m,i}^{(1)} = 0$, i.e., the extrinsic memory 304 may be initialized to zero.

After executing the LDPC decoder 122, we now have updated values $\hat{z}_i$ in the LDPC decoder's a-posteriori memory, which is not shown in Fig. 5 for the sake of clarity. The input to the subsequent differential decoder stage 118 is obtained by subtracting the bypass memory $b_i$ 306 from the a-posteriori values $\hat{z}_i$. The next trellis output may be computed according to

$$b_i^{(2)} = f_T(\mathbf{s}, \hat{z}_i - b_i^{(1)})_i \,, \tag{9}$$

or more generally

$$b_i^{(l+1)} = f_T(\mathbf{s}, \hat{z}_i - b_i^{(l)})_i \,, \tag{10}$$

where b denotes the extrinsic information computed by the trellis decoder 118 (see J. Hagenauer, E. Offer, L. Papke, "Iterative Decoding of Binary Block and Convolutional Codes", IEEE Trans. Inform. Theory, vol. 42, no. 2, March 1996). In order to get the updated a-posteriori value $\hat{z}_i'$, we may add the input of the trellis decoder 118 to its output, i.e., we get the updated a-posteriori value according to

$$\hat{z}_i' = \hat{z}_i - b_i^{(l)} + b_i^{(l+1)} = \hat{z}_i - b_i^{(l)} + f_T(\hat{z}_i - b_i^{(l)})_i \,. \tag{11}$$

Generally, in the case of LDPC codes, easy decoding algorithms exist and in contrast to classical channel coding, the challenge is not to find a good decoder for a given code, but to find a good code given the decoding algorithm. Most LDPC codes that are implemented today are so-called Quasi-Cyclic (QC) LDPC codes. They have a parity check matrix **H** with a structure that allows for inherent parallelization of the LDPC decoder and leads to an efficient encoder realization. Almost all LDPC codes utilized in practice belong to the class of QC LDPC codes.

QC-LDPC codes may be constructed using a so-called lifting matrix **A.** The parity check matrix **H** may be constructed from the lifting matrix **A** by replacing each element of **A** with either an all-zero matrix of size *SxS* or a permutation matrix, e.g., a cyclically permuted identity matrix, of size *SxS.* We adhere to the following notation: S denotes the lifting factor, i.e., the size of the all-zero or cyclically shifted identity matrix. If the entry of **A** at row *m* and column *i* corresponds to a predetermined value, e.g., $A_{m,i} = -1$, then the all-zero matrix of size *SxS* is used, and if $A_{m,i} \geq 0$, $A_{m,i}$ may denote how many cyclic right shifts of the identity matrix are performed. If dim(**H**) = $M \times N$, then dim(**A**) = $M' \times N'$, with $M'=M/S$ and $N'=N/S$. We furthermore define the set $\mathcal{N}_{\mathbf{A}}(m)$ to denote the positions of the non "-1" entries (or any other entry denoting a void replacement) in the *m*-th row of **A,** i.e., $\mathcal{N}_{\mathbf{A}}(m) = \{i: A_{m,i} \neq -1\}$.

Let us illustrate the construction of QC-LDPC codes by a small (artificial) example with a lifting matrix of size dim(**A**) = 3×5 and a lifting factor of S = 5 (leading to dim(**H**) = $S \cdot$dim(**A**) = 15x25. This corresponds to a code of design rate $r = 0.4$, or an overhead of 150%, respectively).

$$\mathbf{A} = \begin{pmatrix} -1 & 0 & 1 & 1 & 2 \\ 2 & -1 & 4 & 2 & 1 \\ 1 & 3 & -1 & 3 & 1 \end{pmatrix} \rightarrow \mathbf{H} = \left(\begin{array}{ccccc|ccccc|ccccc|ccccc|ccccc}
&&&& & 1&&&& & &1&&& & &1&&& & &&1&& \\
&&&& & &1&&& & &&1&& & &&1&& & &&&1& \\
&&&& & &&1&& & &&&1& & &&&1& & &&&&1 \\
&&&& & &&&1& & &&&&1 & &&&&1 & 1&&&& \\
&&&& & &&&&1 & 1&&&& & 1&&&& & &1&&& \\
\hline
&&1&& & &&&& & &&&&1 & &&1&& & &1&&& \\
&&&1& & &&&& & 1&&&& & &&&1& & &&1&& \\
&&&&1 & &&&& & &1&&& & &&&&1 & &&&1& \\
1&&&& & &&&& & &&1&& & 1&&&& & &&&&1 \\
&1&&& & &&&& & &&&1& & &1&&& & 1&&&& \\
\hline
&1&&& & &&&1& & &&&& & &&&1& & &1&&& \\
&&1&& & &&&&1 & &&&& & &&&&1 & &&1&& \\
&&&1& & 1&&&& & &&&& & 1&&&& & &&&1& \\
&&&&1 & &1&&& & &&&& & &1&&& & &&&&1 \\
1&&&& & &&1&& & &&&& & &&1&& & 1&&&&
\end{array}\right) \tag{12}$$

Note that for the sake of clarity again only the 1s are show in the description of **H.** Generally the value S corresponds to the parallelism that can be implemented in a QC-LDPC decoder 122.

**Fig.** 6 illustrates an example of a quasi-cyclic parity check matrix **H** (reference numeral 600) of size 3000x25200 ($M$= 3000, $N$ = 25200) resulting from a lifting matrix **A** of size dim(**A**) = 10×84 with a lifting factor S = 300. Note that in this case, also **A** is sparse, i.e., most entries of **A** are, e.g., -1, leading to zero entries for **H.** Note that in Fig. 6 the 1s of **H** are shown as small points. Due to the cyclic structure of the matrix **H,** these show up as diagonal lines in Fig.6.

The implications of the quasi-cyclic (QC) code construction on the row-layered LDPC decoder is shown in **Fig. 7.** Due to the QC structure of **H**, a row-layered LDPC decoder 122 can now process always S rows of **H** in parallel as these computations are independent. This parallelism is necessary to be able to operate at decoding speeds of 100Gbit/s and above. Instead of decoding each row of **H**, the row-layered decoder 122 for QC LDPC codes does now decode each row of the lifting matrix **A** by decoding S rows of **H** in parallel.

The decoding circuitry set up for decoding the first row of **A** of the example above is shown in Fig. 7. Decoding the first row of **A** corresponds to decoding the first, e.g., S = 5 rows of **H.** Note that S = 5 in this example, such that S = 5 check node decoding circuits 300-1 to 300-5 can be deployed in parallel. Note that the first row of **A** contains only 4 non-void entries ($A_{m,i} \geq 0$, as does any other row), which means that each of the first 5 rows of **H** contains only 4 ones. In the left part of the circuit 122 shown in Fig. 7, the memory fetching circuits 710 each retrieve S = 5 neighboring values $\hat{z}_i$ of the a-posteriori memory. For example, the fetching circuit 710-1 retrieves the vector $\hat{\mathbf{z}}_{6:10} = (\hat{z}_6\ \hat{z}_7\ \hat{z}_8\ \hat{z}_9\ \hat{z}_{10})^T$ where the notation "6:10" denotes the entries 6 to 10. These are then processed by the shifting circuit 715-1 (which can be realized using a barrel shifter) to account for the cyclic shifting nature of **H.** If we consider the fetch circuit 710-4 which retrieves $\hat{\mathbf{z}}_{21:25} = (\hat{z}_{21}\ \hat{z}_{22}\ \hat{z}_{23}\ \hat{z}_{24}\ \hat{z}_{25})^T$, the corresponding entry of **A** is $A_{1,5} = 2$, which means that the shifter 715-4 is configured such that it performs a (cyclic) left-shift by "2" and the output of the shifter 715-4 is the vector $(\hat{z}_{23}\ \hat{z}_{24}\ \hat{z}_{25}\ \hat{z}_{21}\ \hat{z}_{22})^T$. The individual outputs of the shifters 715 are then fed to check node operations 302 as described above, and the outputs of the S = 5 parallel check node circuits 300-$s$ ($s$ = 1 ... S) are gathered and then fed to a bank of four inverse shifters 725, that are configured using the same values but perform cyclic right-shifts of the S values at their inputs. These are then stored again in the a-posteriori memory 710.

Note that the columns of **H** correspond to the transmitted bits and the rows to the parity check equations. We assume that the all-zero code word y of 25 bits has been transmitted. Now assume that two phase slip have occurred at positions 6 and 16, leading to a received (hard decision) code word of y' = $(00000111111111100000000000)^T$. Therefore, due to the slip, 10 consecutive bits have been flipped. If we now consider the evaluation of the parity check equations **H·y**', we see that the first 5 parity equations are fulfilled, as both inverted bits are included in each of this five parity checks. However, the other 10 parity checks are not fulfilled due to the phase slip.

In order to overcome extended VLSI implementation complexity for the setup of Fig. 1, a system based on a special class of LDPC Codes (quasi-cyclic, quasi-symmetric) has been proposed that significantly reduces the complexity, as only a single differential decoding execution is needed. In this system, which is illustrated in **Fig. 8,** the positions of the differential code and the inner FEC (LDPC encoder) have been swapped, and modified LDPC encoders 806 and decoders 822 are used making use of a Quasi-Cyclic, Quasi-Symmetric Low-Density Parity-Check (QCQS LDPC) code construction.

A parity check matrix **H'** of a QCQS LDPC code may be obtained by adding parity check matrices $\mathbf{H}_1$ and $\mathbf{H}_2$ of two or more (an even number of) quasi-cyclic LDPC codes obtained based on associated two or more (an even number of) lifting matrices $\mathbf{A}_1$ and $\mathbf{A}_2$. That is to say, the parity check matrix **H'** may correspond to an addition of an even number of parity check matrices corresponding to different quasi-cyclic LDPC codes, respectively. A first $M'S \times N'S$ parity check matrix $\mathbf{H}_1$ of the even number of parity check matrices may be constructed from a first $M' \times N'$ lifting matrix $\mathbf{A}_1$ by replacing each entry of the first lifting matrix $\mathbf{A}_1$ with either an all-zero matrix of size $SxS$ or a permutation matrix, e.g., a cyclically permuted identity matrix, of size $SxS$, depending on the entry of the first lifting matrix $\mathbf{A}_1$. A second $M'S \times N'S$ parity check matrix $\mathbf{H}_2$ of the even number of parity check matrices may be constructed from a second $M' \times N'$ lifting matrix $\mathbf{A}_2$ by replacing each entry of the second lifting matrix $\mathbf{A}_2$ with either an all-zero matrix of size $SxS$ or a permutation matrix, e.g., a cyclically permuted identity matrix, of size $S \times S$, depending on the entry of the second lifting matrix $\mathbf{A}_2$. If the entry of $\mathbf{A}_1$, $\mathbf{A}_2$ at row $m$ and column $i$ corresponds to a predetermined value, e.g., $A_{m,i} = -1$, then the all-zero matrix of size $SxS$ is used, and if $A_{m,i} \geq 0$, $A_{m,i}$ may denote how many cyclic right shifts of the identity matrix are performed.

The at least two lifting matrices $\mathbf{A}_1$ and $\mathbf{A}_2$ may have the property that no two entries (different from, e.g., -1 where "-1" denotes the entropy leading to a void replacement) at the same position are identical, i.e., $A_{1,m,i} = A_{2,m,i}$ if $A_{1,m,i} = -1$ and $A_{1,m,i} \neq A_{1,m,i} \neq -1$ if $A_{1,m,i} \neq -1$. We may furthermore assume without loss of generality that $A_{2,m,i} > A_{1,m,i}$ if $A_{1,m,i} \neq -1$. That is to say, an entry $A_{1,m,i}$ of the $m$-th row and the $i$-th column of the first lifting matrix $\mathbf{A}_1$ may correspond to an entry $A_{2,m,i}$ of the $m$-th row and the $i$-th column of the second lifting matrix $\mathbf{A}_2$ if and only if the entry $A_{1,m,i}$ is x, wherein $x$ (e.g., $x = -1$) denotes a predetermined value of the first lifting matrix $\mathbf{A}_1$ leading to $SxS$ void or zero entries in the corresponding first parity check matrix $\mathbf{H}_1$, and wherein an entry $A_{1,m,i} \neq A_{2,m,i} \neq x$ if $A_{1,m,i} \neq x$. Further, $A_{1,m,i}$ may be smaller than $A_{2,m,i}$ if $A_{1,m,i} \neq x$.

Hence, Fig. 8 suggests an encoder 830 to be used on transmitter side, wherein the encoder 830 comprises a differential encoder 810 which is configured to provide a differentially encoded signal 811 based on an input signal 105 and based on a differential encoding rule. Thereby the differential encoder 810 can be a plain bit differential encoder making a current bit to depend on a previous bit or a block differential encoder making a current block of bits to depend on a previous block of bits, resulting in a lower complexity. Further, the encoder 830 comprises an LDPC encoder 806 which is configured to provide an LDPC encoded signal 807 based on the differentially encoded signal 811 and based on an LDPC encoding rule defined by or corresponding to an $M'S \times N'S$ parity check matrix **H'** comprising a plurality of *SxS* permutation or circulant sub-matrices with an even number of non-zero entries in each row of a sub-matrix. In this way the LDPC decoding rule may be kept transparent to phase slips caused, e.g., by (phase) noise of a transmission channel for the LDPC encoded signal.

On the receiver side, a decoder 840 comprises an LDPC decoder 822 which is configured to provide an output signal 823 based on an input signal 821 and based on an LDPC decoding rule defined by or corresponding to an $M'S \times N'S$ parity check matrix **H'** comprising a plurality of *SxS* permutation or circulant sub-matrices with an even number of non-zero entries in each row of an *SxS* sub-matrix. Further, the decoder 840 comprises a differential decoder 818 which is configured to provide a decoded signal 819 based on the output signal 823 from the LDPC decoder 822 and based on a differential decoding rule corresponding to the differential encoding rule.

As has been explained before, the encoder 830 and/or decoder 840 may be comprised by an optical communication system 800 for transmitting optical signals. However, other applications, such as in wireless communications, are also possible. Therefore embodiments are not restricted to the exemplary setup shown in Fig. 8. In fact, other hard- and/or software combinations are possible.

The implementation of Fig. 8 however has a drawback in that binary codes can only be used if constellations with 180° phase ambiguity, i.e. $V = 2$; are used. If constellations with 90° phase ambiguities are employed (e.g., the frequently used QPSK and 16-QAM), this solution requires the use of non-binary codes, hindering the implementation, as the decoding complexity of a non-binary (with field size 4, e.g., using fields GF(4) or the ring of integers modulo-4)) scales with $O(N \cdot 2 \cdot \log(4))$ compared to $O(N)$ for a binary code. It is therefore advantageous to employ binary codes, as the majority of employed modulation formats have phase ambiguities of 180°.

The present disclosure proposes to extend the aforementioned QCQS LDPC code construction that allows parts of the codeword to be sign-inverted to also account for the case were two neighboring bits are position exchanged. This may be ensured by the quasi-cyclic property of the code (a cyclic shift of a chunk of the codeword is again a valid codeword) and a properly designed interleaver. Embodiments of the proposed quasi-symmetric, position-inversion-transparent code can stay agnostic to this sign flip and position exchange. The sign flips and position exchanges remain after decoding and correcting the transmission errors. A decoded codeword may then be further decoded by a quaternary differential decoder to remove these ambiguities. The remaining errors, which are due to the fact that the phase slips do not occur at the specific boundaries of the parts to be sign-inverted, may be corrected by a strong outer code.

Embodiments provide an encoder device and an according decoder device. Block diagrams of such devices are schematically illustrated in **Figs. 9a and 9b.**

The encoder 900 of Fig. 9a includes an interleaver module 910 having an input 911 for a binary signal and an output 912 for an interleaved signal. Thereby a pair of bits of the binary signal at the input 911 may correspond to or may be mapped to a differentially encoded quaternary symbol. The interleaver module 910 is configured to interleave an input block of $K$ consecutive bits of the binary signal at the input 911 in accordance with a first interleaver rule $\pi$. The interleaver rule $\pi$ re-arranges the $K$ consecutive bits of the input block to an interleaved signal block of $K$ consecutive interleaved bits. The interleaved signal block at the output 912 comprises at least a first sub-block of S consecutive bits corresponding to odd bit positions in the input block and at least one adjacent second sub-block of S consecutive bits corresponding even bit positions in the input block.

The encoder 900 further includes a systematic LDPC encoder module 920 having an input 921 for the interleaved signal block (having $K$ bits) and an output 922 for an LDPC encoded signal block (having $N$ bits). The LDPC encoder module's input 921 is coupled to the interleaver module's output 912. The LDPC encoder module 920 is configured to provide the LDPC encoded signal block based on a combination of the interleaved signal block with an $M \times N$ parity check matrix **H** of a systematic LDPC code of rate $K/N$, where $K = (N-M)$. According to embodiments, the LDPC encoder module 920 is configured to encode the interleaved input signal block **x** systematically, i.e., the input signal block is included verbatim in the LDPC encoded output signal block y (i.e., codeword), e.g., **y** = **(x p)** where **p** are the parity-bits. The parity check matrix **H** comprises $M'$ rows of $N'$ binary-valued sub-matrices of size *SxS.* Thereby, a first sub-matrix corresponding to an odd sub-matrix position in a row of sub-matrices equals an adjacent second sub-matrix corresponding to an even sub-matrix position in the row of sub-matrices. The latter condition may hold at least for those sub-matrices of the parity check matrix H which are associated or combined with a portion of the input signal (i.e., the interleaved signal block) that has been differentially encoded by an optional differential encoder.

The encoder 900 also includes a de-interleaver module 930 having an input 931 for the LDPC encoded signal block and an output 932 for a de-interleaved signal. The de-interleaver module's input 931 is coupled to the LDPC encoder module's output 922. The de-interleaver module 930 is configured to de-interleave the LDPC encoded signal block of N consecutive bits in accordance with a second interleaver rule π' of a corresponding second interleaver. The corresponding de-interleaver rule may hence be denoted as $\pi'^{-1}$. The second interleaver rule π' re-arranges N consecutive bits of an input signal block to an interleaved signal block of N consecutive interleaved bits. The interleaved signal block comprises at least a first sub-block of S consecutive bits corresponding to odd bit positions in the input signal block and at least a second sub-block of S consecutive bits corresponding to even bit positions in the input signal block.

The skilled person having benefit from the present disclosure will appreciate that the different encoder modules may 910, 920, and 930 may be implemented by means of respective dedicated hardware, such as ASICs, for example, accordingly programmed general purpose hardware circuits, such as DSPs, for example. A chosen implementation may depend on various factors, e.g., including costs, performance, and the like.

The corresponding decoder 950 of Fig. 9b includes an interleaver module 960 having an input 961 for a received signal and an output 962 for an interleaved signal. A pair of samples of the received signal at input 961 corresponds to a potential or hypothetical differentially encoded quaternary symbol. The interleaver module 960 is configured to interleave an input block of N consecutive samples of the received signal according to interleaver rule π'. As mentioned before, the interleaver rule π' re-arranges the N consecutive samples of the input block to an interleaved signal block of N consecutive interleaved samples. The interleaved signal block at output 962 comprises at least a first sub-block of S consecutive samples corresponding odd sample positions in the input block and at least an adjacent second sub-block of S consecutive samples corresponding even sample positions in the input block.

The decoder 950 also includes an LDPC decoder module 970 having an input 971 for the interleaved signal block (having N samples) and an output 972 for an LDPC decoded signal block (having *K* samples). The LDPC decoder module's input 971 is coupled to the interleaver module's output 962. The LDPC decoder module 970 is configured to provide the LDPC decoded signal block at its output 972 based on a combination of the interleaved signal block with the $M \times N$ parity check matrix **H** of the systematic LDPC code of rate *K*/*N*. As mentioned before, the parity check matrix **H** comprises *M'* rows of *N'* binary-valued sub-matrices of size *SxS*. A first sub-matrix corresponding to an odd sub-matrix position in a row of sub-matrices equals an adjacent second sub-matrix corresponding to an even sub-matrix position in the row of sub-matrices. The latter condition may hold at least for those sub-matrices of the parity check matrix **H** which are associated or combined with a portion of the LDPC decoder module's input signal that has been differentially encoded by an optional differential encoder at a transmitter side.

The decoder 950 further includes a de-interleaver module 980 having an input 981 for the LDPC decoded signal block (having *K* samples) and an output 982 for a de-interleaved signal (having *K* de-interleaved samples). The de-interleaver module's input 981 is coupled to the LDPC decoder module's output 972. The de-interleaver module 980 is configured to de-interleave the LDPC decoded signal block of *K* consecutive samples in accordance with interleaver rule π of a corresponding interleaver. Hence, the de-interleaver rule is $\pi^{-1}$. The second interleaver rule π re-arranges an input signal block of *K* consecutive input samples to an interleaved signal block of *K* consecutive interleaved samples. The interleaved signal block comprises at least a first sub-block of S consecutive samples corresponding odd bit positions in the input signal block and at least a second sub-block of S consecutive samples corresponding even bit positions in the input signal block.

The skilled person having benefit from the present disclosure will appreciate that the different decoder modules may 960, 970, and 980 may be implemented by means of respective dedicated hardware, such as ASICs, for example, accordingly programmed general purpose hardware circuits, such as DSPs, for example. A chosen implementation may depend on various factors, e.g., including costs, performance, and the like.

In order to explain the functioning of embodiments, consider the Gray-mapped QPSK example of **Fig. 10a.**

Let the two bits assigned to each QPSK symbol be denoted by ($b_1$ $b_2$). As observed in J. Karaki, R. le Bidan and E. Pincemin, "A Simple and High-Performance Method for Combining Soft-Decision FEC with Differential Encoding in 100 Gbps Dual-Polarization QPSK System," Proc. OFC 2014, Paper M3A.7, San Francisco, CA, USA, a phase slip of -90° leads to a modified QPSK symbol that can be described by ($b_1'$ $b_2'$) = ($1 \oplus b_2$ $b_1$), i.e., the position of the bits is exchanged and the first bit is inverted. Similarly, a phase slip of +90° leads to a modified QPSK symbol that can be described by ($b_1''$ $b_2''$) = ($b_2$ $1 \oplus b_1$), i.e., again the position of the bits is exchanged (they swap places) and the second bit is inverted. This means that following a phase slip, all groups of two bits in a bit stream are position exchanged and one of these bits is inverted.

**Fig. 10b** illustrates an example where a phase slip occurs after four symbols (e.g., 8 bits) in a bitstream corresponding to quaternay modulation symbols. It can clearly be seen that the respective second bits $b_2$ of a bit pair ($b_1$ $b_2$) change position and the respective first bits $b_1$ change position and are flipped after the phase slip.

A solution presented in J. Karaki, R. le Bidan and E. Pincemin, "A Simple and High-Performance Method for Combining Soft-Decision FEC with Differential Encoding in 100 Gbps Dual-Polarization QPSK System," Proc. OFC 2014, Paper M3A.7, San Francisco, CA, USA, proposes to use a multi-level coding approach and to use a separate code for bit $b_1$ and a separate code for bit $b_2$ where both codes are symmetric codes, i.e., the all-one codeword is a codeword of the code, meaning the the inversion of each codeword (as the code is linear, the addition of two codewords over the binary field is itself a valid codeword, thus **x**+(1 1 1 1 ... 1) is a valid codeword) is a codeword again. In this case, with an outer differential decoder, a phase ambiguity per whole codeword can be resolved. However, the case where a single phase slip can occur within the codeword is not taken into account.

Here, it is proposed to further extend the solution described with reference to Fig. 8 and to take into account the case where we do not only allow for bit inversion, but also position changes, as required by the 90° phase ambiguity system.

**Fig. 11** illustrates an overview of a communication system 1100 according to an embodiment of the present disclosure. Communication system 1100 includes the aforementioned encoder device 900 on the transmit side and the aforementioned decoder device 950 on the receive side.

The signal processing exemplarily starts at the upper left corner of Fig. 11 with an outer encoder 102, which may, for example, correspond to a convolutional encoder, a Reed Solomon encoder, a Turbo product encoder 102, or the like. The task of the outer encoder 102 is to add redundancy to an input information word 101, which may comprise digitized data. A binary signal output 103 of the outer encoder 102 may then be fed to a bina-ry-to-quaternary conversion module 1105 having an input for the binary signal 103 and an output for a quaternary signal 1107. Binary-to-quaternary conversion module 1105 is configured to convert pairs of bits of the binary signal 103 to respective quaternary symbols (e.g. 0, 1, 2, or 3) of the quaternary signal 1107. This may be done according to a predefined mapping rule, e.g., a Gray mapping rule, where two successive values differ in only one bit (binary digit). The resulting quaternary symbol stream 1107 may then be fed to an input of a differential encoder module 1109 having as output a differentially encoded quaternary signal 1111. The differential encoder module 1109 is configured to provide the differentially encoded quaternary signal 1111 based on the quaternary signal 1107 and a quaternary differential encoding rule. The differentially encoded quaternary signal 1111 may be further fed to an input of a quaternary-to-binary conversion module 1113 having for output a binary signal 1115. Quaternary-to-binary conversion module 1113 is configured to convert quaternary symbols of the differentially encoded quaternary signal 1111 to respective pairs of bits of the binary signal 1115. Frames or blocks of the binary signal 1115 may be fed to the input 911 of the encoder's interleaver module 910. Thereby, a frame may consist of *K* bits. Output 932 of the encoder 900, i.e., a de-interleaved binary signal block of size N, may be fed to a mapping module 108. The mapping module 108 is configured to map a number of bits of the de-interleaved signal to a modulation symbol of an at least quaternary symbol alphabet.

The receiver side of the example communication system 1100 carries out the respective inverse operations, i.e., de-mapping 1118, interleaving $\pi'$ 960, LDPC decoding 970, de-interleaving $\pi^{-1}$ 980, binary-to-quaternary conversion 1120, differential decoding 1122, quaternary-to-binary conversion 1124, and outer decoding 126.

That is to say, the receiver may further comprise a de-mapping module 1118 upstream to the decoder device 950, the de-mapping module 1118 having an input for a received modulated signal 1117 and an output for a demodulated signal 1119. The de-mapping module 1118 may be configured to map a received modulated signal sample to a number of demodulated signal samples based on a (de-)mapping rule between a number of bits and a modulation symbol of an at least quaternary symbol alphabet. According to one embodiment, the de-mapping module 1118 may determine soft-decisions, e.g. in form of likelihood information (e.g. Log-Likelihood Ratios, LLRs), for the demodulated signal samples. In the example implementation of Fig. 11, the de-mapping module's output is coupled to input 961 of interleaver module 960.

The differential decoder module 1122 downstream to (or after) inner decoder device 950 may have an input for a quaternary signal and an output for a differentially decoded quaternary signal. The differential decoder module 1122 may be configured to provide the differentially decoded quaternary signal based on the input quaternary signal and a differential decoding rule. In different embodiments, the differential decoder module's input may be either directly or indirectly coupled to de-interleaver module's output 982. In the illustrated example of Fig. 11, the differential decoder module 1122 is indirectly coupled to the interleaver module 980 via binary-to-quaternary conversion module 1120. An output of differential decoder module 1122 is coupled to an input of a quaternary-to-binary conversion module 1124 having an output for a binary signal. Quaternary-to-binary conversion module 1124 is configured to convert a quaternary symbol of the differentially decoded quaternary signal to a respective pair of bits of the binary signal, which may then be further decoded by outer decoder 126.

In the proposed communication system 1100, we exchange the positions of inner FEC coder 900 and differential coder 1109, as already done in the system according to Fig.8. For the inner LDPC encoder 900 we propose to design a systematic Forward Error Correction code that is slip-transparent, i.e., that fulfills the following properties

- the inversion of every second bit of a sequence of bits should be a valid codeword,
- the exchange of two neighboring bits in a sequence of bits (and possible inverting one of these) should also be a valid codeword.

For simplified explanatory reasons only, we assume that quaternary QPSK transmission over channel 114 is used and further assume that the transmitted data 113 is partitioned into blocks of N symbols. Note, however, that embodiments are not limited to QPSK transmission. We further assume that *N is* an integer multiple of a number S, i.e,

$N = k \cdot S$. To show an idea behind the proposed scheme, we first assume that phase slips can only occur at positions $pos \in \{1; 1+S; 1+2S, ...\}$ within one such block, i.e., at multiples of S. A phase slip thus affects at least S consecutive QPSK symbols.

We thus design an LDPC code that is agnostic to phase slips, which means that it can handle the event that a sequence of at least $2S$ bits is inverted and where the bit positions in a codeword can be exchanged within pairs of adjacent bits. We call such a code *"slip transparent code"*. The code design with respect to the system of Fig. 8 is slip transparent to phase slips that are a multiple of 180°, e.g., in BPSK constellations, or in special constellations with 180° phase ambiguity.

A first important component of the proposed scheme is the interleaver 910 with its underlying interleaver rule $\pi$. We define the interleaver rule $\pi$ of interleaver 910 to form a permutation from an input vector $\mathbf{x}$ of length $K$ to an output vector y of length $K$ with

$$y_{\left\lfloor \frac{i-1}{2S} \right\rfloor 2S + \frac{(i-1)\%(2S)}{2} + 1} = x_i \quad \text{if } i \text{ odd}$$

$$y_{\left\lfloor \frac{i-1}{2S} \right\rfloor 2S + \frac{(i-2)\%(2S)}{2} + S + 1} = x_i \quad \text{if } i \text{ even},$$

where $\lfloor u \rfloor$ denotes the largest integer smaller or equal than $u$ and (u%v) returns the remainder of $u$ divided by v, i.e., $u = qv + (u\%v)$ with $q$ being an integer such that $0 \leq (u\%v) < v$. The skilled person having benefit from the present disclosure will appreciate that the decoder's de-interleaver 980 is based on the same interleaver rule $\pi$. The de-interleaver 980 employs the inverse interleaver rule $\pi^{-1}$. Hence, the de-interleaver module 980 is configured to re-arrange the $i$-th sample $y_i$ of an input block to obtain a sample $x_i$ of the de-interleaved signal block according to

$$x_i = y_{\left\lfloor \frac{i-1}{2S} \right\rfloor 2S + \frac{(i-1)\%(2S)}{2} + 1} \quad \text{if } i \text{ odd}$$

$$x_i = y_{\left\lfloor \frac{i-1}{2S} \right\rfloor 2S + \frac{(i-2)\%(2S)}{2} + S + 1} \quad \text{if } i \text{ even}.$$

As an illustrative example, consider S = 5 *and* $K$ = 20, such that $\mathbf{x} = (x_1,...,x_{20})$. In this case, the interleaved signal block $\mathbf{y}$ is given by

$$\mathbf{y} = \left( x_1 \;\; x_3 \;\; x_5 \;\; x_7 \;\; x_9 \;\vdots\; x_2 \;\; x_4 \;\; x_6 \;\; x_8 \;\; x_{10} \;\vdots\; x_{11} \;\; x_{13} \;\; x_{15} \;\; x_{17} \;\; x_{19} \;\vdots\; x_{12} \;\; x_{14} \;\; x_{16} \;\; x_{18} \;\; x_{20} \right)(*)$$

The interleaver rule $\pi$ converts a bit stream $\mathbf{x} = (x_1,...,x_K)$. into $\mathbf{y} = (x_1, x_3, ..., x_{2S-1}, x_2, x_4, ..., x_{2S}, x_{2S+1}, ..., x_{4S-1}, x_{2S+2}, ..., x_{4S}, ...)$, i.e., separates originally neighboring bits into adjacent sub-blocks of interleaved signal block **y,** where sub-blocks $2i$-1 contain bits from the odd positions in **x** and sub-blocks $2i$ contain bits from the even positions in x. This means that when considering the according de-interleaving rule 930, each QPSK symbol gets a contribution from two neighboring sub-blocks.

The interleaver rule $\pi$' underlying interleaver module 960 and de-interleaver module 930 is similar to $\pi$ with the exception that it acts on frames or blocks of length N instead on signal blocks of length $K$.

An example realization of the interleavers 910, 960 is shown in **Fig. 12.**

A left-most switch 1202 operating on an input signal block changes its position every bit or sample such that bits/samples at odd positions are distributed to the upper chain ($u$) and bits/samples at even positions to the lower chain ($l$). Switch 1204-$u$ of the upper chain changes its position every 2S samples. The same holds for switch 1204-$l$ of the lower chain. Once the respective shift registers 1206 are filled, which is the case after 2S time instants (bits/samples), the next switches 1208-$u$ and 1208-$l$ are each moved to the other position in the respective chain (upper or lower) and the filled FIFO buffers 1206 may be read. Note that the read buffers 1206 are also swapped every 2S time instants.

If, for example, a phase slip occurs immediately after the fifth transmitted symbol (after the 10th bit), this means that the bits/samples $x_{11}$, ... are affected such that the bits/samples $x_{2i}$ and $x_{2i-1}$ swap positions and such that bit $x_{2i-1}$ is additionally inverted. This means that if vector **t** = ($t_1$, $t_2$, ...) has been transmitted, we receive vector z with

$$\mathbf{z}=\left(t_1 \quad t_2 \quad t_3 \quad t_4 \quad t_5 \mid t_6 \quad t_7 \quad t_8 \quad t_9 \quad t_{10} \mid t_{12} \quad 1\oplus t_{11} \quad t_{14} \quad 1\oplus t_{13} \quad t_{16} \mid 1\oplus t_{15} \quad t_{18} \quad 1\oplus t_{17} \quad t_{20} \quad 1\oplus t_{19}\right)$$

After interleaving with the interleaver module 960, we get the following interleaved vector $\mathbf{z}^{[i]}$ at the input of LDPC decoder module 970:

$$\mathbf{z}^{[i]}=\left(t_1 \quad t_3 \quad t_5 \quad t_7 \quad t_9 \mid t_2 \quad t_4 \quad t_6 \quad t_8 \quad t_{10} \mid t_{12} \quad t_{14} \quad t_{16} \quad t_{18} \quad t_{20} \mid 1\oplus t_{11} \quad 1\oplus t_{13} \quad 1\oplus t_{15} \quad 1\oplus t_{17} \quad 1\oplus t_{19}\right)$$

If we compare the interleaved vector $\mathbf{z}^{[i]}$ with the LDPC encoded transmit vector (*), we observe that the third and the fourth group of $S$ = 5 bits/samples have swapped their positions and additionally, the third group **of y,** which has become the fourth group of $\mathbf{z}^{[i]}$, has been inverted. Note that interleaved vector $\mathbf{z}^{[i]}$ is at the input of LDPC decoder 970, which now has to be transparent to the inversion of $S$ = 5 continuous bits and the exchange of two neighboring blocks of $S$ = 5 bits each in position. The former condition has been successfully solved with the code design related to Fig. 8 using the concept of quasi-symmetric codes. It remains to solve the latter condition, which can be done by extending the concept of quasi-symmetric codes as described below.

Recall that quasi-symmetric codes fulfill the property that each parity-check equation contains an even number of participants from each sub-block of size $S$. Equivalently card( $\mathcal{N}(m)\cap\{kS+1,kS+2,...,(k+1)S\}$)= $2j$ for all $M$ (rows of **H)** and all possible (valid within the range of code size) integers $k$ and $j$ being an integer number. The extension we introduce in the present disclosure, denoted slip-transparent codes, does fulfill this condition as well. They further fulfill the additional condition that each parity check equation has the same (even number of) connections in two adjacent sub-blocks $2k$-1 and $2k$ (with $k$ integer), i.e., we have

$$\mathcal{N}(m)\cap\{2kS+1,2kS+2,...,(2k+1)S\}=B$$

*with*

$$B:=\{\ell-S:\ell\in(\mathcal{N}(m)\cap\{(2k+1)S+1,(2k+1)S+2,...,(2k+2)S\})\}$$

where $k$ are the integers defining the $SxS$ sub-blocks or sub-matrices of the parity-check matrix. Note that card($B$) = $2\cdot j$ ($j$ integer) still has to be fulfilled. This equation may be fulfilled for each row $m$ of the LDPC codes's parity-check matrix **H.** In the following, we present a code construction technique using the quasi-cyclic code construction introduced above.

Now let us consider the following code construction which we denote as extended Quasi-Symmetric Quasi-Cyclic (eQSQC) LDPC code. It is an extension of the quasi-symmetric quasi-cyclic (also called as block-symmetric quasi-cyclic code that we have explained referring to Fig. 8).

Recall that an $M'\cdot S \times N'\cdot S$ parity check matrix **H'** of a QCQS LDPC code comprises a plurality of $S\times S$ permutation (e.g., circulant) sub-matrices with an even number of non-zero entries in each row (and thus, consequently, also with an even number of non-zero entries in each column) of a sub-matrix. Such a parity check matrix **H'** may be obtained by adding parity check matrices $\mathbf{H}_1$ and $\mathbf{H}_2$ of two or more (an even number of) quasi-cyclic LDPC codes obtained based on associated two or more (an even number of) lifting matrices $\mathbf{A}_1$ and $\mathbf{A}_2$. That is to say, the parity check matrix **H'** may correspond to an addition of an even number of parity check matrices corresponding to different quasi-cyclic LDPC codes, respectively. A first $M'S\times N'S$ parity check matrix $\mathbf{H}_1$ of the even number of parity check matrices may be constructed from a first $M'\times N'$ lifting matrix $\mathbf{A}_1$ by replacing each entry of the first lifting matrix $\mathbf{A}_1$ with either an all-zero matrix of size $SxS$ or a permutation matrix, e.g., a cyclically permuted identity matrix, of size $SxS$, depending on the entry of the first lifting matrix $\mathbf{A}_1$. A second $M'S\times N'S$ parity check matrix $\mathbf{H}_2$ of the even number of parity check matrices may be constructed from a second $M'\times N'$ lifting matrix $\mathbf{A}_2$ by replacing each entry of the second lifting matrix $\mathbf{A}_2$ with

either an all-zero matrix of size *SxS* or a permutation matrix, e.g., a cyclically permuted identity matrix, of size *SxS,* depending on the entry of the second lifting matrix $\mathbf{A}_2$. If the entry of $\mathbf{A}_1$, $\mathbf{A}_2$ at row *m* and column *i* corresponds to a predetermined value, e.g., $A_{m,i}$ = -1, then the all-zero matrix of size *SxS* is used, and if $A_{m,i} \geq 0$, $A_{m,i}$ may denote how many cyclic right shifts of the identity matrix are performed.

According to some embodiments, the at least two lifting matrices $\mathbf{A}_1$ and $\mathbf{A}_2$ may have the property that no two entries (different from, e.g., -1 where "-1" denotes the entropy leading to a void replacement) at the same position are identical, i.e., $A_{1m,i} = A_{2m,i}$, if $A_{1m,i}$ = -1, and $A_{1m,i} \neq A_{2m,i} \neq -1$, if $A_{1m,i} \neq -1$. We may furthermore assume without loss of generality that $A_{2m,i} > A_{1m,i}$, if $A_{1m,i} \neq -1$. That is to say, an entry $A_{1,m,i}$ of the *m*-th row and the *i*-th column of the first lifting matrix $\mathbf{A}_1$ may correspond to an entry $A_{2,m,i}$ of the *m*-th row and the *i*-th column of the second lifting matrix $\mathbf{A}_2$, if the entry $A_{1,m,i}$ is *x*, wherein *x* (e.g., *x* = -1) denotes a predetermined value of the first lifting matrix $\mathbf{A}_1$ leading to *SxS* void or zero entries in the corresponding first parity check matrix $\mathbf{H}_1$, and wherein an entry $A_{1,m,i} \neq A_{2m,i} \neq x$, if $A_{1m,i} \neq x$. Further, $A_{1,m,i}$ may be smaller than $A_{2,m,i}$ if $A_{1m,i} \neq x$.

A parity check matrix **H'** of a proposed eQCQS LDPC code for *V*= 4 may also comprises a plurality of $S\times S$ permutation (e.g., circulant) sub-matrices with an even number of non-zero entries in each row (and thus, consequently, also with an even number of non-zero entries in each column) of a sub-matrix. A eQCQS LDPC code parity check matrix **H'** may be obtained by adding the parity check matrices $\mathbf{H}_1$ and $\mathbf{H}_2$ of two or more (an even number of) quasi-cyclic LDPC codes obtained by the lifting matrices $\mathbf{A}_1$ and $\mathbf{A}_2$ of size $M'\times N'$ which have the property that no two entries (different from e.g. -1) at the same position are identical, i.e., $A_{1,m,i} = A_{2m,i}$ if $A_{1m,i}$=-1 and $A_{1m,i} \neq A_{2m,i}$ if $A_{1m,i} \neq -1$ (and $A_{2,m,i} \neq -1$). We furthermore assume without loss of generality that $A_{2m,i} > A_{1,m,i}$ if $A_{1m,i} \neq -1$. Additionally, an extended property that has to hold is that *N'* should be even and $A_{1m,2i-1} = A_{1m,2i}$ and $A_{2m,2i-1} = A_{2m,2i}$, for $i \in \{1,2,...,N'/2\}$.

So, according to some embodiments, the parity check matrix **H'** underlying LDPC encoder module 920 and LDPC decoder module 960 may be based on an addition of an even number of parity check matrices corresponding to different quasi-cyclic LDPC codes, respectively. A first parity check matrix $\mathbf{H}_1$ of the even number of parity check matrices may be constructed from a first $M'\times N'$ lifting matrix $\mathbf{A}_1$ by replacing each entry of the first lifting matrix $\mathbf{A}_1$ with either an all-zero matrix of size *SxS* or a permutation matrix of size $S\times S$, depending on the entry of the first lifting matrix. A second parity check matrix $\mathbf{H}_2$ of the even number of parity check matrices may be constructed from a second $M'\times N'$ lifting matrix $\mathbf{A}_2$ by replacing each entry of the second lifting matrix with either an all-zero matrix of size *SxS* or a permutation matrix of size $S\times S$, depending on the entry of the second lifting matrix. An entry $A_{1m,i}$ of the *m*-th row and the *i*-th column of the first lifting matrix $\mathbf{A}_1$ corresponds to an entry $A_{2m,i}$ of the *m*-th row and the *i*-th column of the second lifting matrix $\mathbf{A}_2$, if the entry $A_{1,m,i}$ is *x*, wherein *x* denotes a predetermined value leading to zero entries in the corresponding first and second parity check matrices. Further, the following relations have to hold:

$$A_{1,m,i} \neq A_{2,m,i}\ \text{, if } A_{1,m,i} \neq x \text{ and/or } A_{2,m,i} \neq x,$$

and

$$A_{1,m,2i-1} = A_{1,m,2i} \text{ and } A_{2,m,2i-1} = A_{2,m,2i}.$$

We illustrate the proposed code construction by an example of an extended quasi-symmetric quasi-cyclic LDPC code:

$$\begin{array}{l}\mathbf{A}_1=\begin{pmatrix}-1 & -1 & 0 & 0 & 0 & 0\\ 2 & 2 & 1 & 1 & 1 & 1\\ 1 & 1 & -1 & -1 & 1 & 1\end{pmatrix}\\ \mathbf{A}_2=\begin{pmatrix}-1 & -1 & 4 & 4 & 2 & 2\\ 3 & 3 & 2 & 2 & 4 & 4\\ 3 & 3 & -1 & -1 & 0 & 0\end{pmatrix}\end{array}\rightarrow \mathbf{H'}=\left(\begin{array}{ccccc|ccccc|ccccc|ccccc|ccccc|ccccc}
&&&&&&&&&&1&&&&1&1&&&&1&1&&1&&&1&&1&&\\
&&&&&&&&&&1&1&&&&1&1&&&&&1&&1&&&1&&1&\\
&&&&&&&&&&&1&1&&&&1&1&&&&&1&&1&&&1&&1\\
&&&&&&&&&&&&1&1&&&&1&1&&1&&&1&&1&&&1&\\
&&&&&&&&&&&&&1&1&&&&1&1&&1&&&1&&1&&&1\\
\hline
&&1&1&&&&1&1&&&1&1&&&&1&1&&&&1&&&1&&1&&&1\\
&&&1&1&&&&1&1&&&1&1&&&&1&1&&1&&1&&&1&&1&&\\
1&&&&1&1&&&&1&&&&1&1&&&&1&1&&1&&1&&&1&&1&\\
1&1&&&&1&1&&&&1&&&&1&1&&&&1&&&1&&1&&&1&&1\\
&1&1&&&&1&1&&&1&1&&&&1&1&&&&1&&&1&&1&&&1&\\
\hline
&1&&1&&&1&&1&&&&&&&&&&&&1&1&&&&1&1&&&\\
&&1&&1&&&1&&1&&&&&&&&&&&&1&1&&&&1&1&&\\
1&&&1&&1&&&1&&&&&&&&&&&&&&1&1&&&&1&1&\\
&1&&&1&&1&&&1&&&&&&&&&&&&&&1&1&&&&1&1\\
1&&1&&&1&&1&&&&&&&&&&&&&1&&&&1&1&&&&1
\end{array}\right)$$

It can be seen that the $M'{\cdot}S \times N'{\cdot}S$ parity check matrix **H'** comprises a plurality of $S{\times}S$ permutation (e.g., circulant) sub-matrices with an even number of non-zero entries in each row (and thus, consequently, also with an even number of non-zero entries in each column) of a sub-matrix. It can further be seen that the *SxS* sub-matrices at positions 2*k*-1 and 2*k* (with *k* integer) of a row of are identical, respectively. As the cyclic shift values of $S{\times}S$ blocks of **H'** with even and odd indices are always equal, this means that we may exchange the bits of the codewords at those positions corresponding to an even or odd sub-block without changing the parity-check equations. It can be shown that this code has a minimum distance of $d_{min}$ = 2, which could result in an elevated error floor. However, an outer code is required anyways to clean up the errors after differential decoding 1122 caused by phase slips. This outer code can be dimensioned such that the errors due to near-codewords can be corrected as well. Note that the widely-used Turbo codes also have extremely low minimum distances, however, they are very attractive for implementation due to their good properties in the waterfall region.

The binary-to-4-ary transform modules 1105 and 1120 may map groups of two bits ($b_1$ $b_2$) to 4-ary symbols following the Gray (or natural) mapping given in the following table

| | | Mapping rule | |
|---|---|---|---|
| $b_1$ | $b_2$ | Gray | Natural |
| 0 | 0 | 0 | 0 |
| 0 | 1 | 1 | 1 |
| 1 | 0 | 3 | 2 |
| 1 | 1 | 2 | 3 |

The 4-ary-to-binary transform modules 1113 and 1124 perform vice-versa, i.e., they map a 4-ary number to two bits. The outer code 102, 126 is needed to cleanup remaining bit errors after differential decoding (each phase slip will cause at least one residual bit error after differential decoding). This code may conveniently be an algebraic hard-decision code, for example.

The differential encoder 1109 and differential decoder 1122 shown in Fig. 11 are quaternary differential encoders and decoders. The encoder 1109 may operate according to the input-output relation $v_t = (v_{t-1} + u_t)\%4$, with the "%" operator as introduced above and with the initialization $v_0 = 0$. The input value $u_t$ and the output value $v_t$ are 4-ary numbers.

The differential decoder 1122 can be realized by several means:

- One possible implementation would be to use a binary hard-decision output of the LDPC decoder 970 and then apply a hard-decision differential decoder that reconstructs the original symbol based on $(d_t - d_{t-1})\%4$.
- Another implementation would be to use a soft differential decoder, if the LDPC decoder 970 is able to provide soft-outputs, e.g., estimated bit a posteriori probabilities. In this case, the soft differential decoder may be built using the well-known BCJR algorithm. In this case, the binary to 4-ary conversion module 1120 in front of the differential decoder 1122 may not be necessary, as the BCJR algorithm can inherently compute its state transition probabilities using the binary input log-likelihood ratios.

Note that in practice, phase slips will not exactly occur at boundaries of 2*S* bits (corresponding to *S* symbols), however, the proposed solution can still cope with the generic setting as phase slips that occur within sub-blocks will be treated as additional errors that will be corrected by the code. Note that these additional errors may affect the overall error correction budget of the code.

Let us illustrate the proposed concept by means of an example.

Using the proposed extended quasi-symmetric, quasi-cyclic code construction, we construct a parity-check matrix of dimension 2400x600, i.e., a code of design rate 0.75. As the example code is rank-deficient (the rank of this matrix is 579), the actual rate of the code is 0.76. The parity check matrix of this code, constructed with $S = 30$ is visualized in **Fig. 13.**

Note that exemplary LDPC code constructions according to embodiments may lead to rank-deficient LDPC parity check matrices **H**'. One can see from various examples that there are at least *M'* linearly dependent parity check equations (if we consider the S parity check equations corresponding to one line (row) of $\mathbf{A}_i$, we see that the rank of that sub-matrix is upper bounded by *S*-1). This means that the total or combined parity check matrix **H'** is rank-deficient with rank**(H')** $\leq M'(S-1)$. This in turn means that from the *M'S* parity bits generated by the encoder, *M'* are linearly dependent parity checks. This increase in coding rate may be avoided especially in optical communication systems, which already operate at very high rates close to the theoretical limits.

Some embodiments therefore allow to construct LDPC codes without the described rank deficiency, i.e., with rank**(H')** $\leq M'S$. One possibility to get a full-rank LDPC parity check matrix is to have for instance in each chunk of S rows of **H'** one $S \times S$ sub-matrix which has an even number of additional non-zero entries, such that there are, e.g., 4 ones in this row of the $S \times S$ sub-matrix. Another possibility is to remove in each chunk of *S* rows of **H'** and in one row of one $S \times S$ sub-matrix of said chunk an even number of the non-zero entries. That is to say, regarding a parity check matrix **H'** comprising *M'* chunks of S rows, wherein *M'* denotes a number of rows of an associated lifting matrix $\mathbf{A}_1$ and/or $\mathbf{A}_2$ of the parity check matrix **H',** each chunk of S rows comprises one row with more or less non-void or non-zero entries than the other rows of said chunk, such that the parity check matrix **H'** has full rank. In this case the resulting LDPC code is not quasi-cyclic (QC) anymore, but the quasi-symmetric (QS) property is maintained.

An exemplary LDPC parity check matrix according to the first possibility, i.e., each chunk of S rows comprises one row with more non-zero entries than the other rows of said chunk, is given by

$$\mathbf{H}''=\left(\begin{array}{ccccc|ccccc|ccccc|ccccc|ccccc|ccccc}
&&&& & &&&& & 1&&1&{\large 1}&{\large 1} & 1&&1&{\large 1}&{\large 1} & 1&1&&& & 1&1&&& \\
&&&& & &&&& & &1&&1& & &1&&1& & &1&1&& & &1&1&& \\
&&&& & &&&& & &&1&&1 & &&1&&1 & &&1&1& & &&1&1& \\
&&&& & &&&& & 1&&&1& & 1&&&1& & &&&1&1 & &&&1&1 \\
&&&& & &&&& & &1&&&1 & &1&&&1 & 1&&&&1 & 1&&&&1 \\
\hline
{\large 1}&&1&1&{\large 1} & {\large 1}&&1&1&{\large 1} & &1&&&1 & &1&&&1 & &1&1&& & &1&1&& \\
&&&1&1 & &&&1&1 & 1&&1&& & 1&&1&& & &&1&1& & &&1&1& \\
1&&&&1 & 1&&&&1 & &1&&1& & &1&&1& & &&&1&1 & &&&1&1 \\
1&1&&& & 1&1&&& & &&1&&1 & &&1&&1 & 1&&&&1 & 1&&&&1 \\
&1&1&& & &1&1&& & 1&&&1& & 1&&&1& & 1&1&&& & 1&1&&& \\
\hline
&1&&1& & &1&&1& & &&&& & &&&& & {\large 1}&{\large 1}&1&1& & {\large 1}&{\large 1}&1&1& \\
&&1&&1 & &&1&&1 & &&&& & &&&& & &&&1&1 & &&&1&1 \\
1&&&1& & 1&&&1& & &&&& & &&&& & 1&&&&1 & 1&&&&1 \\
&1&&&1 & &1&&&1 & &&&& & &&&& & 1&1&&& & 1&1&&& \\
1&&1&& & 1&&1&& & &&&& & &&&& & &1&1&& & &1&1&&
\end{array}\right),$$

wherein the added 1s are given in a larger font size. An exemplary parity check matrix according to the second possibility, i.e., each chunk of S rows comprises one row with less non-zero entries than the other rows of said chunk, is given by

$$
\mathbf{H}''' = \left(\begin{array}{ccccc|ccccc|ccccc|ccccc|ccccc|ccccc}
&&&&&&&&&&&&&&&&&&&&1&&1&&&1&&1&& \\
&&&&&&&&&&&1&&1&&&1&&1&&&1&&1&&&1&&1& \\
&&&&&&&&&&&&1&&1&&&1&&1&&&1&&1&&&1&&1 \\
&&&&&&&&&&1&&&1&&1&&&1&&1&&&1&&1&&&1& \\
&&&&&&&&&&&1&&&1&&1&&&1&&1&&&1&&1&&&1 \\
\hline
&&&&&&&&&&&1&&&1&&1&&&1&&1&&&1&&1&&&1 \\
&&&1&1&&&&1&1&1&&1&&&1&&1&&&1&&1&&&1&&1&& \\
1&&&&1&1&&&&1&&1&&1&&&1&&1&&&1&&1&&&1&&1& \\
1&1&&&&1&1&&&&&&1&&1&&&1&&1&&&1&&1&&&1&&1 \\
&1&1&&&&1&1&&&1&&&1&&1&&&1&&1&&&1&&1&&&1& \\
\hline
&1&&1&&&1&&1&&&&&&&&&&&&&&&&&&&&& \\
&&1&&1&&&1&&1&&&&&&&&&&&&&&1&1&&&&1&1 \\
1&&&1&&1&&&1&&&&&&&&&&&&1&&&&1&1&&&&1 \\
&1&&&1&&1&&&1&&&&&&&&&&&1&1&&&&1&1&&& \\
1&&1&&&1&&1&&&&&&&&&&&&&&1&1&&&&1&1&
\end{array}\right).
$$

Of course corresponding LDPC decoding platforms need to be adapted accordingly if one of these modifications is implemented.

Using the example code of Fig. 13, we deliberately introduce a phase slip of 90° at (symbol) position 250 (bit position 500) and another phase slip of -90° at (symbol) position 750 (bit position 1500). In **Fig. 14a,** we display the difference between the original transmitted codeword and the decoder output for a large SNR of 40dB. It seems that the decoder output is totally corrupted with a long error burst. If we now carry out proper de-interleaving followed by differential decoding, we get the result illustrated in **Fig. 14b** (after removing parity bits). We see that the two phase slips are now translated into single bit errors by the decoder 950 which will be removed by the outer decoder 126.

If we decrease the SNR ($E_S/N_0$) to 3.3dB, we may expect additional transmission errors that potentially cannot be corrected by the decoder. It can be clearly seen that this is the case in **Fig. 15a,** where we observe that there are some residual errors before and after the phase slips. Of course, these errors also translate into bit errors after differential decoding as can be seen in **Fig. 15b.**

From the previous figures we may also notice an important property of the proposed concept. As the first phase slip occurring at position 250 does not occur exactly at the boundary of a sub-block, it leads to additional errors. In the first example with very high SNR, these additional errors were corrected by the code and we only observed two errors after differential decoding. In the low-SNR case, this is not possible anymore and will thus lead to a burst-like error around position 500, as can be seen in Fig. 15b.

This immediately provides some hints for dimensioning the outer code, which should be able to cope with burst errors. Codes that are perfectly suited for burst errors are Reed-Solomon codes, which may preferably be used as outer coding scheme or at least as component of the outer coding scheme.

The proposed concept is not restricted to the use of QPSK modulation, but can in principle be applied to any modulation format that has a phase ambiguity of 90°, for instance the popular 16-QAM format or other formats such as, e.g., 32-QAM, 64-QAM, or star-8-QAM. In such cases, if $V$ bits are mapped to one modulation symbol (e.g., $V$=4 for 16-QAM), then $V$-2 bits may be mapped to the symbols in one quadrant of the complex plane using a rotationally invariant mapping and the remaining two bits may be differentially encoded. This is shown for the example of the 16-QAM constellation in **Fig.** 16, where a symbol's first two Most Significant Bits (MSBs) - which denote the quadrant - may be differentially encoded and the Least Significant Bits (LSBs) may be rotationally invariantly mapped. In this case we may introduce partial slip transparent codes, e.g., constructed using the partial extended quasi-symmetric quasi-cyclic construction described above, where the above conditions apply only for a fraction 2/$V$ of the variable nodes, i.e., of the columns of the parity-check matrix **H.**

An example code for $V$=3 (e.g., star 8-QAM) may be based on the following parity check matrix:

$$\mathbf{A}_1 = \begin{pmatrix} -1 & -1 & 0 & 0 & 0 & 3 \\ 2 & 2 & 1 & 1 & 1 & 2 \\ 1 & 1 & -1 & -1 & 2 & 1 \end{pmatrix}$$
$$\mathbf{A}_2 = \begin{pmatrix} -1 & -1 & 4 & 4 & -1 & -1 \\ 3 & 3 & 2 & 2 & -1 & -1 \\ 3 & 3 & -1 & -1 & -1 & -1 \end{pmatrix} \rightarrow$$

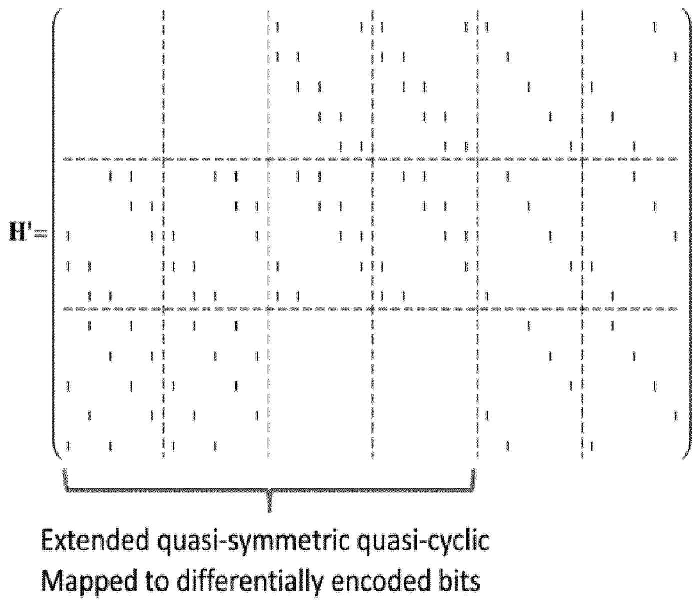


Here, first parity check matrix $\mathbf{H}_1$ may be constructed from a first $M' \times N'$ lifting matrix $\mathbf{A}_1$ by replacing each entry of the first lifting matrix with either an all-zero matrix of size $SxS$ or a permutation matrix of size $S \times S$, depending on the entry of the first lifting matrix $\mathbf{A}_1$. A second parity check matrix $\mathbf{H}_2$ may be constructed from a second $M' \times N'$ lifting matrix $\mathbf{A_2}$ by replacing each entry of the second lifting matrix with either an all-zero matrix of size $SxS$ or a permutation matrix of size $S \times S$, depending on the entry of the second lifting matrix.

In other words, embodiments also comprise code designs defined by an $M'S \times N'S$ parity check matrix **H'** comprising a first fraction of $S \times S$ permutation or circulant sub-matrices with an even number of non-zero entries in each row of a sub-matrix and comprising a second fraction of $S \times S$ permutation sub-matrices with an odd number of non-zero entries in each row of a sub-matrix, wherein the first fraction of permutation or circulant $S \times S$ sub-matrices may form a first contiguous fraction of the $N'S$ columns **of H'** corresponding to a fraction of bits (of a multiple bit symbol) to be protected against phase slips by the LPDC code, and wherein the second fraction of sub-matrices forms a second fraction (e.g., the rest) of the $N'S$ columns corresponding to a second fraction (e.g., the rest) of bits of the multiple bit symbol. Thereby the second fraction may be obtained by subtracting the first fraction from one. Note that the fraction of the columns need not be contiguous but can be arranged in an arbitrary manner, if the interleaver is properly designed. However, by column rearrangement (and consequently re-design of the interleaver), the matrix can always be brought into a form where the columns are contiguous. For the first fraction of permutation or circulant $S \times S$ sub-matrices corresponding entries $A_{1m,i}$ of the $m$-th row and the $i$-th column of the first lifting matrix $\mathbf{A}_1$ correspond to entries $A_{2,m,i}$ of the $m$-th row and the $i$-th column of the second lifting matrix $A_2$, if the entry $A_{1,m,i}$ is $x$, wherein x denotes a predetermined value of the first lifting matrix leading to zero entries in the corresponding first and second parity check matrices (here: $x = -1$). For entries corresponding to the first fraction of permutation or circulant $S \times S$ sub-matrices the following conditions hold:

$$A_{1,m,i} \neq A_{2,m,i} \text{ , if } A_{1,m,i} \neq x.$$

Further,

$$A_{1,m,2i-1} = A_{1,m,2i} \text{ and } A_{2,m,2i-1} = A_{2,m,2i}.$$

Hence, the latter constraints hold for those $m$, $i$ of the lifting matrices that are associated with input bits of differentially encoded quaternary symbols. In the illustrated example of star 8-QAM, only the first two of three bits correspond to a respective differentially encoded quaternary symbol.

This then allows performing the outer differential encoding 1109 and decoding 1122 only on, e.g., two thirds of the data, limiting the error rate at the input of the outer code 102, 126. The according block diagram is shown in **Fig. 17.**

According to the system setup shown in Fig. 17 the outer encoded data is de-multiplexed or parallelized by de-multiplexer 1702 to obtain a plurality of parallel bits (e.g., three in the 8-QAM case) per symbol. Two bits to be especially protected against phase slips may binary-to-quaternary converted, differentially encoded by differential encoder 1109, and quaternary-to-binary converted before non-differentially-encoded and differentially encoded bits are multiplexed or serialized again by multiplexer 1704 in such a way that the bits to be protected against phase slips are mapped to those columns of the parity check matrix that correspond to the first fraction of permutation or circulant *SxS* sub-matrices with an even number of non-zero entries in each row of a sub-matrix and the additional constraints. The resulting data stream is then fed to encoder 900 according to an embodiment, which operates according to a systematic LDPC encoding rule that is defined by or based on an $M'S \times N'S$ parity check matrix **H'** comprising a plurality of permutation or circulant *SxS* sub-matrices with an even number of non-zero entries in each row of an *SxS* sub-matrix, wherein the plurality of permutation or circulant *SxS* sub-matrices forms a fraction of the *N'S* columns corresponding to the fraction of differentially encoded bits (of a multiple bit symbol) to be especially protected against phase slips by the LPDC code.

The receiver side of the communication system 1700 carries out the respective inverse operations, i.e., demapping 1118, LDPC decoding 950, de-multiplexing 1702, differential decoding 1122, multiplexing 1704, and outer decoding 126. That is to say, the LDPC decoder module 970 may operate according to an LDPC decoding rule defined by or based on an $M'S \times N'S$ parity check matrix **H'** comprising a plurality of permutation or circulant *SxS* sub-matrices with an even number of non-zero entries in each row of an *SxS* sub-matrix, wherein the plurality of permutation or circulant *SxS* sub-matrices forms a contiguous fraction (e.g., 2/3) of the *N'S* columns corresponding to the fraction of differentially encoded bits (of a multiple bit symbol) to be especially protected against phase slips by the LPDC code. Here, contiguous means that the columns comprised by the fraction or portion are contiguously adjacent.

In **Fig. 18,** we show an example system that may include iterations between the LDPC decoder 970 and the demapper 1118. The feedback path from LDPC decoder 970 to demapper 1118 includes a further de-interleaver module 930 operating according to inverse interleaver rule $\pi'^{-1}$. This feedback of soft-information can be beneficial if a higher order modulation format is used that is not square and for which a Gray mapping does not exist (e.g., 8-QAM). Note that such an iterative feedback increases however the complexity again.

Iterations and feedbacks between other decoder components can be included as well. For instance between the differential decoder 1122, e.g. realized using the BCJR algorithm, and the LDPC decoder 970, as shown in **Fig. 19.** Here, the LDPC decoder module 970 is configured to provide the LDPC decoded signal with soft-decisions. The differential decoding rule of the differential decoder module 1122 is a soft decision decoding rule. According to the embodiment of Fig. 18, the differential decoder module 1122 comprises an output coupled to the LDPC decoder module 970 to transfer extrinsic information back to the LDPC decoder module 970 for a subsequent decoding iteration. The feedback path from differential decoder module 1122 to LDPC decoder module 970 includes a further interleaver module 910 operating according to interleaver rule $\pi$.

As shown in **Fig. 20,** iterations and feedbacks can be inserted between all three relevant receiver components. The feedback path from LDPC decoder 970 to demapper 1118 includes a further de-interleaver module 930 operating according to inverse interleaver rule $\pi'^{-1}$. The feedback path from differential decoder module 1122 to LDPC decoder module 970 includes a further interleaver module 910 operating according to interleaver rule$\pi$.

In the present disclosure a low-complexity coding scheme has been proposed that can tolerate sporadic phase slip events in the transmission channel. This concept is based on a novel LDPC code design technique. Large gains compared with a conventional differentially LDPC coded modulation scheme can be observed without increasing the complexity.

The description and drawings merely illustrate the principles of embodiments the invention. It will thus be appreciated that those skilled in the art will be able to devise various arrangements that, although not explicitly described or shown herein, embody the principles of example embodiments. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

It should be appreciated by those skilled in the art that any block diagrams herein represent conceptual views of illustrative hardware or circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

Further, it is to be understood that the disclosure of multiple acts or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

## Claims

**1.** An encoder (900), comprising:

an interleaver module (910) having an input (911) for a binary signal and an output (912) for an interleaved signal, wherein a pair of bits of the binary signal corresponds to a quaternary symbol,
wherein the interleaver module (910) is configured to interleave an input block of $K$ consecutive bits of the binary signal according to a first interleaver rule, the first interleaver rule re-arranging the K consecutive bits of the input block to an interleaved signal block of $K$ consecutive interleaved bits comprising at least a first sub-block of S consecutive bits corresponding odd bit positions in the input block and at least an adjacent second sub-block of S consecutive bits corresponding even bit positions in the input block;
an LDPC encoder module (920) having an input (921) for the interleaved signal block and an output (922) for an LDPC encoded signal block,
wherein the LDPC encoder module (920) is configured to provide the LDPC encoded signal based on a combination of the interleaved signal block with a parity check matrix of a systematic LDPC code of rate $K/N$, wherein the parity check matrix comprises $M'$ rows of $N'$ binary-valued sub-matrices of size $SxS$, wherein a first sub-matrix corresponding to an odd sub-matrix position in a row of sub-matrices equals an adjacent second sub-matrix corresponding to an even sub-matrix position in the row of sub-matrices; and
a de-interleaver module (930) having an input (931) for the LDPC encoded signal block and an output (932) for a de-interleaved signal, and configured to de-interleave the LDPC encoded signal block of $n$ consecutive bits in accordance with a second interleaver rule of a corresponding second interleaver, the second interleaver rule re-arranging $N$ consecutive bits of an input signal block to an interleaved signal block of $N$ consecutive interleaved bits comprising at least a first sub-block of S consecutive bits corresponding to odd bit positions in the input signal block and at least a second sub-block of S consecutive bits corresponding to even bit positions in the input signal block.

**2.** The encoder (900) of claim 1, further comprising:

a mapping module (108) having an input for the de-interleaved signal and an output to a communications channel (114),
wherein the mapping module (108) is configured to map a number of bits of the de-interleaved signal to a modulation symbol of an at least quaternary symbol alphabet.

**3.** The encoder (900) of claim 1, further comprising:

a first conversion module (1105) having an input for a binary signal and an output for a quaternary signal,
wherein the first conversion module (1105) is configured to convert a pair of bits of the binary signal to a quaternary symbol of the quaternary signal;
a differential encoder module (1109) having an input for the quaternary signal and an output for a differentially encoded quaternary signal,
wherein the differential encoder module (1109) is configured to provide the differentially encoded quaternary signal based on the quaternary signal and a differential encoding rule; and
a second conversion module (1113) having an input for the differentially encoded quaternary signal and an output for a binary signal,
wherein the second conversion module (1113) is configured to convert a quaternary symbol of the differentially encoded quaternary signal to a pair of bits of the binary signal,
wherein the second conversion module's output is coupled to the interleaver module's input.

**4.** The encoder (900) of claim 3, wherein the differential encoder module (1109) is configured to provide a sample $v_t$ of the differentially encoded quaternary signal at time index $t$ based on

$$v_t = (v_{t-1} + u_t)\%4,$$

wherein $u_t$ denotes a quaternary input signal at time index $t$ and wherein ($u\%v$) returns the remainder of $u$ divided by $v$.

**5.** The encoder (900) of claim 1, wherein the parity check matrix is based on an addition of an even number of parity check matrices corresponding to different quasicyclic LDPC codes, respectively.

**6.** The encoder (900) of claim 5, wherein a first parity check matrix of the even number of parity check matrices is constructed from a first $M' \times N'$ lifting matrix by replacing each entry of the first lifting matrix with either an all-zero matrix of size $SxS$ or a permutation matrix of size $S \times S$, depending on the entry of the first lifting matrix,
wherein a second parity check matrix of the even number of parity check matrices is constructed from a second $M' \times N'$ lifting matrix by replacing each entry of the second lifting matrix with either an all-zero matrix of size $SxS$ or a permutation matrix of size $S \times S$, depending on the entry of the second lifting matrix,
wherein an entry $A_{1,m,i}$ of the $m$-th row and the $i$-th column of the first lifting matrix corresponds to an entry $A_{2,m,i}$ of the $m$-th row and the $i$-th column of the second lifting matrix, if the entry $A_{1,m,i}$ is x, wherein $x$ denotes a predetermined value of the first lifting matrix leading to zero entries in the corresponding first and second parity check matrices,
wherein an entry $A_{2,m,i} \neq A_{2,m,i}$, if $A_{1,m,i} \neq x$, and $A_{2,m,i} \neq x$, and
wherein $A_{1,m,2i-1} = A_{1,m,2i}$ and $A_{2,m,2i-1} = A_{2,m,2i}$.

**7.** The encoder (900) of claim 1, wherein the interleaver (910) module is configured to re-arrange an $i$-th bit $x_i$ of the input block to obtain a bit $y_j$ of the interleaved signal block according to

$$y_{\left\lfloor \frac{i-1}{2S} \right\rfloor 2S + \frac{(i-1)\%(2S)}{2} + 1} = x_i \quad \text{if } i \text{ odd}$$

$$y_{\left\lfloor \frac{i-1}{2S} \right\rfloor 2S + \frac{(i-2)\%(2S)}{2} + S + 1} = x_i \quad \text{if } i \text{ even},$$

wherein $\lfloor u \rfloor$ denotes the largest integer smaller or equal than $u$ and ($u\%v$) returns the remainder of $u$ divided by $v$.

**8.** The encoder (900) of claim 1, wherein the de-interleaver module (930) is configured to re-arrange an $i$-th bit $y_i$ of the input block to obtain a bit $x_i$ of the de-interleaved signed block according to

$$x_i = y_{\left\lfloor \frac{i-1}{2S} \right\rfloor 2S + \frac{(i-1)\%(2S)}{2} + 1} \quad \text{if } i \text{ odd}$$

$$x_i = y_{\left\lfloor \frac{i-1}{2S} \right\rfloor 2S + \frac{(i-2)\%(2S)}{2} + S + 1} \quad \text{if } i \text{ even}$$

**9.** A method for encoding, comprising:

interleaving an input block of $k$ consecutive bits of a binary signal according to a first interleaver rule, wherein a pair of bits of the binary signal corresponds to a quaternary symbol, and wherein the first interleaver rule re-arranges the $K$ consecutive bits of the input block to an interleaved signal block of $K$ consecutive interleaved bits comprising at least a first sub-block of $S$ consecutive bits corresponding odd bit positions in the input block and at least an adjacent second sub-block of $S$ consecutive bits corresponding even bit positions in the input block;
providing an LDPC encoded signal block based on a combination of the interleaved signal block with a parity check matrix of a systematic LDPC code of rate *K*/*N*, wherein the parity check matrix comprises *M'* rows of *N'* binary-valued sub-matrices of size *SxS*, wherein at least a first sub-matrix corresponding to an odd sub-matrix position in a row of sub-matrices equals an adjacent second sub-matrix corresponding to an even sub-matrix position in the row of sub-matrices; and
de-interleaving the LDPC encoded signal block of *N* consecutive bits in accordance with a second interleaver rule of a corresponding second interleaver, the second interleaver rule re-arranging *N* consecutive bits of an input signal block to an interleaved signal block of *N* consecutive interleaved bits comprising at least a first sub-block of *S* consecutive bits corresponding odd bit positions in the input signal block and at least a second sub-block of *S* consecutive bits corresponding even bit positions in the input signal block.

**10.** A decoder (950), comprising:

an interleaver module (960) having an input for a received signal and an output for an interleaved signal, wherein a pair of samples of the received signal corresponds to a potential quaternary symbol, and wherein the interleaver module is configured to interleave an input block of *N* consecutive samples of the received signal according to a first interleaver rule, the first interleaver rule re-arranging the *N* consecutive samples of the input block to an interleaved signal block of *N* consecutive interleaved samples comprising at least a first sub-block of *S* consecutive samples corresponding odd sample positions in the input block and at least an adjacent second sub-block of *S* consecutive samples corresponding even sample positions in the input block;
an LDPC decoder module (970) having an input for the interleaved signal block and an output for an LDPC decoded signal block, and configured to provide the LDPC decoded signal block based on a combination of the interleaved signal block with a parity check matrix of a systematic LDPC code of rate *K*/*N*, wherein the parity check matrix comprises *M'* rows of *N'* binary-valued sub-matrices of size $S \times S$, wherein a first sub-matrix corresponding to an odd sub-matrix position in a row of sub-matrices equals an adjacent second sub-matrix corresponding to an even sub-matrix position in the row of sub-matrices; and
a de-interleaver module (980) having an input for the LDPC decoded signal block and an output for a de-interleaved signal, and configured to de-interleave the LDPC decoded signal block of *K* consecutive samples in accordance with a second interleaver rule of a corresponding second interleaver, the second interleaver rule re-arranging an input signal block of *K* consecutive input samples to a de-interleaved signal block of *N* consecutive de-interleaved samples comprising at least a first sub-block of *S* consecutive samples corresponding odd bit positions in the input signal block and at least a second sub-block of S consecutive samples corresponding even bit positions in the input signal block.

**11.** The decoder (950) of claim 10, further comprising:

a de-mapping module (1118) having an input for a received modulated signal and an output for a demodulated signal, and configured to map a received modulated signal sample to a number of demodulated signal samples based on a mapping rule between a number of bits and a modulation symbol of an at least quaternary symbol alphabet,
wherein the de-mapping module's output is coupled to the interleaver module's input.

**12.** The decoder (950) of claim 10, further comprising:

a differential decoder module (1122) having an input for a quaternary signal and an output for a differentially decoded quaternary signal, and configured to provide the differentially decoded quaternary signal based on the quaternary signal and a differential decoding rule, wherein the differential decoder module's input is coupled to the de-interleaver module's output; and
a conversion module (1124) having an input for the differentially decoded quaternary signal and an output for a binary signal and configured to convert a quaternary symbol of the differentially decoded quaternary signal to a pair of bits of the binary signal.

**13.** The decoder (950) of claim 12, wherein the LDPC decoder module (970) is configured to provide the LDPC decoded signal with soft-decisions and wherein the differential decoding rule of the differential decoder module (1122) is a soft decision decoding rule.

**14.** The decoder (950) of claim 13, wherein the differential decoder module (1122) comprises an output coupled to the LDPC decoder module (970) to transfer extrinsic information back to the LDPC decoder module (970) for a subsequent decoding iteration.

**15.** The decoder (950) of claim 12, wherein the LDPC decoder module (970) is configured to provide the LDPC decoded signal with binary hard-decisions, the decoder further comprising:

a further conversion module (1120) having an input for a binary input signal and an output for a quaternary signal, and configured to convert a pair of bits of the binary input signal to a quaternary symbol of the quaternary signal,
wherein the further conversion module's input is coupled to the de-interleaver module's output.

**16.** The decoder (950) of claim 15, wherein the differential decoder module (1122) is configured to provide a differentially decoded quaternary signal $d_t$ at time index *t* based on

$$d_t = (y_t - y_{t-1})\%4,$$

wherein ($u\%v$) returns the remainder of *u* divided by *v.*

**17.** A method for decoding, comprising:

interleaving an input block of *n* consecutive samples of a received signal according to a first interleaver rule, the first interleaver rule re-arranging the *N* consecutive samples of the input block to an interleaved signal block of *N* consecutive interleaved samples comprising at least a first sub-block of *S* consecutive samples corresponding odd sample positions in the input block and at least an adjacent second sub-block of *S* consecutive samples corresponding even sample positions in the input block;
providing a block of a LDPC decoded signal based on a combination of the interleaved signal block with a parity check matrix of a systematic LDPC code of rate *K*/*N,* wherein the parity check matrix comprises *M'* rows of *N'* binary-valued sub-matrices of size *SxS,* wherein a first sub-matrix corresponding to an odd sub-matrix position in a row of sub-matrices equals an adjacent second sub-matrix corresponding to an even sub-matrix position in the row of sub-matrices; and
de-interleaving the LDPC decoded signal block of *K* consecutive samples in accordance with a second interleaver rule of a corresponding second interleaver, the second interleaver rule re-arranging an input signal block of *K* consecutive input samples to a de-interleaved signal block of *K* consecutive de-interleaved samples comprising at least a first sub-block of *S* consecutive samples corresponding odd bit positions in the input signal block and at least a second sub-block of *S* consecutive samples corresponding even bit positions in the input signal block.

**Amended claims in accordance with Rule 137(2) EPC.**

**1.** An encoder (900), comprising:

an interleaver module (910) having an input (911) for a binary signal and an output (912) for an interleaved signal, wherein a pair of bits of the binary signal corresponds to a quaternary symbol,
wherein the interleaver module (910) is configured to interleave an input block of *K* consecutive bits of the binary signal according to a first interleaver rule, the first interleaver rule re-arranging the *K* consecutive bits of the input block to an interleaved signal block of *K* consecutive interleaved bits comprising at least a first sub-block of *S* consecutive bits corresponding odd bit positions in the input block and at least an adjacent second sub-block of *S* consecutive bits corresponding even bit positions in the input block;
an LDPC encoder module (920) having an input (921) for the interleaved signal block and an output (922) for an LDPC encoded signal block,
wherein the LDPC encoder module (920) is configured to provide the LDPC encoded signal based on a combination of the interleaved signal block with a parity check matrix of a systematic LDPC code of rate *K*/*N*, wherein the parity check matrix comprises *M'* rows of *N'* binary-valued sub-matrices of size $S \times S$, wherein, in each row of sub-matrices, a first sub-matrix corresponding to an odd sub-matrix position in a row of sub-matrices equals an adjacent second sub-matrix corresponding to an even sub-matrix position in the row of sub-matrices; and
a de-interleaver module (930) having an input (931) for the LDPC encoded signal block and an output (932) for a de-interleaved signal, and configured to de-interleave the LDPC encoded signal block of *n* consecutive bits in accordance with a second interleaver rule of a corresponding second interleaver, the second interleaver rule re-arranging *N* consecutive bits of an input signal block to an interleaved signal block of *N* consecutive interleaved bits comprising at least a first sub-block of $S$ consecutive bits corresponding to odd bit positions in the input signal block and at least a second sub-block of $S$ consecutive bits corresponding to even bit positions in the input signal block.

**2.** The encoder (900) of claim 1, further comprising:

a mapping module (108) having an input for the de-interleaved signal and an output to a communications channel (114),
wherein the mapping module (108) is configured to map a number of bits of the de-interleaved signal to a modulation symbol of an at least quaternary symbol alphabet.

**3.** The encoder (900) of claim 1, further comprising:

a first conversion module (1105) having an input for a binary signal and an output for a quaternary signal,
wherein the first conversion module (1105) is configured to convert a pair of bits of the binary signal to a quaternary symbol of the quaternary signal;
a differential encoder module (1109) having an input for the quaternary signal and an output for a differentially encoded quaternary signal,
wherein the differential encoder module (1109) is configured to provide the differentially encoded quaternary signal based on the quaternary signal and a differential encoding rule; and
a second conversion module (1113) having an input for the differentially encoded quaternary signal and an output for a binary signal,
wherein the second conversion module (1113) is configured to convert a quaternary symbol of the differentially encoded quaternary signal to a pair of bits of the binary signal,
wherein the second conversion module's output is coupled to the interleaver module's input.

**4.** The encoder (900) of claim 3, wherein the differential encoder module (1109) is configured to provide a sample $v_t$ of the differentially encoded quaternary signal at time index $t$ based on
$v_t = (v_{t-1} + u_t)\%4$,
wherein $u_t$ denotes a quaternary input signal at time index $t$ and wherein $(u\%v)$ returns the remainder of $u$ divided by $v$.

**5.** The encoder (900) of claim 1, wherein the parity check matrix is based on an addition of an even number of parity check matrices corresponding to different quasi-cyclic LDPC codes, respectively.

**6.** The encoder (900) of claim 5, wherein a first parity check matrix of the even number of parity check matrices is constructed from a first $M' \times N'$ lifting matrix by replacing each entry of the first lifting matrix with either an all-zero matrix of size $S \times S$ or a permutation matrix of size $S \times S$, depending on the entry of the first lifting matrix,
wherein a second parity check matrix of the even number of parity check matrices is constructed from a second $M' \times N'$ lifting matrix by replacing each entry of the second lifting matrix with either an all-zero matrix of size $S \times S$ or a permutation matrix of size $S \times S$, depending on the entry of the second lifting matrix,
wherein an entry $A_{1,m,i}$ of the $m$-th row and the $i$-th column of the first lifting matrix corresponds to an entry $A_{2,m,i}$ of the $m$-th row and the $i$-th column of the second lifting matrix, if the entry $A_{1,m,i}$ is $x$, wherein $x$ denotes a predetermined value of the first lifting matrix leading to zero entries in the corresponding first and second parity check matrices,
wherein an entry $A_{1,m,i} \neq A_{2,m,i}$, if $A_{1,m,i} \neq x$, and $A_{2,m,i} \neq x$, and
wherein $A_{1,m,2i-1} = A_{1,m,2i}$ and $A_{2,m,2i-1} = A_{2,m,2i}$.

**7.** The encoder (900) of claim 1, wherein the interleaver (910) module is configured to re-arrange an $i$-th bit $x_i$ of the input block to obtain a bit $y_j$ of the interleaved signal block according to $y_{\lfloor \frac{i-1}{2S} \rfloor 2S + \frac{(i-1)\%(2S)}{2} + 1} = x_i$ if $i$ odd $y_{\lfloor \frac{i-1}{2S} \rfloor 2S + \frac{(i-2)\%(2S)}{2} + S + 1} = x_i$ if $i$ even,
wherein $\lfloor u \rfloor$ denotes the largest integer smaller or equal than $u$ and $(u\%v)$ returns the remainder of $u$ divided by v.

**8.** The encoder (900) of claim 1, wherein the de-interleaver module (930) is configured to re-arrange an $i$-th bit $y_i$ of the input block to obtain a bit $x_i$ of the de-interleaved signed block according to

$$x_i = y_{\lfloor \frac{i-1}{2S} \rfloor 2S + \frac{(i-1)\%(2S)}{2} + 1}$$

if *i* odd

$$x_i = y_{\lfloor \frac{i-1}{2S} \rfloor 2S + \frac{(i-2)\%(2S)}{2} + S + 1}$$

if *i* even

**9.** A method for encoding, comprising:

interleaving an input block of *k* consecutive bits of a binary signal according to a first interleaver rule, wherein a pair of bits of the binary signal corresponds to a quaternary symbol, and wherein the first interleaver rule re-arranges the *K* consecutive bits of the input block to an interleaved signal block of *K* consecutive interleaved bits comprising at least a first sub-block of *S* consecutive bits corresponding odd bit positions in the input block and at least an adjacent second sub-block of *S* consecutive bits corresponding even bit positions in the input block;
providing an LDPC encoded signal block based on a combination of the interleaved signal block with a parity check matrix of a systematic LDPC code of rate *K*/*N*, wherein the parity check matrix comprises *M'* rows of *N'* binary-valued sub-matrices of size $S \times S$, wherein, in each row of sub-matrices, at least a first sub-matrix corresponding to an odd sub-matrix position in a row of sub-matrices equals an adjacent second sub-matrix corresponding to an even sub-matrix position in the row of sub-matrices; and
de-interleaving the LDPC encoded signal block of *N* consecutive bits in accordance with a second interleaver rule of a corresponding second interleaver, the second interleaver rule re-arranging *N* consecutive bits of an input signal block to an interleaved signal block of *N* consecutive interleaved bits comprising at least a first sub-block of *S* consecutive bits corresponding odd bit positions in the input signal block and at least a second sub-block of *S* consecutive bits corresponding even bit positions in the input signal block.

**10.** A decoder (950), comprising:

an interleaver module (960) having an input for a received signal and an output for an interleaved signal, wherein a pair of samples of the received signal corresponds to a potential quaternary symbol, and wherein the interleaver module is configured to interleave an input block of *N* consecutive samples of the received signal according to a first interleaver rule, the first interleaver rule re-arranging the *N* consecutive samples of the input block to an interleaved signal block of *N* consecutive interleaved samples comprising at least a first sub-block of *S* consecutive samples corresponding odd sample positions in the input block and at least an adjacent second sub-block of *S* consecutive samples corresponding even sample positions in the input block;
an LDPC decoder module (970) having an input for the interleaved signal block and an output for an LDPC decoded signal block, and configured to provide the LDPC decoded signal block based on a combination of the interleaved signal block with a parity check matrix of a systematic LDPC code of rate *K*/*N*, wherein the parity check matrix comprises *M'* rows of *N'* binary-valued sub-matrices of size $S \times S$, wherein, in each row of sub-matrices, a first sub-matrix corresponding to an odd sub-matrix position in a row of sub-matrices equals an adjacent second sub-matrix corresponding to an even sub-matrix position in the row of sub-matrices; and
a de-interleaver module (980) having an input for the LDPC decoded signal block and an output for a de-interleaved signal, and configured to de-interleave the LDPC decoded signal block of *K* consecutive samples in accordance with a second interleaver rule of a corresponding second interleaver, the second interleaver rule re-arranging an input signal block of *K* consecutive input samples to a de-interleaved signal block of *N* consecutive de-interleaved samples comprising at least a first sub-block of *S* consecutive samples corresponding odd bit positions in the input signal block and at least a second sub-block of *S* consecutive samples corresponding even bit positions in the input signal block.

**11.** The decoder (950) of claim 10, further comprising:

a de-mapping module (1118) having an input for a received modulated signal and an output for a demodulated signal, and configured to map a received modulated signal sample to a number of demodulated signal samples based on a mapping rule between a number of bits and a modulation symbol of an at least quaternary symbol alphabet,
wherein the de-mapping module's output is coupled to the interleaver module's input.

**12.** The decoder (950) of claim 10, further comprising:

a differential decoder module (1122) having an input for a quaternary signal and an output for a differentially decoded quaternary signal, and configured to provide the differentially decoded quaternary signal based on the quaternary signal and a differential decoding rule, wherein the differential decoder module's input is coupled to the de-interleaver module's output; and
a conversion module (1124) having an input for the differentially decoded quaternary signal and an output for a binary signal and configured to convert a quaternary symbol of the differentially decoded quaternary signal to a pair of bits of the binary signal.

**13.** The decoder (950) of claim 12, wherein the LDPC decoder module (970) is configured to provide the LDPC decoded signal with soft-decisions and wherein the differential decoding rule of the differential decoder module (1122) is a soft decision decoding rule.

**14.** The decoder (950) of claim 13, wherein the differential decoder module (1122) comprises an output coupled to the LDPC decoder module (970) to transfer extrinsic information back to the LDPC decoder module (970) for a subsequent decoding iteration.

**15.** The decoder (950) of claim 12, wherein the LDPC decoder module (970) is configured to provide the LDPC decoded signal with binary hard-decisions, the decoder further comprising:

a further conversion module (1120) having an input for a binary input signal and an output for a quaternary signal, and configured to convert a pair of bits of the binary input signal to a quaternary symbol of the quaternary signal,
wherein the further conversion module's input is coupled to the de-interleaver module's output.

**16.** The decoder (950) of claim 15, wherein the differential decoder module (1122) is configured to provide a differentially decoded quaternary signal $d_t$ at time index $t$ based on
$d_t = (y_t - y_{t-1})\%4$,
wherein ($u$%v) returns the remainder of $u$ divided by $v$.

**17.** A method for decoding, comprising:

interleaving an input block of $n$ consecutive samples of a received signal according to a first interleaver rule, the first interleaver rule re-arranging the $N$ consecutive samples of the input block to an interleaved signal block of $N$ consecutive interleaved samples comprising at least a first sub-block of $S$ consecutive samples corresponding odd sample positions in the input block and at least an adjacent second sub-block of $S$ consecutive samples corresponding even sample positions in the input block;
providing a block of a LDPC decoded signal based on a combination of the interleaved signal block with a parity check matrix of a systematic LDPC code of rate $K/N$, wherein the parity check matrix comprises $M'$ rows of $N'$ binary-valued sub-matrices of size $S \times S$, wherein, in each row of sub-matrices, a first sub-matrix corresponding to an odd sub-matrix position in a row of sub-matrices equals an adjacent second sub-matrix corresponding to an even sub-matrix position in the row of sub-matrices; and
de-interleaving the LDPC decoded signal block of $K$ consecutive samples in accordance with a second interleaver rule of a corresponding second interleaver, the second interleaver rule re-arranging an input signal block of $K$ consecutive input samples to a de-interleaved signal block of $K$ consecutive de-interleaved samples comprising at least a first sub-block of $S$ consecutive samples corresponding odd bit positions in the input signal block and at least a second sub-block of $S$ consecutive samples corresponding even bit positions in the input signal block.

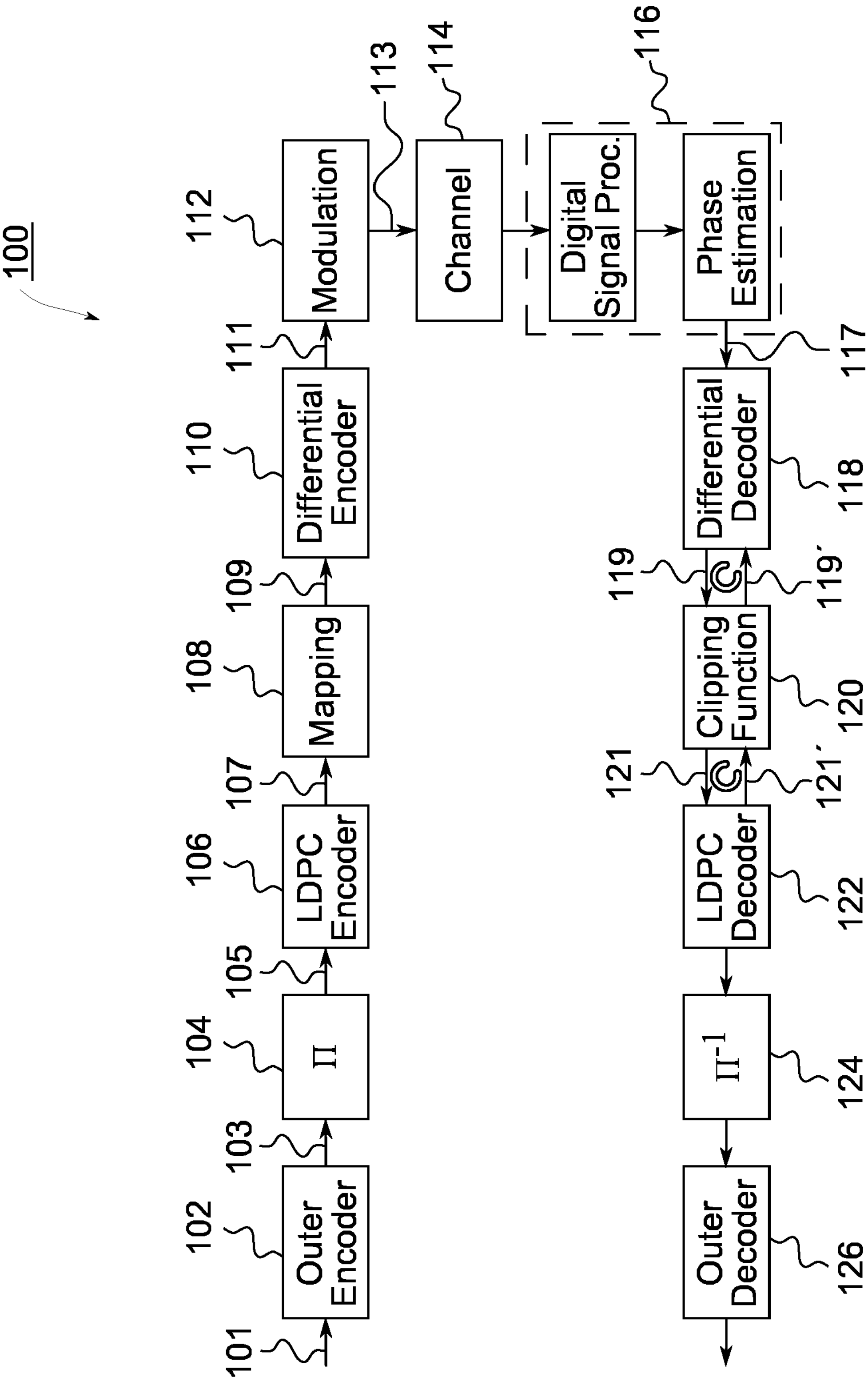
100
101
Outer Encoder
102
103
Π
104
105
LDPC Encoder
106
107
Mapping
108
109
Differential Encoder
110
111
Modulation
112
113
Channel
114
Digital Signal Proc.
Phase Estimation
116
117
Differential Decoder
118
119
119´
Clipping Function
120
121
121´
LDPC Decoder
122
Π-1
124
Outer Decoder
126

Fig. 1

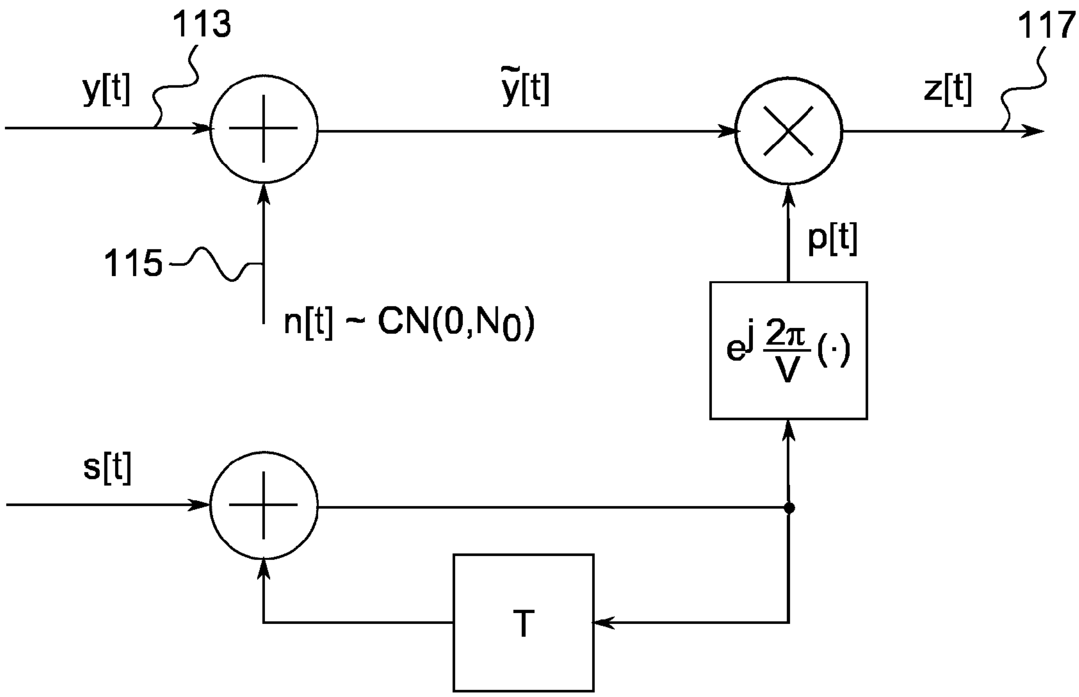
113
117
y[t]
ỹ[t]
z[t]
115
n[t] ~ CN(0,N0)
p[t]
e^{j 2π/V (·)}
s[t]
T

Fig. 2a

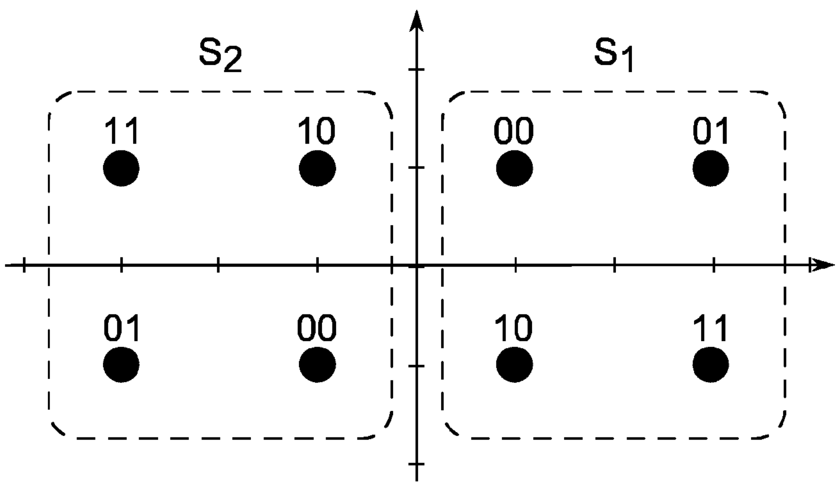
S2
S1
11
10
00
01
01
00
10
11

Fig. 2b

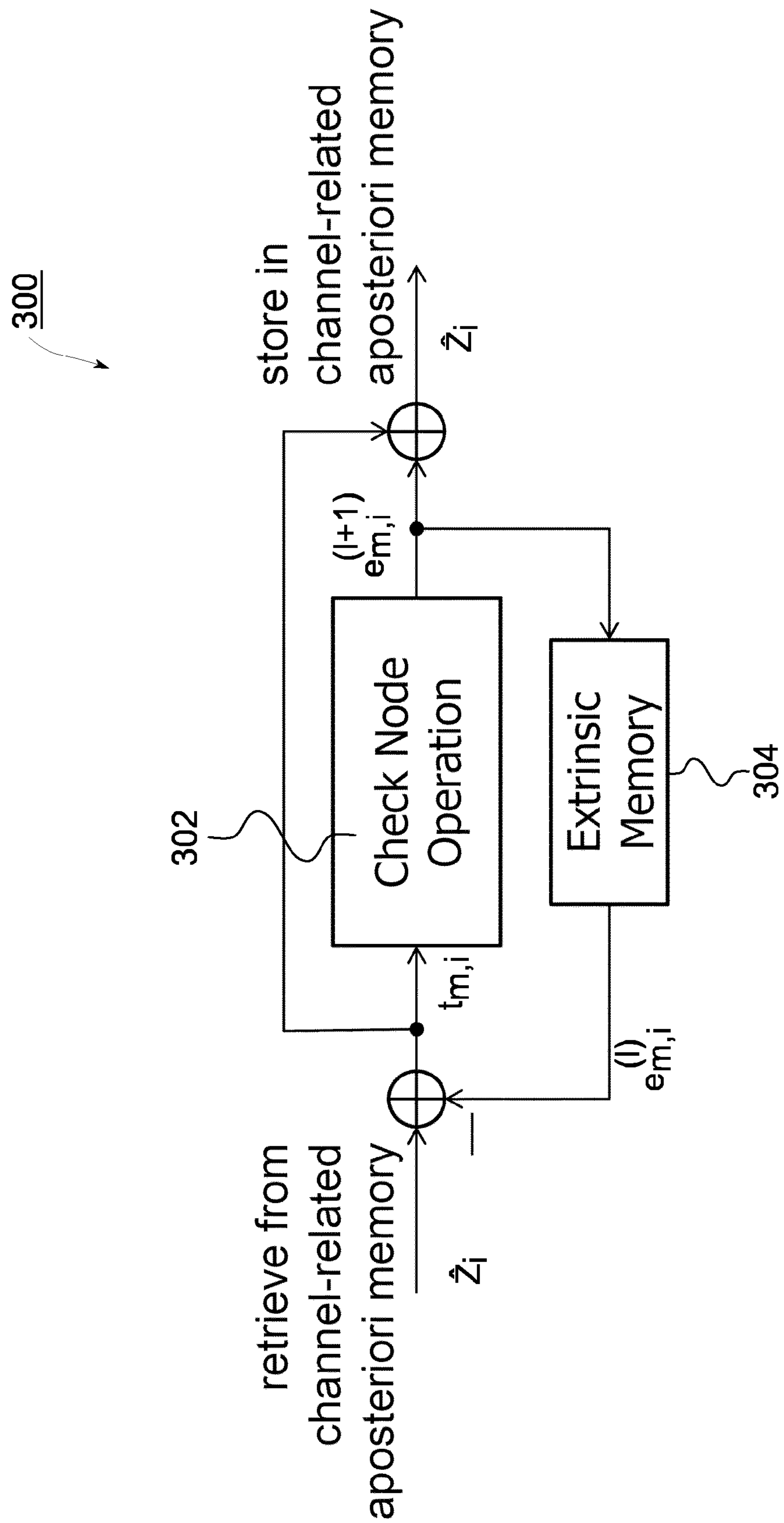
300
store in
channel-related
aposteriori memory
$\hat{z}_i$
$e_{m,i}^{(l+1)}$
Check Node
Operation
302
Extrinsic
Memory
304
$t_{m,i}$
$e_{m,i}^{(l)}$
—
retrieve from
channel-related
aposteriori memory
$\hat{z}_i$

Fig. 3

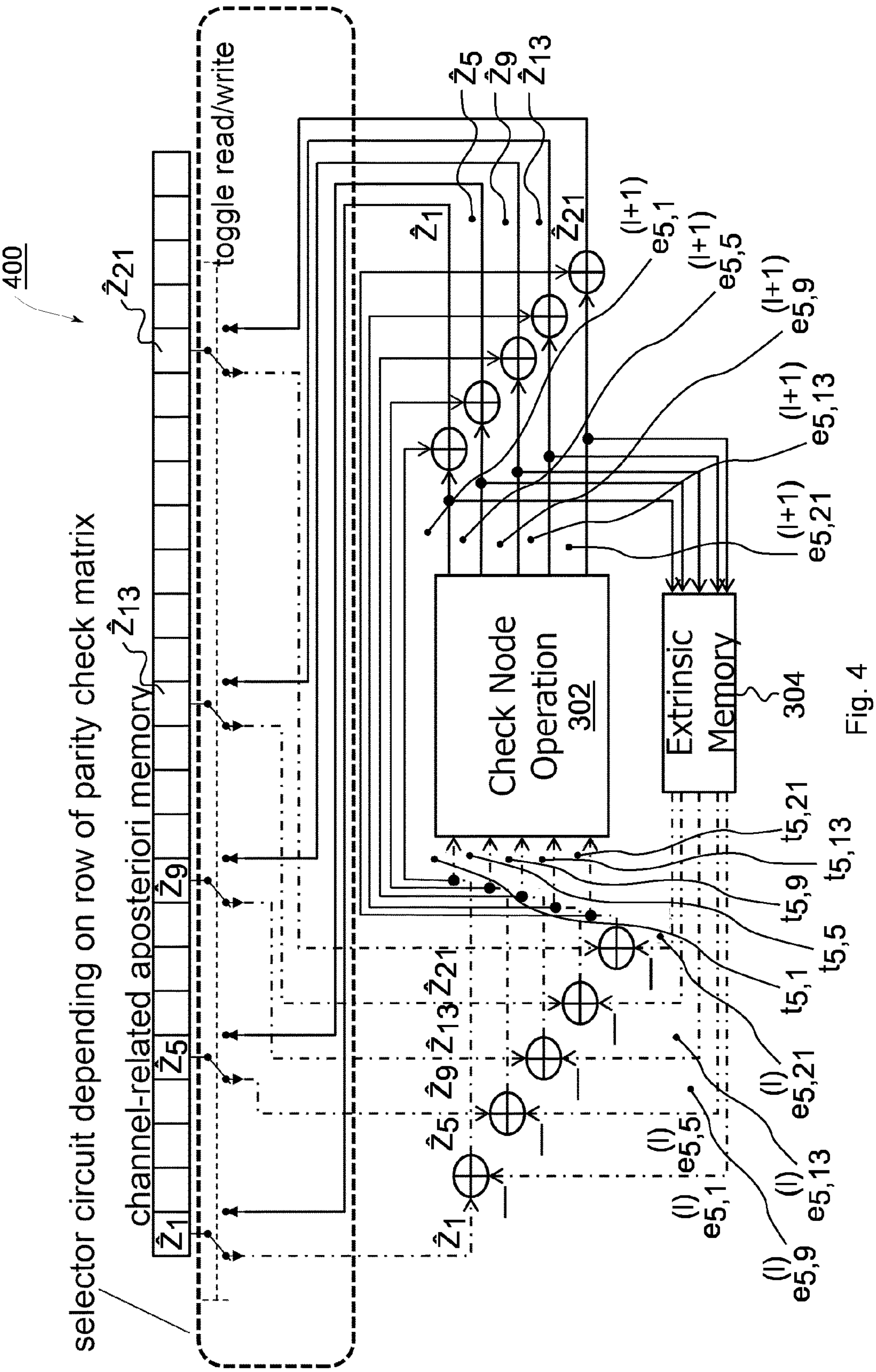
400
selector circuit depending on row of parity check matrix
channel-related aposteriori memory
toggle read/write
$\hat{z}_1$
$\hat{z}_5$
$\hat{z}_9$
$\hat{z}_{13}$
$\hat{z}_{21}$
Check Node Operation 302
Extrinsic Memory
304
$e_{5,1}^{(l)}$
$e_{5,5}^{(l)}$
$e_{5,9}^{(l)}$
$e_{5,13}^{(l)}$
$e_{5,21}^{(l)}$
$e_{5,1}^{(l+1)}$
$e_{5,5}^{(l+1)}$
$e_{5,9}^{(l+1)}$
$e_{5,13}^{(l+1)}$
$e_{5,21}^{(l+1)}$
$t_{5,1}$
$t_{5,5}$
$t_{5,9}$
$t_{5,13}$
$t_{5,21}$

Fig. 4

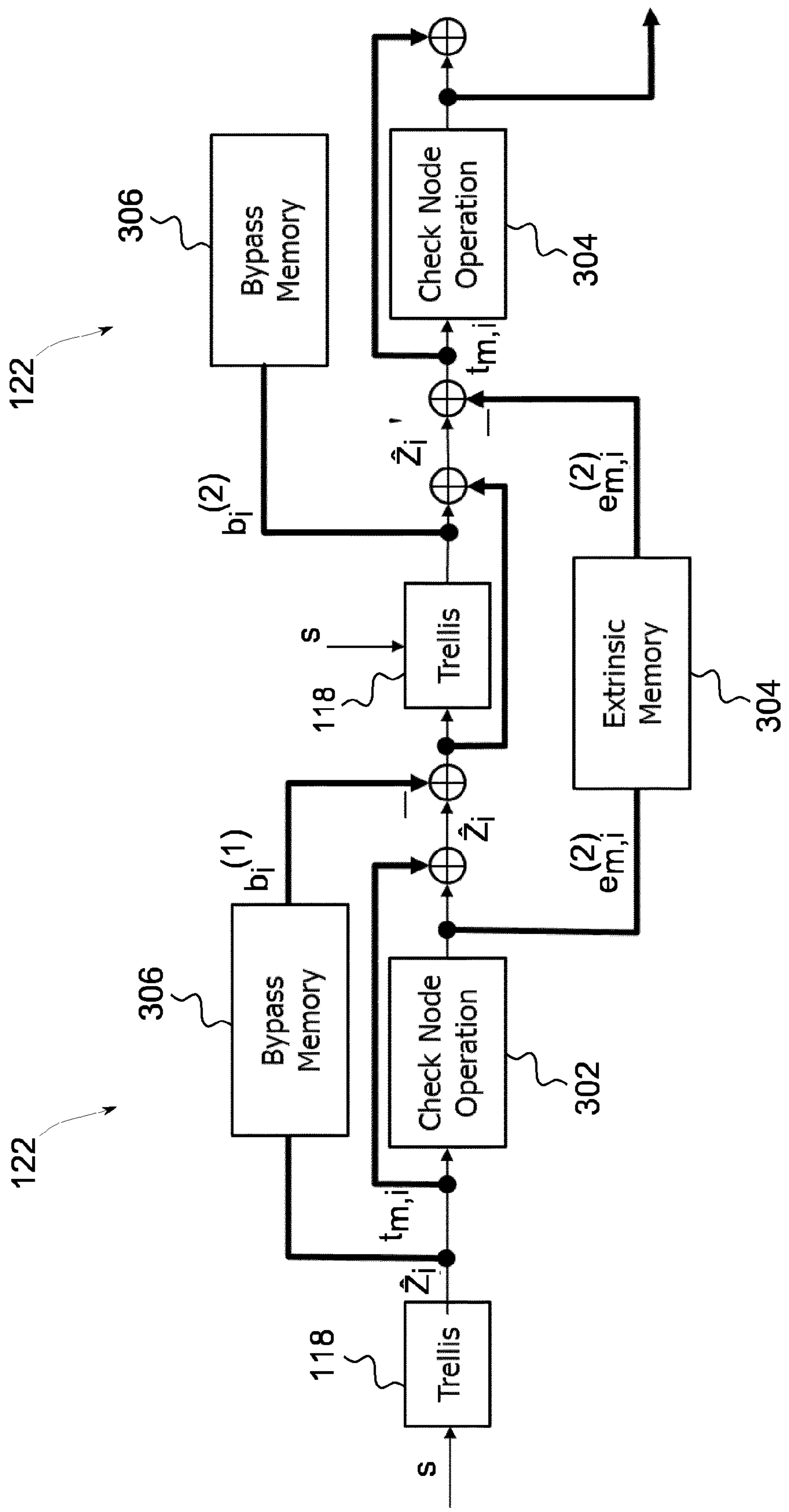
122
122
306
306
Bypass Memory
Bypass Memory
Check Node Operation
Check Node Operation
302
304
304
Extrinsic Memory
118
118
Trellis
Trellis
s
s

Fig. 5

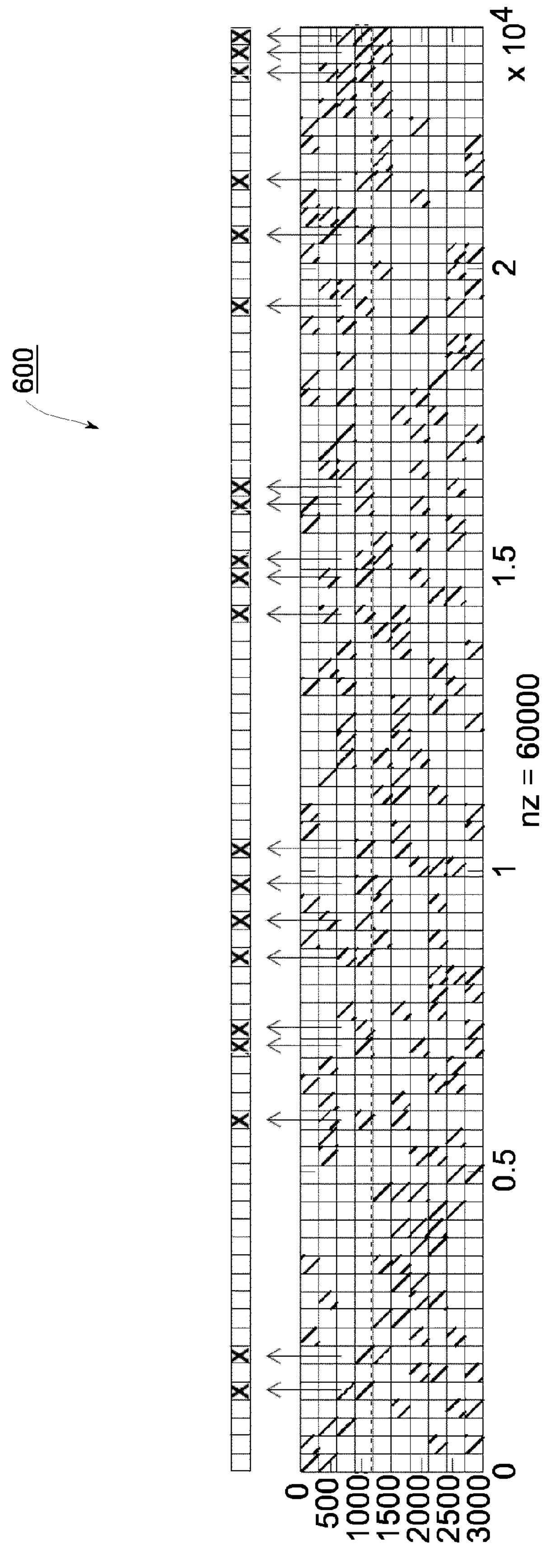


Fig. 6

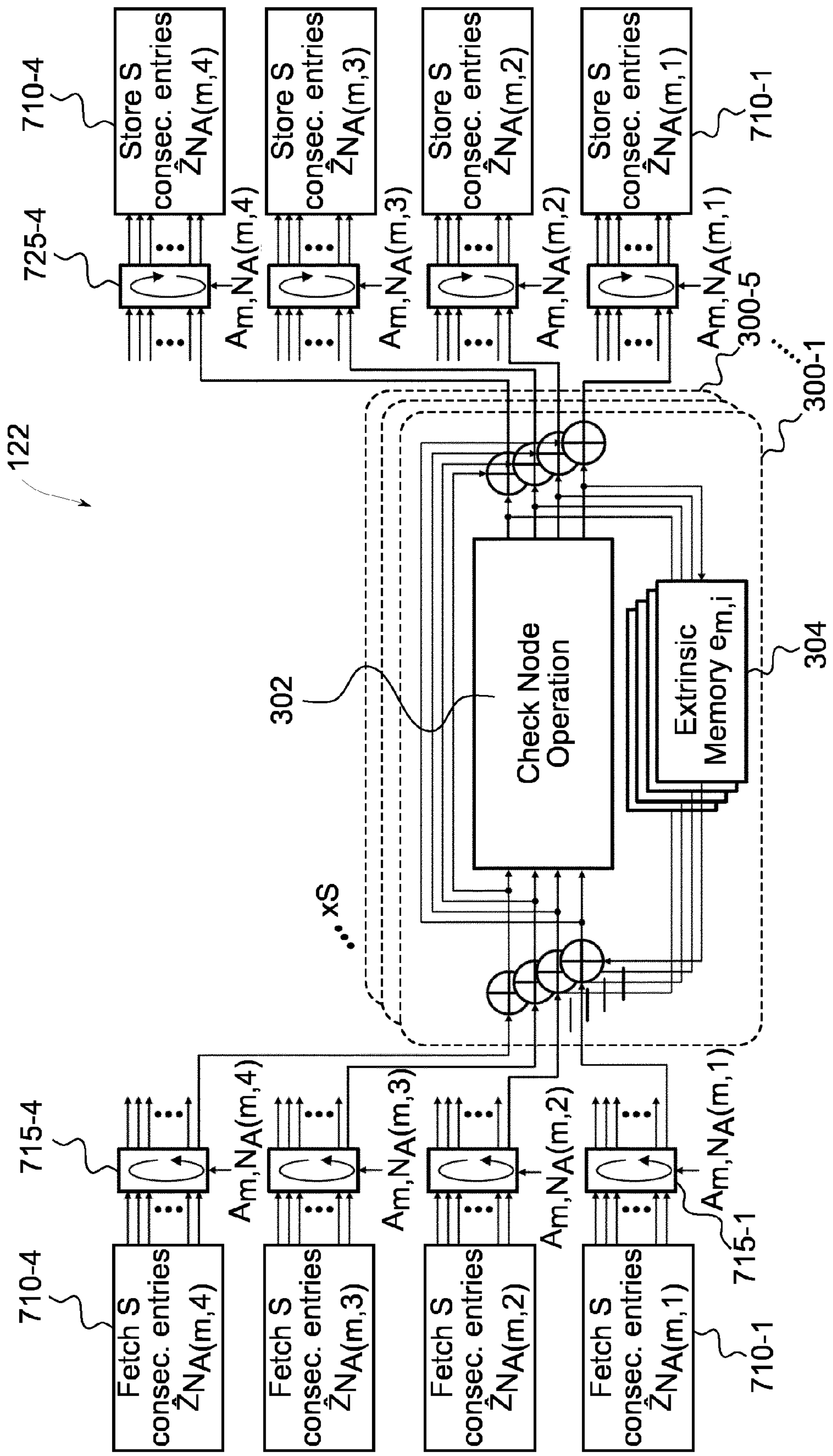
122
710-4
Store S consec. entries $\hat{Z}_{N_A(m,4)}$
Store S consec. entries $\hat{Z}_{N_A(m,3)}$
Store S consec. entries $\hat{Z}_{N_A(m,2)}$
Store S consec. entries $\hat{Z}_{N_A(m,1)}$
710-1
725-4
$A_{m,N_A(m,4)}$
$A_{m,N_A(m,3)}$
$A_{m,N_A(m,2)}$
$A_{m,N_A(m,1)}$
300-5
300-1
302
Check Node Operation
Extrinsic Memory $e_{m,i}$
304
xS
715-4
715-1
710-4
Fetch S consec. entries $\hat{Z}_{N_A(m,4)}$
Fetch S consec. entries $\hat{Z}_{N_A(m,3)}$
Fetch S consec. entries $\hat{Z}_{N_A(m,2)}$
Fetch S consec. entries $\hat{Z}_{N_A(m,1)}$
710-1

Fig. 7

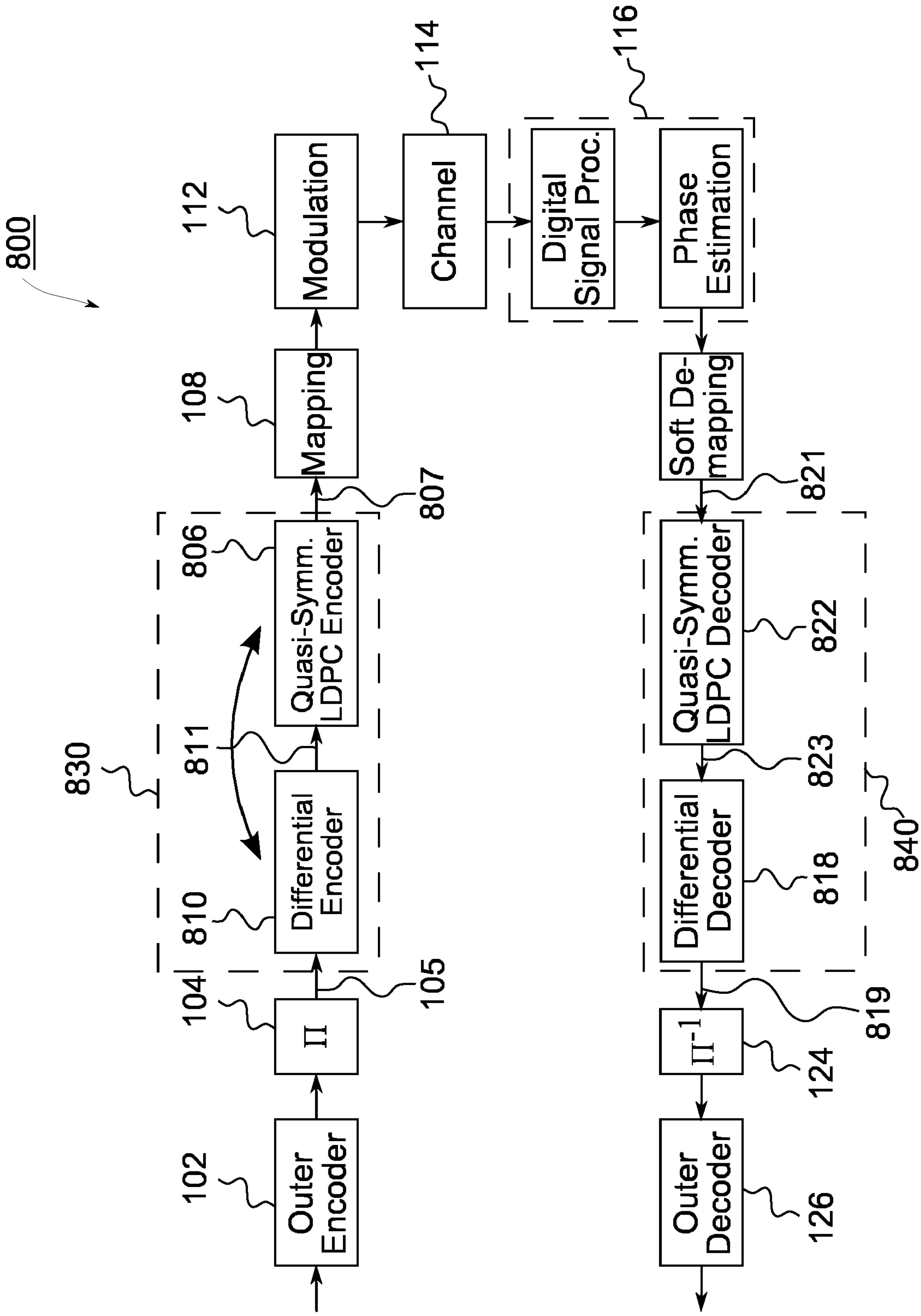
800
Outer Encoder
102
Π
104
105
Differential Encoder
810
811
Quasi-Symm. LDPC Encoder
806
830
807
Mapping
108
Modulation
112
Channel
114
Digital Signal Proc.
Phase Estimation
116
Soft De-mapping
821
Quasi-Symm. LDPC Decoder
822
823
Differential Decoder
818
840
819
Π-1
124
Outer Decoder
126

Fig. 8

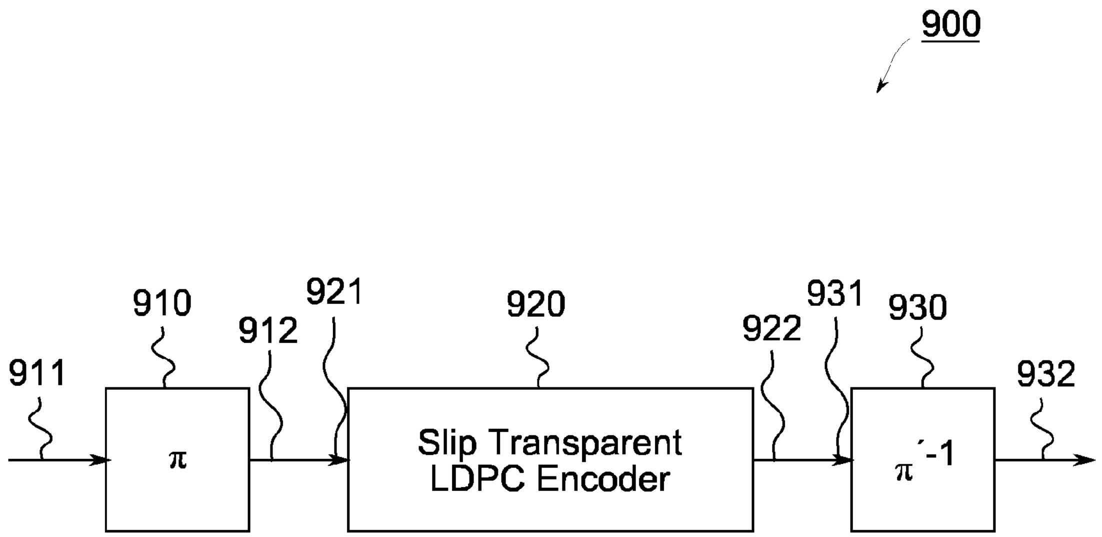
900
910
921
920
931
930
912
922
911
932
π
Slip Transparent
LDPC Encoder
π´-1

Fig. 9a

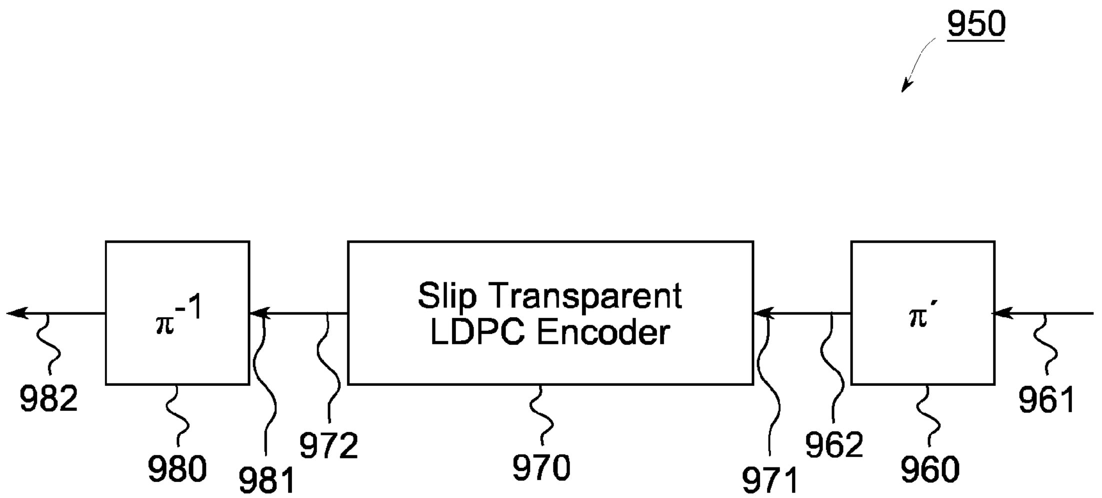
950
π-1
Slip Transparent
LDPC Encoder
π´
982
961
980
972
970
962
960
981
971

Fig. 9b

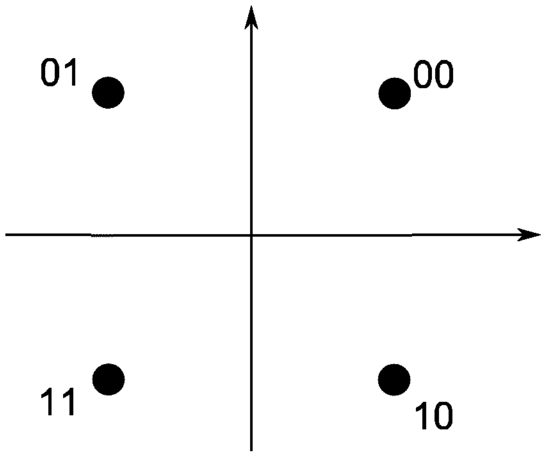


Fig. 10a

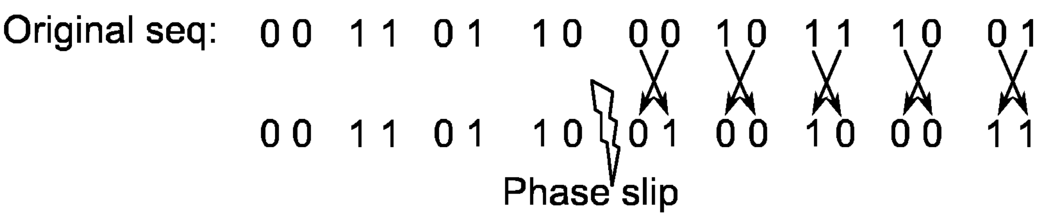


Fig. 10b

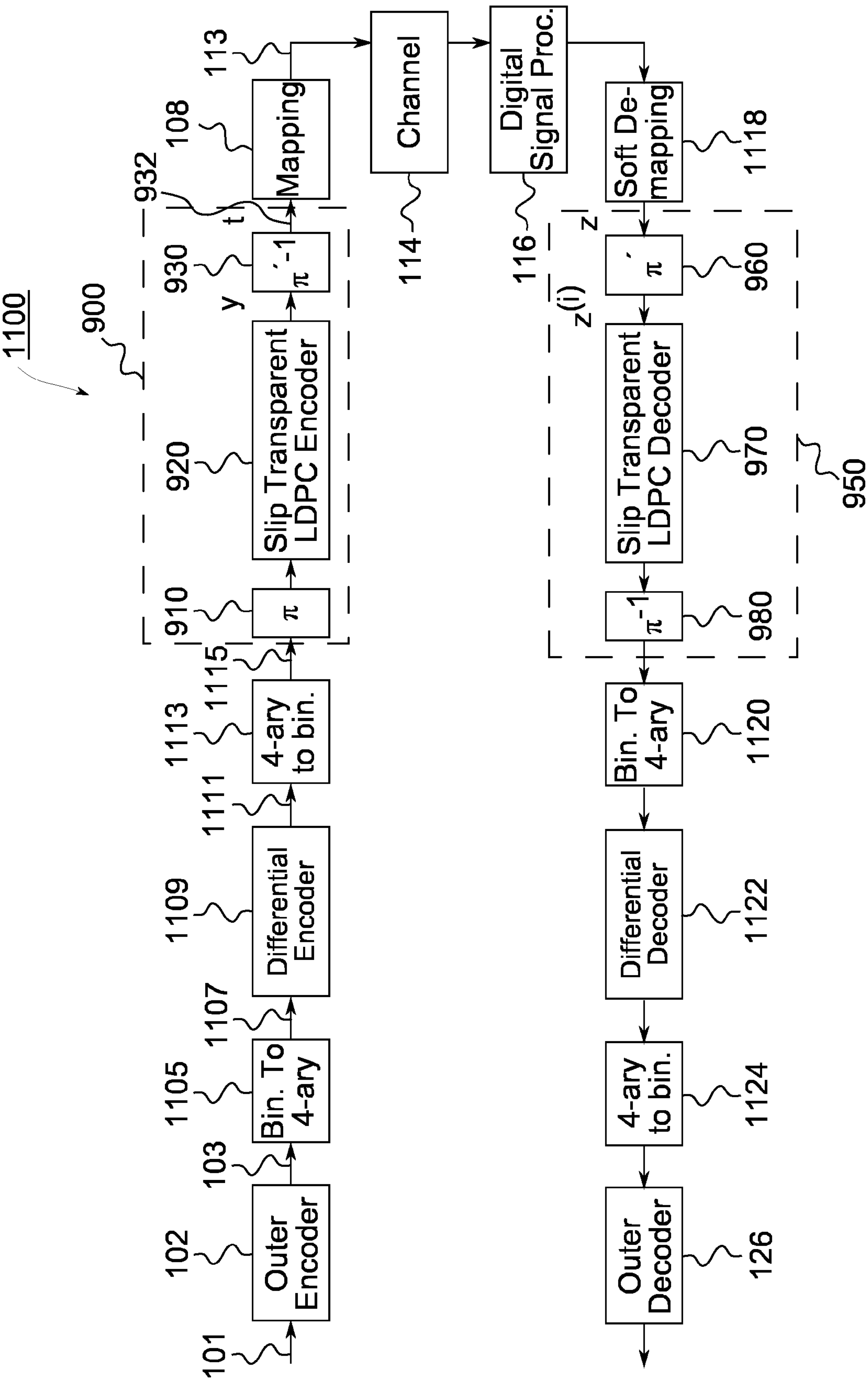
1100
900
Outer Encoder
Bin. To 4-ary
Differential Encoder
4-ary to bin.
Slip Transparent LDPC Encoder
Mapping
Channel
Digital Signal Proc.
Soft De-mapping
Slip Transparent LDPC Decoder
Bin. To 4-ary
Differential Decoder
4-ary to bin.
Outer Decoder
950

Fig. 11

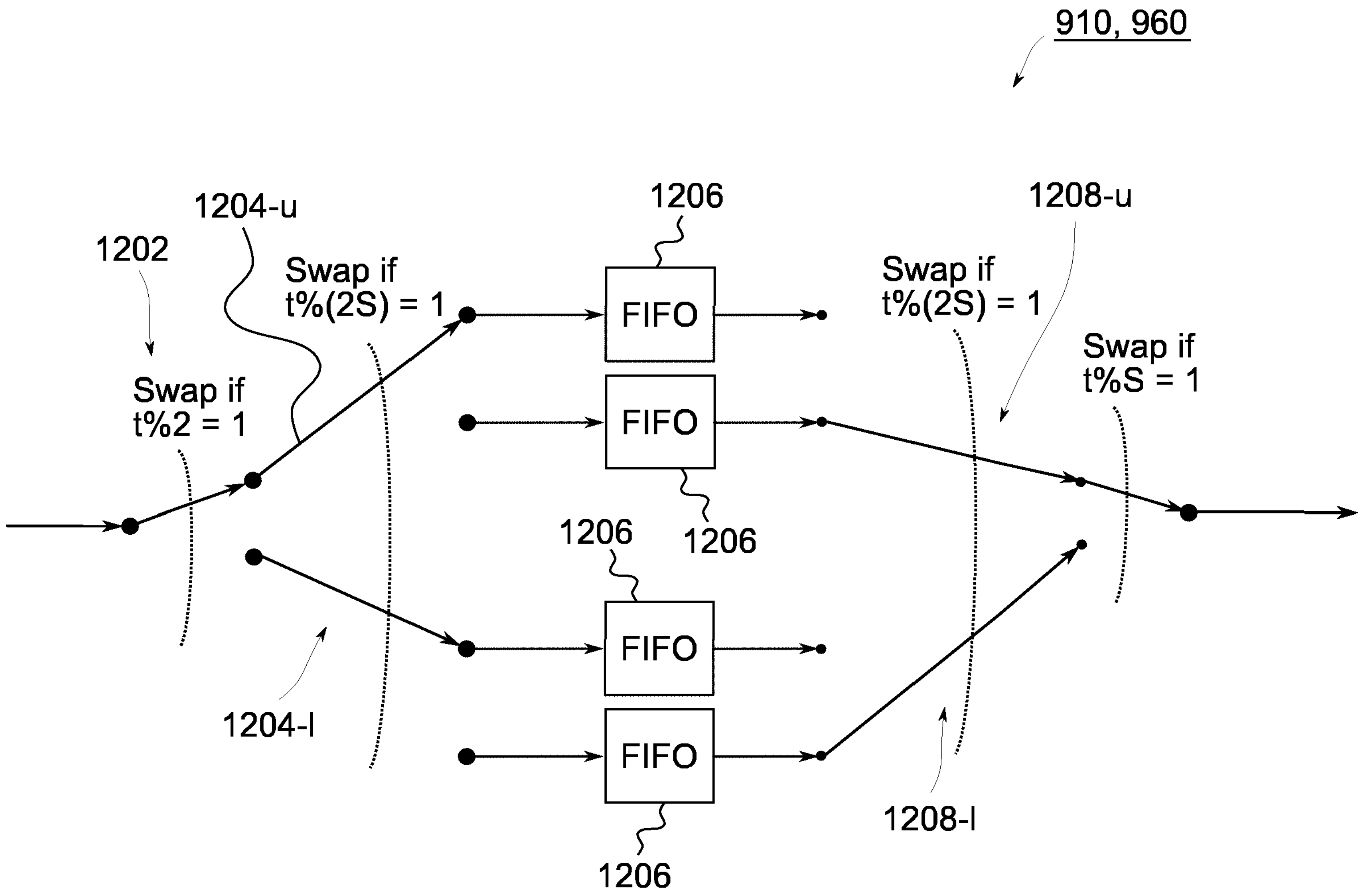
910, 960
1202
1204-u
1204-l
Swap if
t%2 = 1
Swap if
t%(2S) = 1
1206
FIFO
FIFO
1206
1206
FIFO
FIFO
1206
Swap if
t%(2S) = 1
1208-u
1208-l
Swap if
t%S = 1

Fig. 12

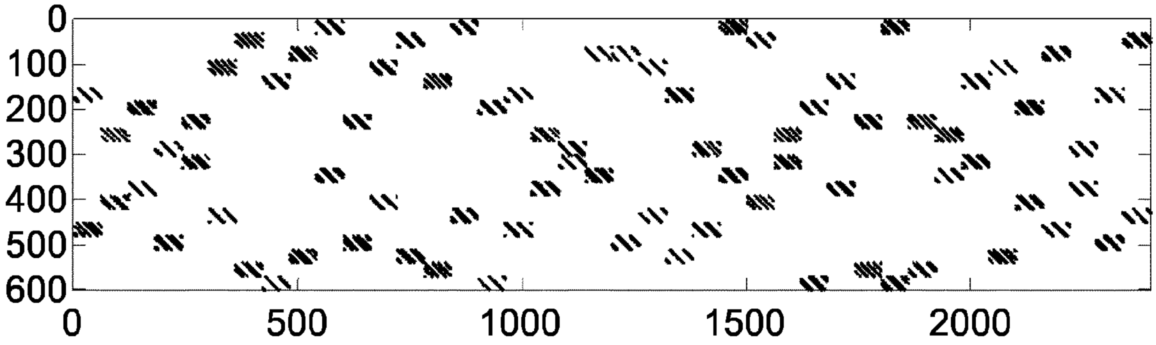


Fig. 13

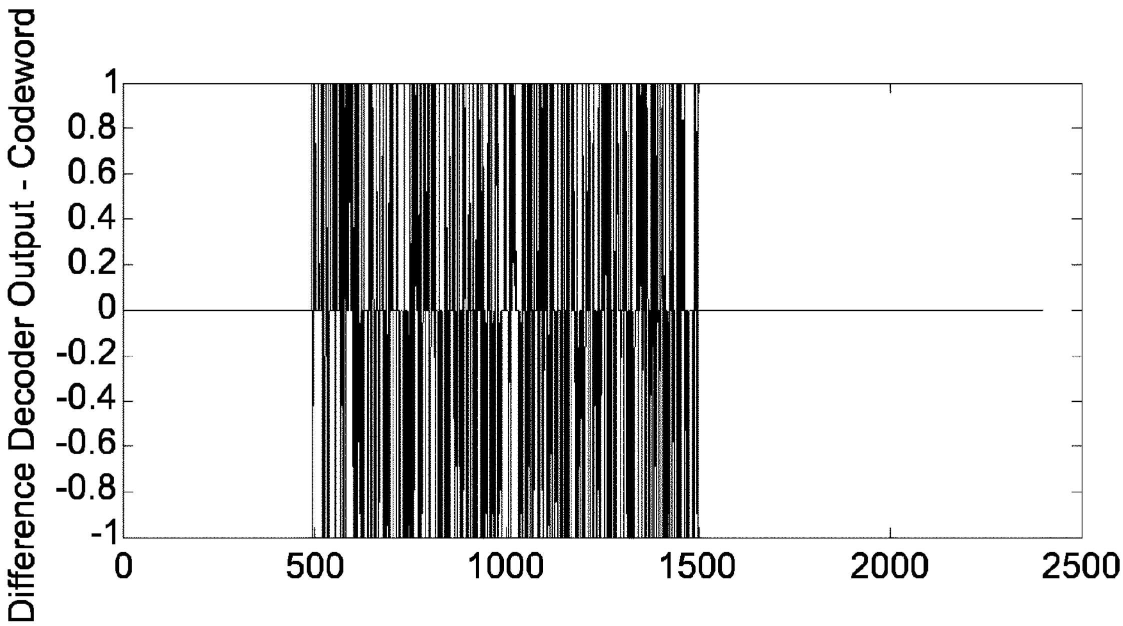


Fig. 14a

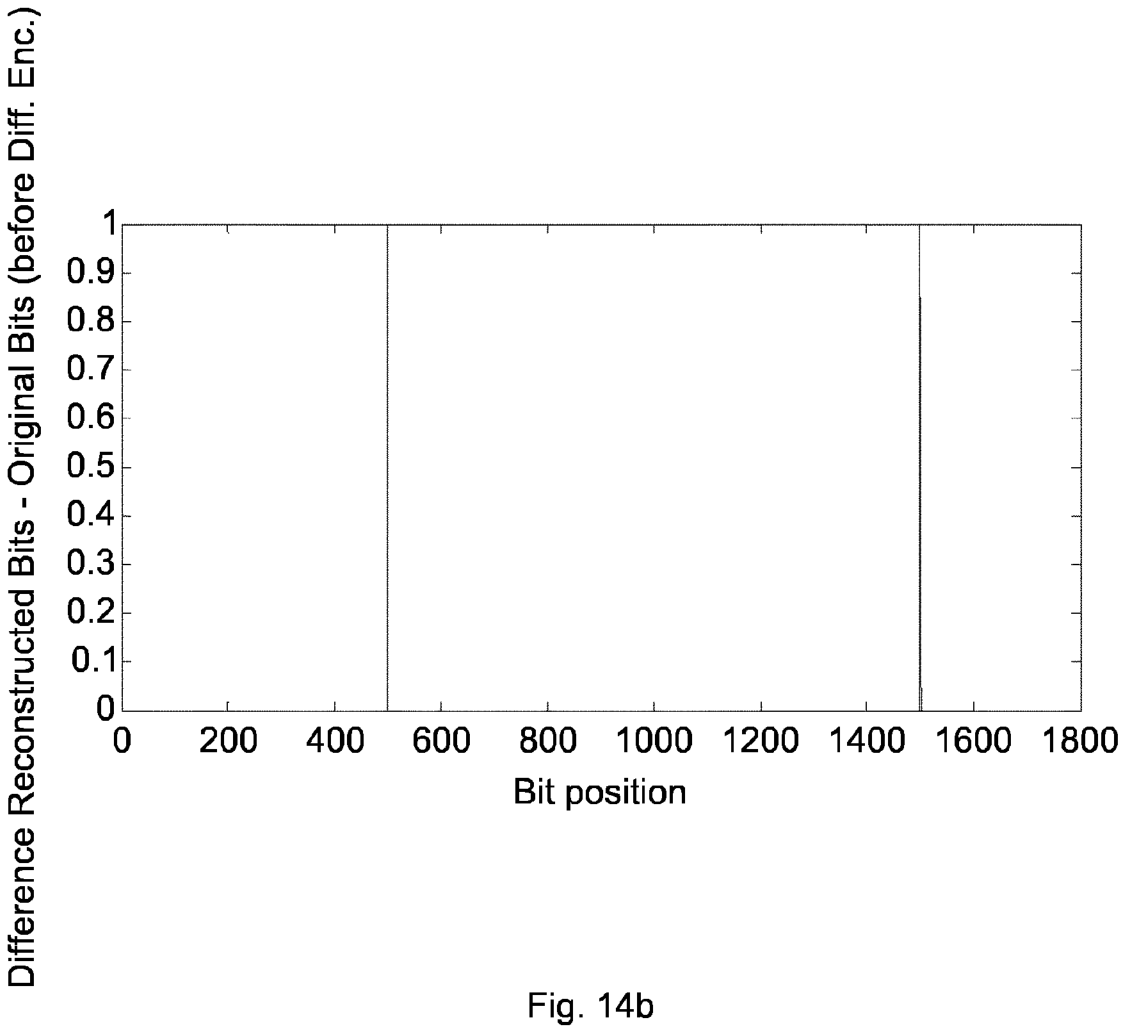


Fig. 14b

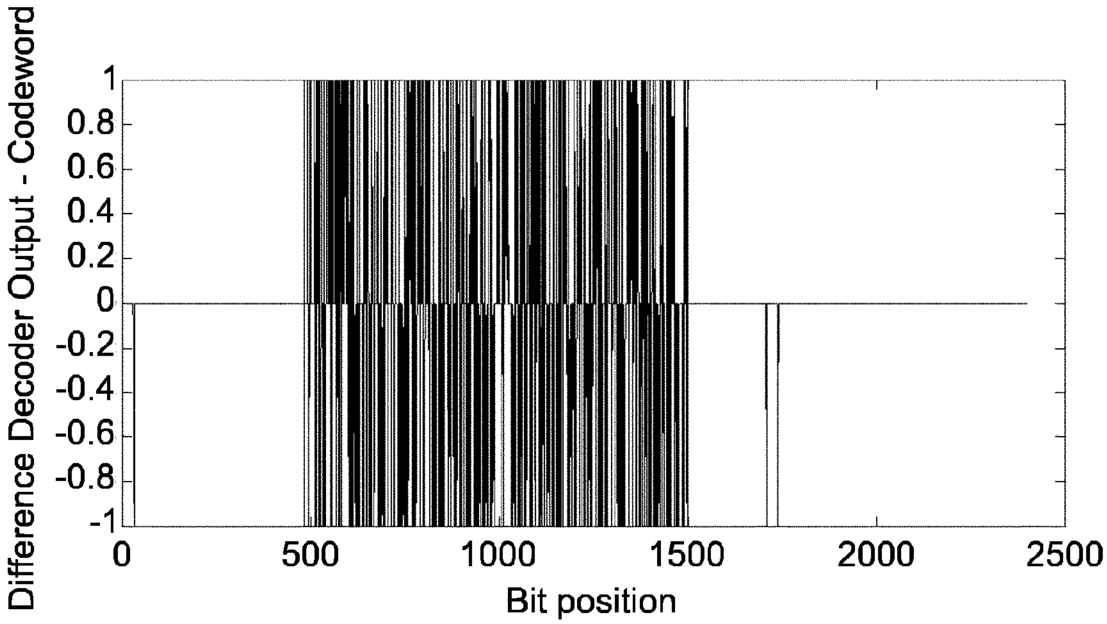


Fig. 15a

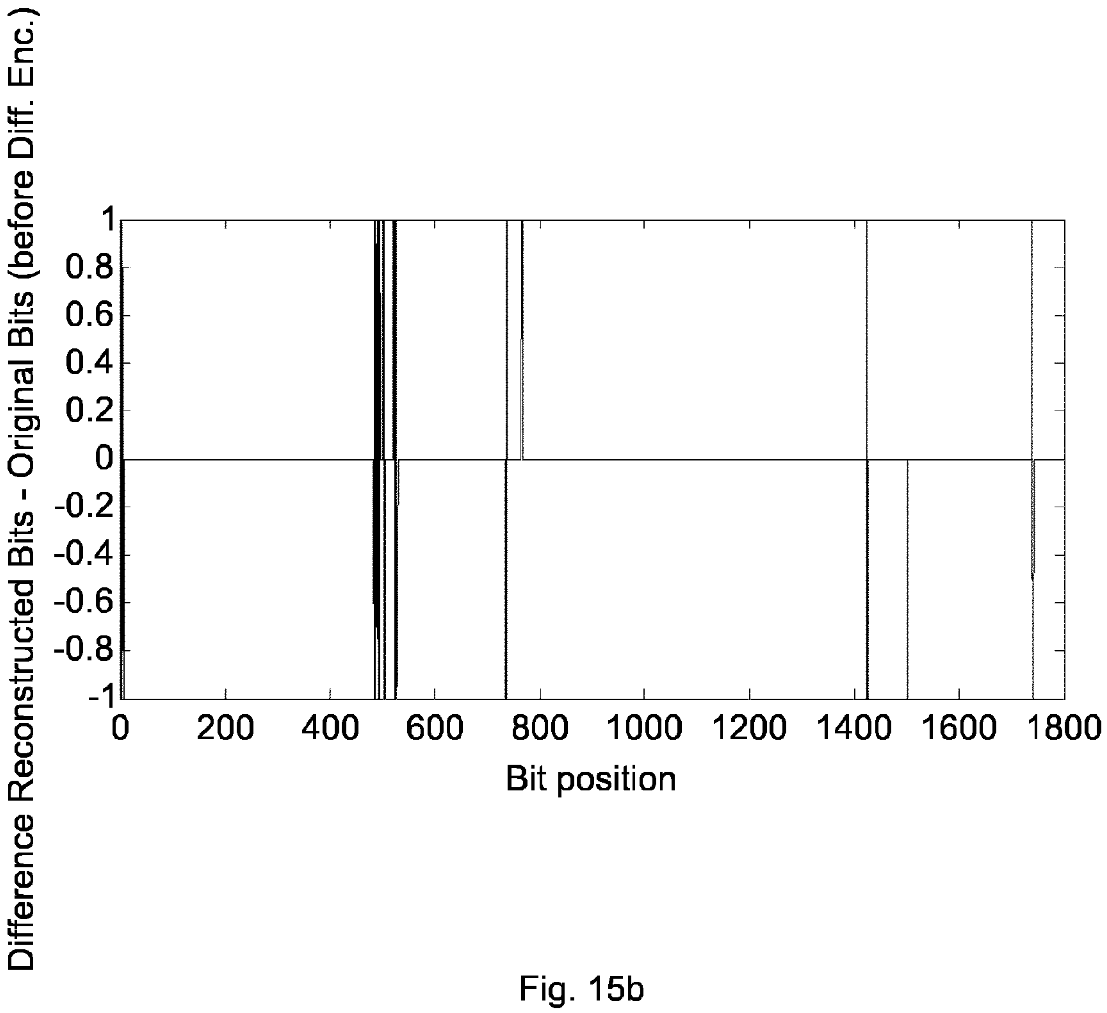


Fig. 15b

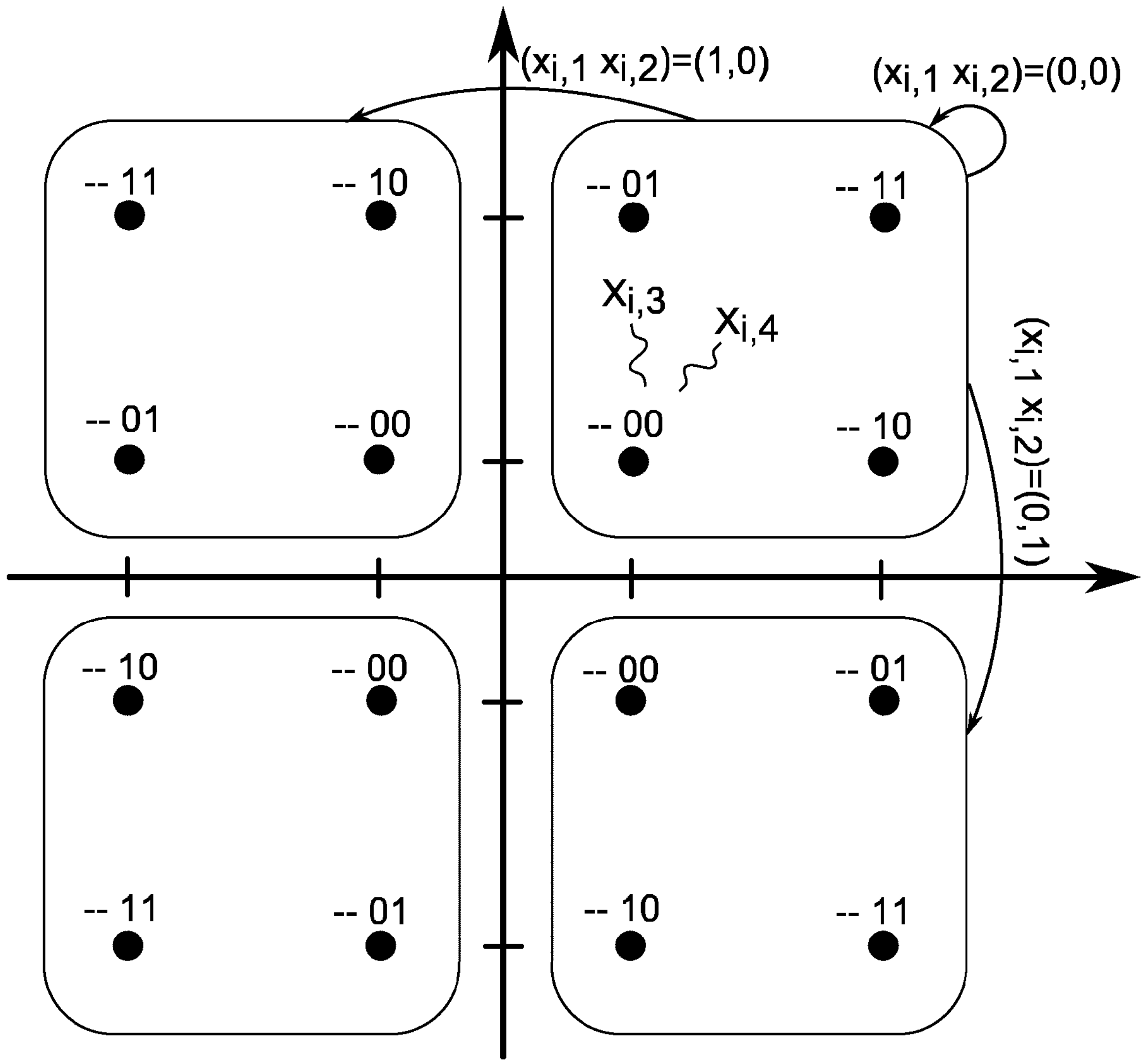

$(x_{i,1}\ x_{i,2})=(1,0)$
$(x_{i,1}\ x_{i,2})=(0,0)$
$(x_{i,1}\ x_{i,2})=(0,1)$
-- 11
-- 10
-- 01
-- 00
-- 01
-- 11
$x_{i,3}$
$x_{i,4}$
-- 00
-- 10
-- 10
-- 00
-- 11
-- 01
-- 00
-- 01
-- 10
-- 11


Fig. 16

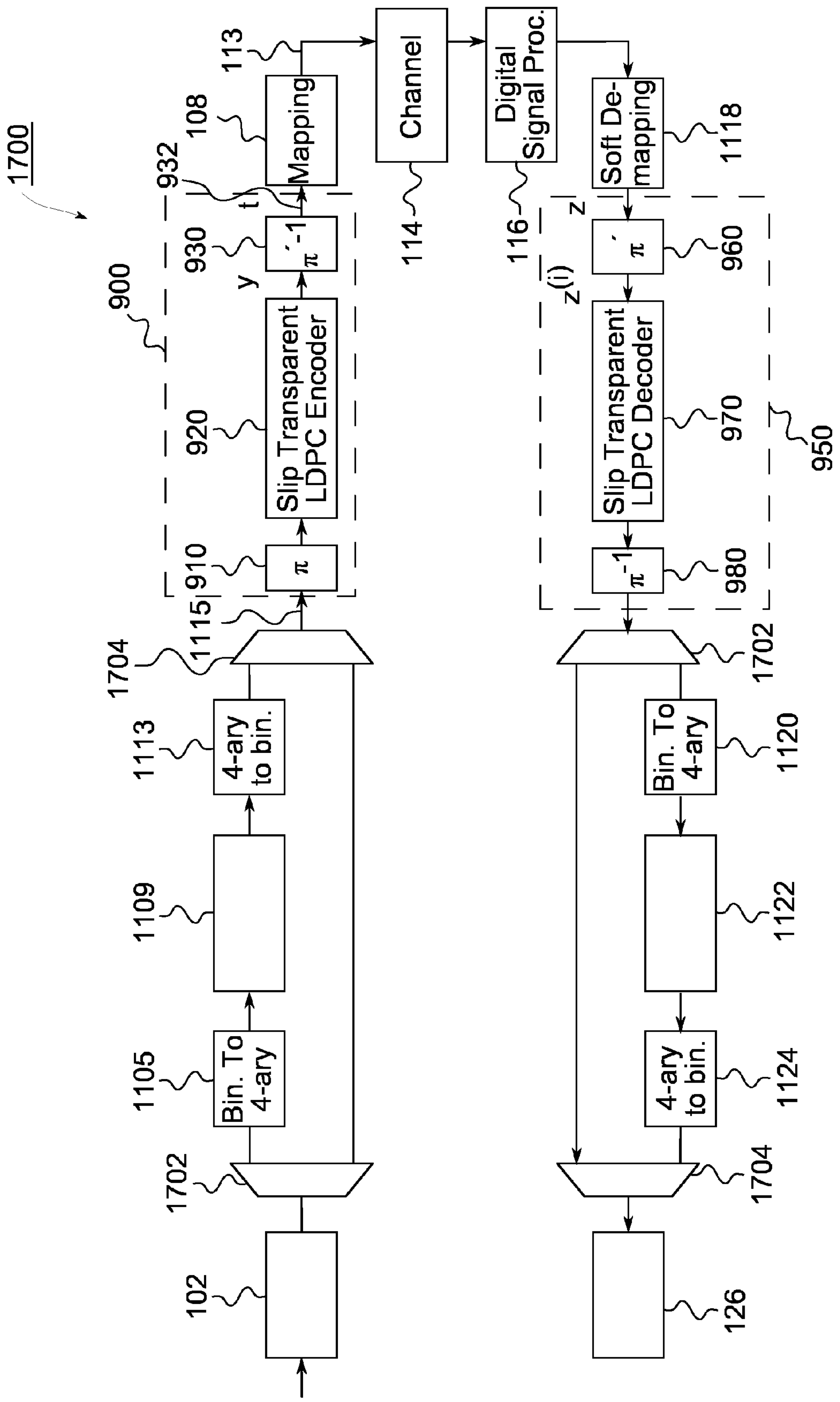
1700
900
Mapping
Channel
Digital Signal Proc.
Soft De-mapping
Slip Transparent LDPC Encoder
Slip Transparent LDPC Decoder
π
π'-1
π'
π-1
y
t
z
z(i)
4-ary to bin.
Bin. To 4-ary
Bin. To 4-ary
4-ary to bin.
102
1702
1105
1109
1113
1704
1115
910
920
930
932
108
113
114
116
1118
960
970
980
950
1702
1120
1122
1124
1704
126

Fig. 17

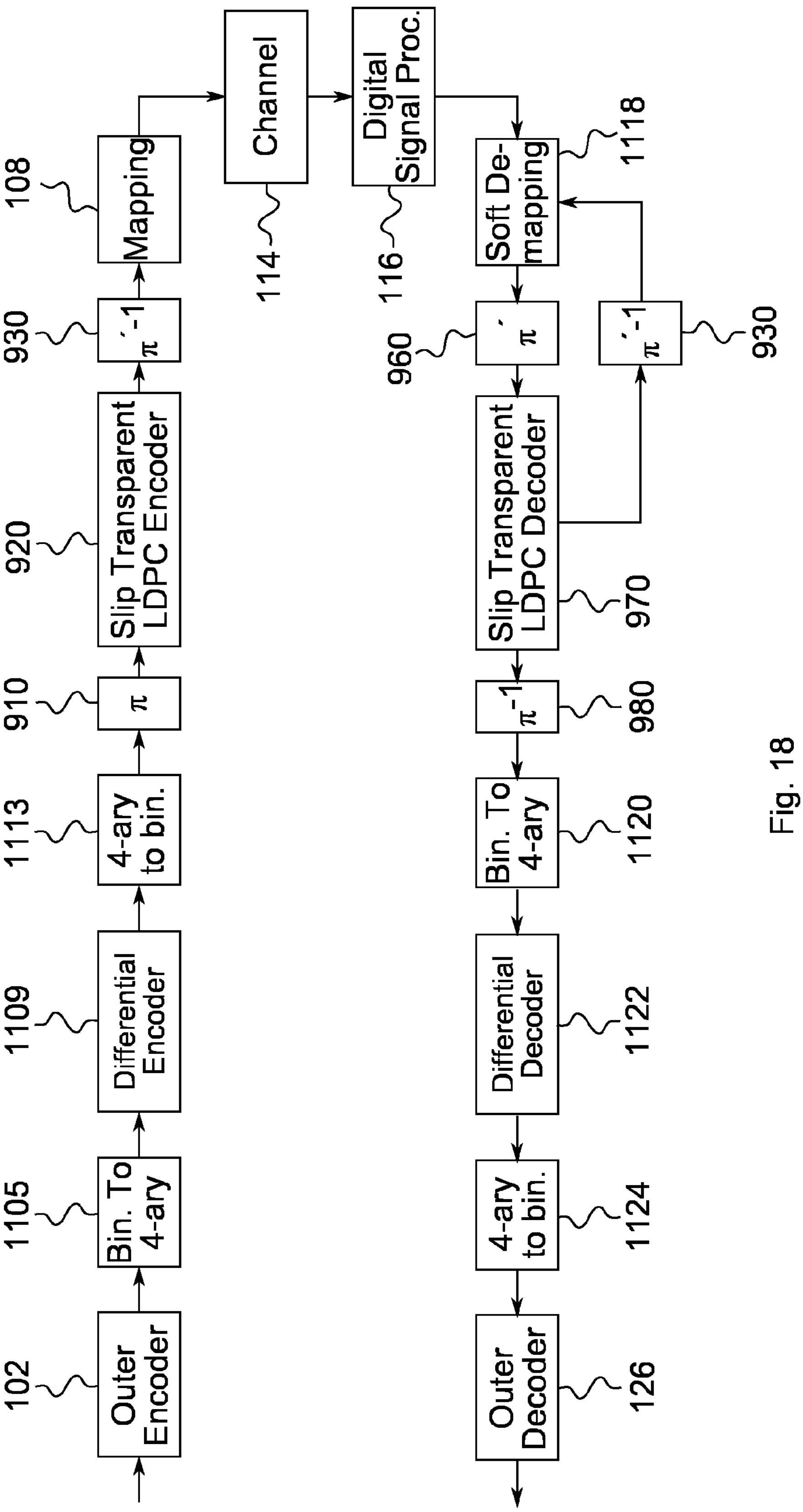

Outer Encoder
102
Bin. To 4-ary
1105
Differential Encoder
1109
4-ary to bin.
1113
π
910
Slip Transparent LDPC Encoder
920
π ′ -1
930
Mapping
108
Channel
114
Digital Signal Proc.
116
Soft De-mapping
1118
π ′
960
π ′ -1
930
Slip Transparent LDPC Decoder
970
π -1
980
Bin. To 4-ary
1120
Differential Decoder
1122
4-ary to bin.
1124
Outer Decoder
126


Fig. 18

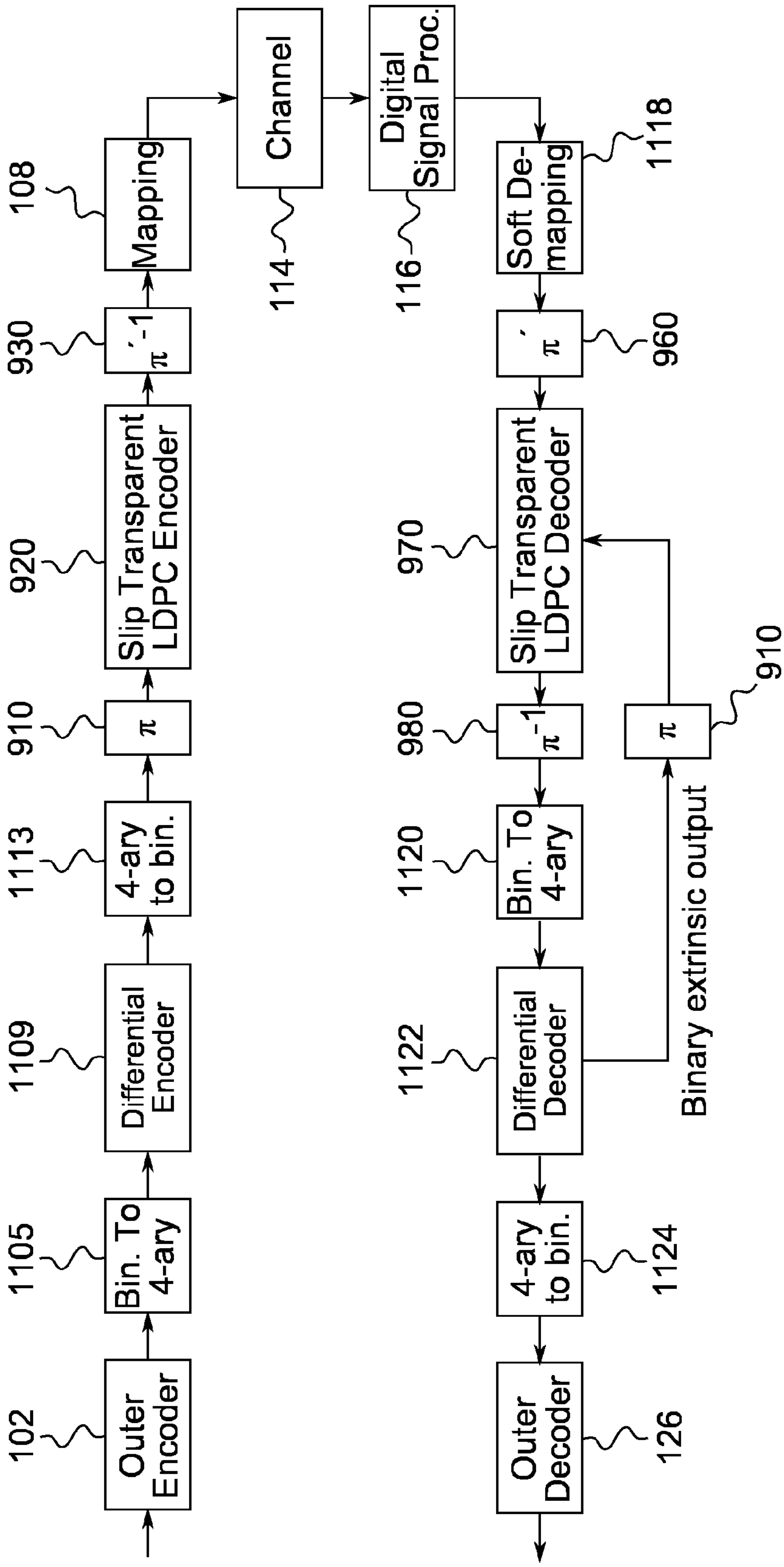
Outer Encoder
102
Bin. To 4-ary
1105
Differential Encoder
1109
4-ary to bin.
1113
π
910
Slip Transparent LDPC Encoder
920
π'-1
930
Mapping
108
Channel
114
Digital Signal Proc.
116
Soft De-mapping
1118
π'
960
Slip Transparent LDPC Decoder
970
π-1
980
Bin. To 4-ary
1120
Differential Decoder
1122
4-ary to bin.
1124
Outer Decoder
126
π
910
Binary extrinsic output

Fig. 19

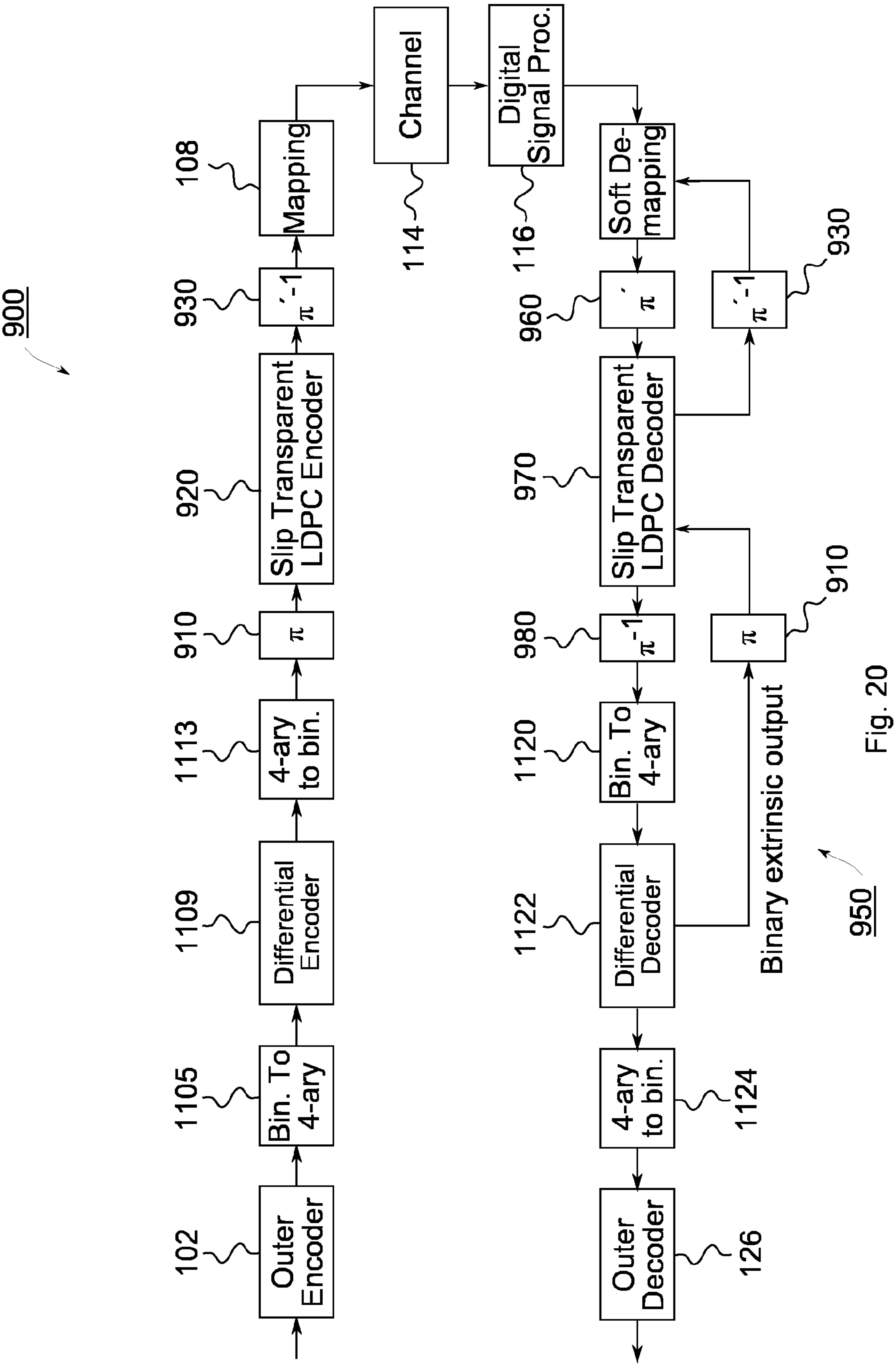
900
102
Outer Encoder
1105
Bin. To 4-ary
1109
Differential Encoder
1113
4-ary to bin.
910
π
920
Slip Transparent LDPC Encoder
930
π´-1
108
Mapping
Channel
114
Digital Signal Proc.
116
Soft De-mapping
960
π´
970
Slip Transparent LDPC Decoder
930
π´-1
980
π-1
910
π
1120
Bin. To 4-ary
1122
Differential Decoder
Binary extrinsic output
1124
4-ary to bin.
126
Outer Decoder
950

Fig. 20

Europäisches Patentamt
European Patent Office
Office européen des brevets

# EUROPEAN SEARCH REPORT

Application Number
EP 14 18 6535

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2011/119056 A1 (GUNNAM KIRAN [US]) 19 May 2011 (2011-05-19) * paragraph [0018] - paragraph [0021]; figures 2,3 * * paragraph [0050] - paragraph [0054] * ----- | 1-17 | INV. H03M13/03 H03M13/11 H03M13/27 H03M13/29 H03M13/00 H04L1/00 |
| A | SRIDHAR KARUPPASAMI ET AL: "LDPC Code Construction and Iterative Receiver Techniques for Channels with Phase Noise", PROC., IEEE VEHICULAR TECHNOLOGY CONFERENCE, VTC SPRING 2008, 11 May 2008 (2008-05-11), pages 2892-2896, XP031256094, ISBN: 978-1-4244-1644-8 * the whole document * ----- | 1-17 | |
| A | SCHMALEN LAURENT: "Low-complexity phase slip tolerant LDPC-based FEC scheme", PROC., THE EUROPEAN CONFERENCE ON OPTICAL COMMUNICATION (ECOC), CANNES , FRANCE, 21 September 2014 (2014-09-21), - 25 September 2014 (2014-09-25), pages 1-3, XP032689360, DOI: 10.1109/ECOC.2014.6963875 [retrieved on 2014-11-20] * the whole document * ----- | 1-17 | TECHNICAL FIELDS SEARCHED (IPC): H03M H04L |

The present search report has been drawn up for all claims

2

| Place of search | Date of completion of the search | Examiner |
|---|---|---|
| Munich | 16 March 2015 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 14 18 6535

This annex lists the patent family members relating to the patent documents cited in the above-mentioned European search report. The members are as contained in the European Patent Office EDP file on
The European Patent Office is in no way liable for these particulars which are merely given for the purpose of information.

16-03-2015

| Patent document cited in search report | Publication date | Patent family member(s) | Publication date |
|---|---|---|---|
| US 2011119056 A1 | 19-05-2011 | US 2011119056 A1 | 19-05-2011 |
| | | US 2011119553 A1 | 19-05-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2538596 A1
- EP 2506516 A1


### Non-patent literature cited in the description


- **D. E. HOCEVAR.** A Reduced Complexity Decoder Architecture via Layered Decoding of LDPC Codes. *Proc. IEEE Workshop on Signal Processing Systems (SIPS),* 2004
- **J. CHEN ; A. DHOLAKIA ; E. ELEFTHERIOU ; M. P. C. FOSSORIER ; X.-Y. HU.** Reduced-Complexity Decoding of LDPC Codes. *IEEE Transactions on Communications,* August 2005, vol. 53 (8), 1288-1299
- **L. R. BAHL ; J. COCKE ; F. JELINEK ; J. RAVIV.** Optimal Decoding of Linear Codes for minimizing symbol error rate. *IEEE Transactions on Information Theory,* March 1974, vol. IT-20 (2), 284-287
- **J. HAGENAUER ; E. OFFER ; L. PAPKE.** Iterative Decoding of Binary Block and Convolutional Codes. *IEEE Trans. Inform. Theory,* March 1996, vol. 42 (2
- **J. KARAKI ; R. LE BIDAN ; E. PINCEMIN.** A Simple and High-Performance Method for Combining Soft-Decision FEC with Differential Encoding in 100 Gbps Dual-Polarization QPSK System. *Proc. OFC 2014,* 2014, vol. M3A.7